# EUROPEAN PATENT APPLICATION

(11) **EP 4 716 039 A1**
(43) Date of publication of application: **25.03.2026**
(21) Application number: 24810938.1
(22) Date of filing: 13.05.2024
(51) Int. Cl.: H01S 5/183, H01L 33/10, H01L 33/14, H01L 33/38, H01L 33/44, H01L 33/62, H01S 5/042, H01S 5/02355

(54) **SURFACE LIGHT EMITTING ELEMENT**

(30) Priority: 19.05.2023 JP 2023082971
(71) Applicant: Sony Semiconductor Solutions Corporation, Atsugi-shi, Kanagawa 243-0014 (JP)
(72) Inventor: YOKOTA, Tomohiro, Kikuchi-gun, Kumamoto 869-1102 (JP); KUDO, Hiroki, Kikuchi-gun, Kumamoto 869-1102 (JP); ITO, Ryo, Kikuchi-gun, Kumamoto 869-1102 (JP); TACHIKAWA, Yoshiteru, Kikuchi-gun, Kumamoto 869-1102 (JP); AOYAGI, Hidekazu, Kikuchi-gun, Kumamoto 869-1102 (JP); SATOU, Takeshi, Kikuchi-gun, Kumamoto 869-1102 (JP); NAKAYAMA, Yuusuke, Kikuchi-gun, Kumamoto 869-1102 (JP); HANZAWA, Yasunari, Kikuchi-gun, Kumamoto 869-1102 (JP); NAKAMURA, Yuki, Kikuchi-gun, Kumamoto 869-1102 (JP); KIKUCHI, Naoto, Kikuchi-gun, Kumamoto 869-1102 (JP)
(74) Representative: D Young & Co LLP
(86) International application number: PCT/JP2024/017574
(87) International publication number: WO 2024/241931

(57) **Abstract**

A surface emitting element having position controllability of a bump when an electrode and a substrate are bonded via the bump is provided.

A surface emitting element according to the present technology is a surface emitting element including: a first structure including a first semiconductor structure; a second structure stacked with the first structure and including a second semiconductor structure; and a light emitting layer arranged between the first structure and the second structure and including a light emitting region, in which the second structure further includes an electrode including a bump joint surface on a side opposite to a side of the light emitting layer of the second semiconductor structure, and a convex portion protruding to the side opposite to the side of the light emitting layer more than the bump joint surface is provided. According to the surface emitting element according to the present technology, a surface emitting element having position controllability of a bump when an electrode and a substrate are bonded via the bump is provided.

## Description

### TECHNICAL FIELD

The technology according to the present disclosure (hereinafter, also referred to as "the present technology") relates to a surface emitting element.

### BACKGROUND ART

In related art, for example, a surface emitting element capable of obtaining a surface emission output such as a surface emitting laser and a light emitting diode is known.

Among surface emitting elements in the related art, there is a surface emitting element including an electrode on a light emitting unit (see, for example, Patent Document 1).

### CITATION LIST

### PATENT DOCUMENT

Patent Document 1: Japanese Patent Application Laid-Open No. 2020-141046

### SUMMARY OF THE INVENTION

### PROBLEMS TO BE SOLVED BY THE INVENTION

For example, in Patent Document 1, the electrode on the light emitting unit does not include an external joint surface (bump joint surface), and furthermore, there is no mention of position controllability of the bump when the electrode and the substrate are bonded via the bump.

Thus, a main object of the present technology is to provide a surface emitting element having position controllability of a bump when an electrode and a substrate are bonded via the bump.

### SOLUTIONS TO PROBLEMS

The present technology provides a surface emitting element including:
a first structure including a first semiconductor structure;
a second structure stacked with the first structure and including a second semiconductor structure; and
a light emitting layer arranged between the first structure and the second structure and including a light emitting region,
in which the second structure further includes an electrode including an external joint surface on a side opposite to a side of the light emitting layer of the second semiconductor structure, and
a convex portion protruding to the side opposite to the side of the light emitting layer more than at least a portion of the external joint surface is provided in the second structure.

The convex portion may protrude to the side opposite to the side of the light emitting layer more than the external joint surface.

The convex portion may protrude to the side opposite to the side of the light emitting layer more than a portion of the external joint surface.

The convex portion may be a portion of the electrode, and may protrude to the side opposite to the side of the light emitting layer more than the other portion of the electrode.

The external joint surface may have a concave surface shape.

A stacked structure in which an insulating film and a wiring are stacked may be provided across the first semiconductor structure and the second semiconductor structure, and the stacked structure may form a step portion on a peripheral portion of the second structure.

The step portion may include the convex portion.

The convex portion may be provided on the step portion.

The stacked structure may include a plurality of the insulating films and at least one of the wirings, and the insulating films and the wirings may be alternately stacked.

The convex portion may have a stacked structure in which a plurality of layers is stacked.

The convex portion does not have to overlap the light emitting region in plan view.

The external joint surface may overlap at least the light emitting region in plan view.

The external joint surface may be a flat surface, a curved surface, or a stepped surface to be bonded to a substrate via a bump.

A protruding amount of the convex portion may be 1/3 or more of a thickness of a portion corresponding to the light emitting region of the electrode.

The convex portion may include a plurality of portions facing each other in an in-plane direction.

The convex portion may include a portion of the electrode.

The convex portion may include at least a portion of an insulating film.

The convex portion may be provided so as to correspond to at least a portion of an outer periphery of the light emitting region in plan view.

The convex portion may surround the light emitting region in plan view.

The convex portion may include a plurality of portions arranged so as to surround the light emitting region in plan view.

The convex portion may be a stepped convex portion.

The convex portion may include a base portion and at least one protrusion protruding from the base portion to the side opposite to the side of the light emitting layer.

The at least one protrusion may be a plurality of protrusions having different protruding amounts.

The plurality of protrusions farther from the light emitting region in plan view may have a larger protruding amount.

In the second semiconductor structure, the electrode may be provided in a first region including a region corresponding to the light emitting region on the side opposite to the side of the light emitting layer, a second region around the first region may include a protruding portion protruding to the side opposite to the side of the light emitting layer more than the first region, and the convex portion may include a portion of the protruding portion.

The second semiconductor structure may include a semiconductor multilayer film reflector including the first region and the second region.

The second semiconductor structure may include a contact layer including the first region and the second region.

The second structure may further include a dielectric layer arranged between the second semiconductor structure and a portion including the external joint surface of the electrode.

A current confinement region that sets the light emitting region may be provided between a surface of the first structure on the side opposite to the side of the light emitting layer and the light emitting layer and/or between a surface of the second structure on the side opposite to the side of the light emitting layer and the light emitting layer.

### BRIEF DESCRIPTION OF DRAWINGS

Fig. 1 is a cross-sectional view of a surface emitting element according to Example 1 of one embodiment of the present technology.
Fig. 2 is a plan view of the surface emitting element according to Example 1 of one embodiment of the present technology.
Fig. 3 is a partial cross-sectional view of a light emitting element constituent portion array of a surface emitting device including the surface emitting element according to Example 1 of one embodiment of the present technology.
Fig. 4 is a plan view of the surface emitting device including the surface emitting element according to Example 1 of one embodiment of the present technology.
Fig. 5 is a cross-sectional view of a light emitting unit of the surface emitting element according to Example 1 of one embodiment of the present technology.
Fig. 6 is a cross-sectional view of a portion including a surface emitting element of a light source device including the surface emitting device including the surface emitting element according to Example 1 of one embodiment of the present technology.
Fig. 7 is a cross-sectional view of a portion including the light emitting element constituent portion array of the light source device including the surface emitting device including the surface emitting element according to Example 1 of one embodiment of the present technology.
Fig. 8 is a flowchart for describing an example of a method for manufacturing the surface emitting device including the surface emitting element according to Example 1 of one embodiment of the present technology.
Fig. 9 is a cross-sectional view for each process of an example of the method for manufacturing the surface emitting device including the surface emitting element according to Example 1 of one embodiment of the present technology.
Fig. 10 is a cross-sectional view for each process of an example of the method for manufacturing the surface emitting device including the surface emitting element according to Example 1 of one embodiment of the present technology.
Fig. 11 is a cross-sectional view for each process of an example of the method for manufacturing the surface emitting device including the surface emitting element according to Example 1 of one embodiment of the present technology.
Fig. 12 is a cross-sectional view for each process of an example of the method for manufacturing the surface emitting device including the surface emitting element according to Example 1 of one embodiment of the present technology.
Fig. 13 is a cross-sectional view for each process of an example of the method for manufacturing the surface emitting device including the surface emitting element according to Example 1 of one embodiment of the present technology.
Fig. 14 is a cross-sectional view for each process of an example of the method for manufacturing the surface emitting device including the surface emitting element according to Example 1 of one embodiment of the present technology.
Fig. 15 is a cross-sectional view for each process of an example of the method for manufacturing the surface emitting device including the surface emitting element according to Example 1 of one embodiment of the present technology.
Fig. 16 is a cross-sectional view of a surface emitting element according to Example 2 of one embodiment of the present technology.
Fig. 17 is a plan view of the surface emitting element according to Example 2 of one embodiment of the present technology.
Fig. 18 is a cross-sectional view of a light emitting unit of the surface emitting element according to Example 2 of one embodiment of the present technology.
Fig. 19 is a cross-sectional view of a surface emitting element according to Example 3 of one embodiment of the present technology.
Fig. 20 is a plan view of the surface emitting element according to Example 3 of one embodiment of the present technology.
Fig. 21 is a cross-sectional view of a light emitting unit of the surface emitting element according to Example 3 of one embodiment of the present technology.
Fig. 22 is a cross-sectional view of a surface emitting element according to Example 4 of one embodiment of the present technology.
Fig. 23 is a plan view of the surface emitting element according to Example 4 of one embodiment of the present technology.
Fig. 24 is a plan view of a surface emitting element according to Example 5 of one embodiment of the present technology.
Fig. 25 is a plan view of a surface emitting element according to Example 6 of one embodiment of the present technology.
Fig. 26 is a plan view of a surface emitting element according to Example 7 of one embodiment of the present technology.
Fig. 27 is a cross-sectional view of a surface emitting element according to Example 8 of one embodiment of the present technology.
Fig. 28 is a cross-sectional view of a surface emitting element according to Example 9 of one embodiment of the present technology.
Fig. 29 is a cross-sectional view of a surface emitting element according to Example 10 of one embodiment of the present technology.
Fig. 30 is a cross-sectional view of a surface emitting element according to Example 11 of one embodiment of the present technology.
Fig. 31 is a cross-sectional view of a surface emitting element according to Example 12 of one embodiment of the present technology.
Fig. 32 is a cross-sectional view of a surface emitting element according to Example 13 of one embodiment of the present technology.
Fig. 33 is a cross-sectional view of a light emitting element constituent portion array of a surface emitting device including the surface emitting element according to Example 13 of one embodiment of the present technology.
Fig. 34 is a plan view of the surface emitting device including the surface emitting element according to Example 13 of one embodiment of the present technology.
Fig. 35 is a flowchart for describing an example of a method for manufacturing the surface emitting device including the surface emitting element according to Example 13 of one embodiment of the present technology.
Fig. 36 is a cross-sectional view for each process of an example of the method for manufacturing the surface emitting device including the surface emitting element according to Example 13 of one embodiment of the present technology.
Fig. 37 is a cross-sectional view for each process of an example of the method for manufacturing the surface emitting device including the surface emitting element according to Example 13 of one embodiment of the present technology.
Fig. 38 is a cross-sectional view for each process of an example of the method for manufacturing the surface emitting device including the surface emitting element according to Example 13 of one embodiment of the present technology.
Fig. 39 is a cross-sectional view for each process of an example of the method for manufacturing the surface emitting device including the surface emitting element according to Example 13 of one embodiment of the present technology.
Fig. 40 is a cross-sectional view for each process of an example of the method for manufacturing the surface emitting device including the surface emitting element according to Example 13 of one embodiment of the present technology.
Fig. 41 is a cross-sectional view for each process of an example of the method for manufacturing the surface emitting device including the surface emitting element according to Example 13 of one embodiment of the present technology.
Fig. 42 is a cross-sectional view for each process of an example of the method for manufacturing the surface emitting device including the surface emitting element according to Example 13 of one embodiment of the present technology.
Fig. 43 is a cross-sectional view of a surface emitting element according to Example 14 of one embodiment of the present technology.
Fig. 44 is a cross-sectional view of a surface emitting element according to Example 15 of one embodiment of the present technology.
Fig. 45 is a cross-sectional view of a surface emitting element according to Modification 1 of Example 1 of one embodiment of the present technology.
Fig. 46 is a cross-sectional view of a surface emitting element according to Modification 2 of Example 1 of one embodiment of the present technology.
Fig. 47 is a cross-sectional view of a surface emitting element according to Modification 3 of Example 1 of one embodiment of the present technology.
Fig. 48 is a cross-sectional view of a surface emitting element according to Modification 4 of Example 1 of one embodiment of the present technology.
Fig. 49 is a cross-sectional view of a surface emitting element according to Modification 5 of Example 1 of one embodiment of the present technology.
Fig. 50 is a cross-sectional view of a surface emitting element according to Modification 1 of Example 11 of one embodiment of the present technology.
Fig. 51 is a cross-sectional view of a surface emitting element according to Modification 2 of Example 11 of one embodiment of the present technology.
Fig. 52 is a cross-sectional view of a surface emitting element according to Modification 3 of Example 11 of one embodiment of the present technology.
Fig. 53 is a cross-sectional view of a surface emitting element according to Modification 4 of Example 11 of one embodiment of the present technology.
Fig. 54 is a cross-sectional view of a surface emitting element according to Modification 6 of Example 1 of one embodiment of the present technology.
Fig. 55 is a cross-sectional view of a surface emitting element according to Modification 7 of Example 1 of one embodiment of the present technology.
Figs. 56A and 56B are views for describing an example of bump bonding of the surface emitting element according to Example 1 of one embodiment of the present technology.
Figs. 57A and 57B are views for describing an example of bump bonding of the surface emitting element according to Example 1 of one embodiment of the present technology.
Figs. 58A and 58B are views for describing an example of bump bonding of the surface emitting element according to Example 2 of one embodiment of the present technology.
Figs. 59A and 59B are views for describing an example of bump bonding of the surface emitting element according to Example 3 of one embodiment of the present technology.
Fig. 60 is a cross-sectional view of a surface emitting element according to Modification 8 of Example 1 of one embodiment of the present technology.
Fig. 61 is a partial cross-sectional view of a light emitting element constituent portion array of a surface emitting device including the surface emitting element according to Modification 8 of Example 1 of one embodiment of the present technology.
Fig. 62 is a partial plan view of the light emitting element constituent portion array of the surface emitting device including the surface emitting element according to Modification 8 of Example 1 of one embodiment of the present technology.
Fig. 63 is a plan view of the surface emitting device including the surface emitting element according to Modification 8 of Example 1 of one embodiment of the present technology.
Fig. 64 is a view (No. 1) illustrating a state immediately before the surface emitting element according to Modification 8 of Example 1 of one embodiment of the present technology is bump-bonded to another substrate.
Fig. 65 is a view (No. 2) illustrating a state immediately before the surface emitting element according to Modification 8 of Example 1 of one embodiment of the present technology is bump-bonded to another substrate.
Fig. 66 is a view (No. 1) illustrating a state in which the surface emitting element according to Modification 8 of Example 1 of one embodiment of the present technology is bump-bonded to another substrate.
Fig. 67 is a view (No. 2) illustrating a state in which the surface emitting element according to Modification 8 of Example 1 of one embodiment of the present technology is bump-bonded to another substrate.
Fig. 68A is a view illustrating a state immediately before a surface emitting element of a comparative example is bump-bonded to another substrate. Fig. 68B is a view illustrating a state in which the surface emitting element of the comparative example is bump-bonded to another substrate.
Fig. 69 is a flowchart for describing an example of a method for manufacturing the surface emitting element according to Modification 8 of Example 1 of one embodiment of the present technology.
Figs. 70A and 70B are cross-sectional views for each process of an example of the method of manufacturing the surface emitting device including the surface emitting element according to Modification 8 of Example 1 of one embodiment of the present technology.
Figs. 71A and 71B are cross-sectional views for each process of an example of the method for manufacturing the surface emitting device including the surface emitting element according to Modification 8 of Example 1 of one embodiment of the present technology.
Figs. 72A and 72B are cross-sectional views for each process of an example of the method for manufacturing the surface emitting device including the surface emitting element according to Modification 8 of Example 1 of one embodiment of the present technology.
Figs. 73A and 73B are cross-sectional views for each process of an example of the method for manufacturing the surface emitting device including the surface emitting element according to Modification 8 of Example 1 of one embodiment of the present technology.
Figs. 74A and 74B are cross-sectional views for each process of an example of the method for manufacturing the surface emitting device including the surface emitting element according to Modification 8 of Example 1 of one embodiment of the present technology.
Fig. 75 is a cross-sectional view for each process of an example of the method for manufacturing the surface emitting device including the surface emitting element according to Modification 8 of Example 1 of one embodiment of the present technology.
Fig. 76 is a partial cross-sectional view of a light emitting element constituent portion array of a surface emitting device including a surface emitting element according to Modification 9 of Example 1 of one embodiment of the present technology.
Fig. 77 is a partial cross-sectional view of a light emitting element constituent portion array of a surface emitting device including a surface emitting element according to Modification 10 of Example 1 of one embodiment of the present technology.
Fig. 78 is a partial cross-sectional view of a light emitting element constituent portion array of a surface emitting device including a surface emitting element according to Modification 11 of Example 1 of one embodiment of the present technology.
Fig. 79 is a partial cross-sectional view of a light emitting element constituent portion array of a surface emitting device including a surface emitting element according to Modification 12 of Example 1 of one embodiment of the present technology.
Fig. 80 is a partial cross-sectional view of a light emitting element constituent portion array of a surface emitting device including a surface emitting element according to Modification 13 of Example 1 of one embodiment of the present technology.
Fig. 81 is a partial cross-sectional view of a light emitting element constituent portion array of a surface emitting device including a surface emitting element according to Modification 14 of Example 1 of one embodiment of the present technology.
Fig. 82 is a partial cross-sectional view of a light emitting element constituent portion array of a surface emitting device including a surface emitting element according to Modification 15 of Example 1 of one embodiment of the present technology.
Fig. 83 is a partial cross-sectional view of a light emitting element constituent portion array of a surface emitting device including a surface emitting element according to Modification 16 of Example 1 of one embodiment of the present technology.

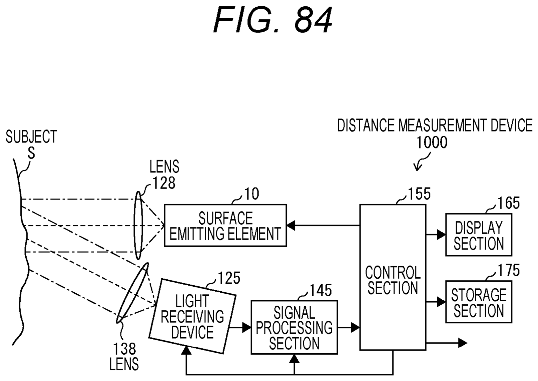

Fig. 84 is a view illustrating an example in which the surface emitting element according to Example 1 of one embodiment of the present technology is applied to a distance measurement device.

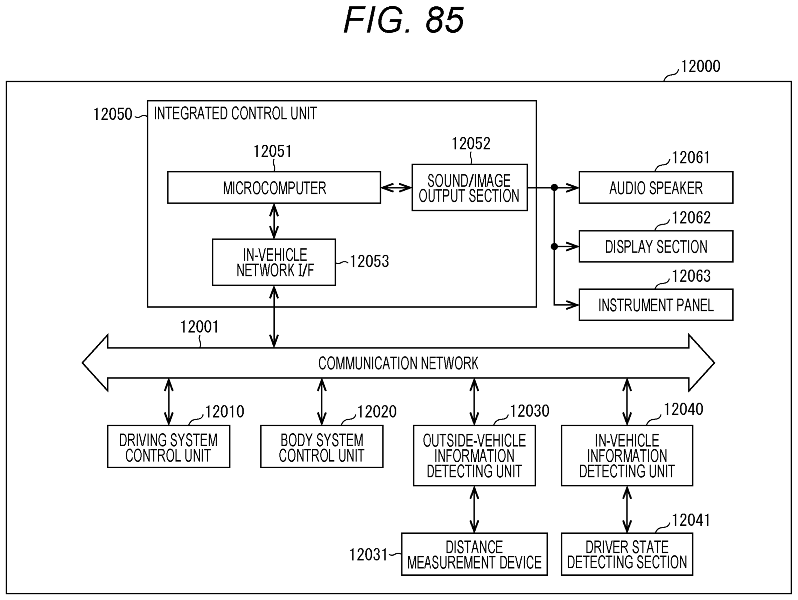

Fig. 85 is a block diagram illustrating an example of a schematic configuration of a vehicle control system.

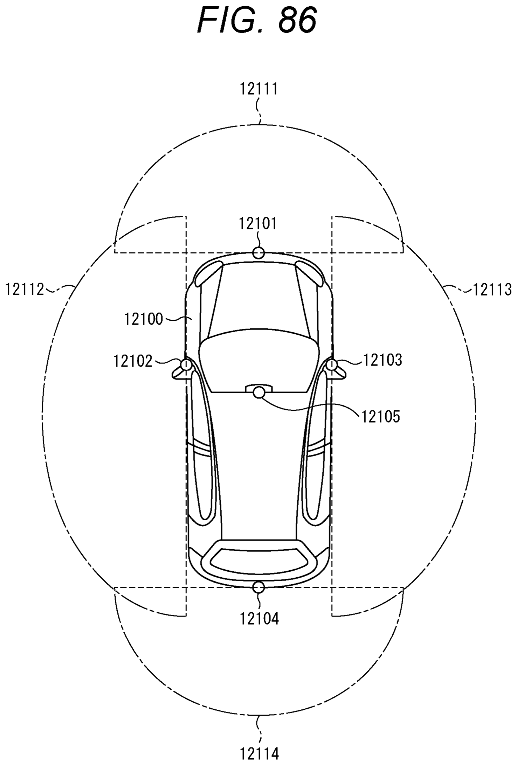

Fig. 86 is an explanatory diagram illustrating an example of installation positions of the distance measurement device.

### MODE FOR CARRYING OUT THE INVENTION

Hereinafter, preferred embodiments of the present technology will be described in detail with reference to the accompanying drawings. Note that, in the present specification and drawings, components having substantially the same functional configuration are denoted by the same reference numerals, and redundant description is omitted. The embodiments to be described below provide representative embodiments of the present technology, and the scope of the present technology is not to be narrowly interpreted according to those embodiments. In the present specification, even in a case where it is described that the surface emitting element according to the present technology exhibits a plurality of effects, it is only necessary that the surface emitting element according to the present technology exhibits at least one effect. The effects described in the present specification are merely examples and are not limited, and other effects may be exerted.

Furthermore, description will be provided in the following order.
0. Introduction
1. Surface Emitting Element According to Example 1 of One Embodiment of Present Technology
2. Surface Emitting Element According to Example 2 of One Embodiment of Present Technology
3. Surface Emitting Element According to Example 3 of One Embodiment of Present Technology
4. Surface Emitting Element According to Example 4 of One Embodiment of Present Technology
5. Surface Emitting Element According to Example 5 of One Embodiment of Present Technology
6. Surface Emitting Element According to Example 6 of One Embodiment of Present Technology
7. Surface Emitting Element According to Example 7 of One Embodiment of Present Technology
8. Surface Emitting Element According to Example 8 of One Embodiment of Present Technology
9. Surface Emitting Element According to Example 9 of One Embodiment of Present Technology
10. Surface Emitting Element According to Example 10 of One Embodiment of Present Technology
11. Surface Emitting Element According to Example 11 of One Embodiment of Present Technology
12. Surface Emitting Element According to Example 12 of One Embodiment of Present Technology
13. Surface Emitting Element According to Example 13 of One Embodiment of Present Technology
14. Surface Emitting Element According to Example 14 of One Embodiment of Present Technology
15. Surface Emitting Element According to Example 15 of One Embodiment of Present Technology
16. Modifications of Present Technology
17. Application Example to Electronic Equipment
18. Example in which Surface Emitting Element is Applied to Distance Measurement Device
19. Example in which Distance Measurement Device is Mounted on Moving Body

### <1. Introduction>

For example, in a backside emission type surface emitting element (such as, for example, a surface emitting laser and a light emitting diode), it is necessary to bond an electrode provided on a light emitting unit and a substrate (such as, for example, a drive substrate and a wiring substrate) via a bump in order to perform energization. At the time of bump bonding (when the electrode and the substrate are bonded via the bump, the same applies hereinafter), alignment accuracy (bonding accuracy) between the electrode and the substrate is important.

If positional deviation between the electrode and the substrate occurs at the time of bump bonding, there is a concern of element destruction due to bias of a current path or occurrence of local stress biased to the light emitting unit.

As a result of intensive studies, the inventors have found that positional deviation between the electrode and the substrate at the time of bump bonding can be suppressed by imparting position controllability of the bump to a surface emitting element at the time of bump bonding.

Then, in order to embody this new finding, the inventors have developed the surface emitting element according to the present technology as a surface emitting element having position controllability of a bump at the time of bump bonding.

Specifically, the inventors provided the light emitting unit with a convex portion having a special structure in order to impart position controllability of the bump to the surface emitting element.

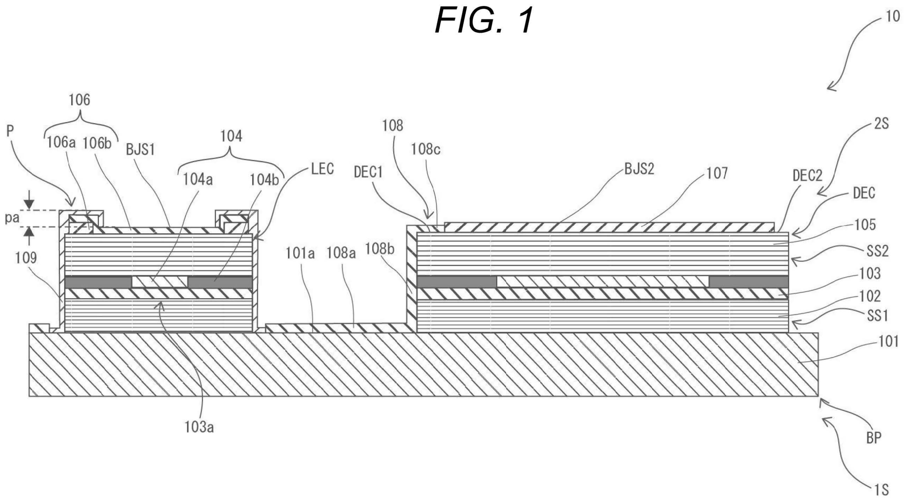

Hereinafter, some examples of one embodiment of the surface emitting element according to the present technology will be described in detail using the drawings. Hereinafter, in the cross-sectional view of Fig. 1, and the like, an upper side will be described as "upper" and a lower side will be described as "lower" as appropriate.

### <1. Surface Emitting Element According to Example 1 of One Embodiment of Present Technology>

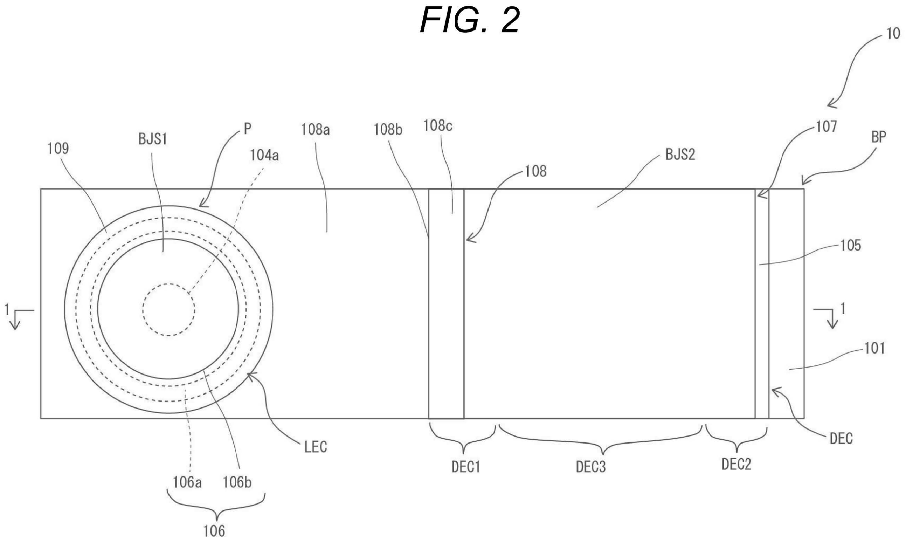

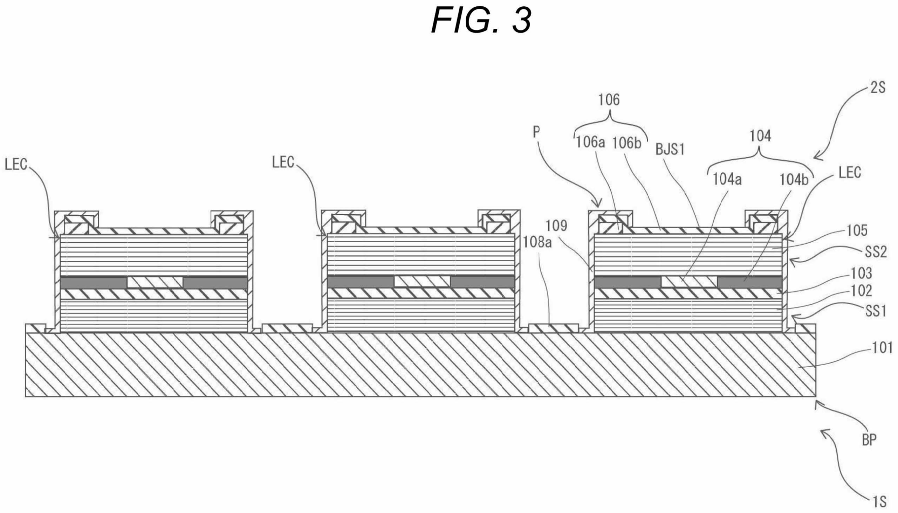

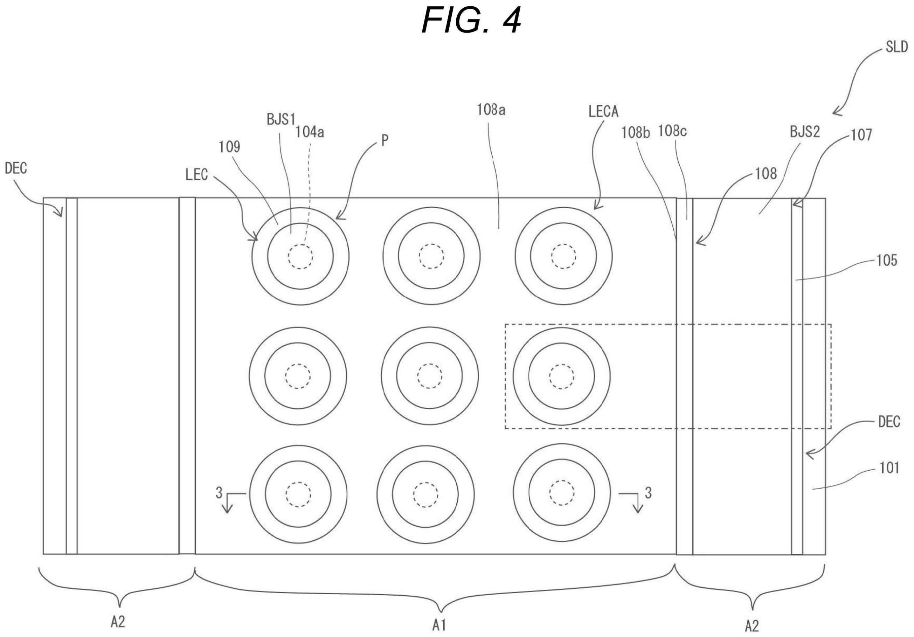

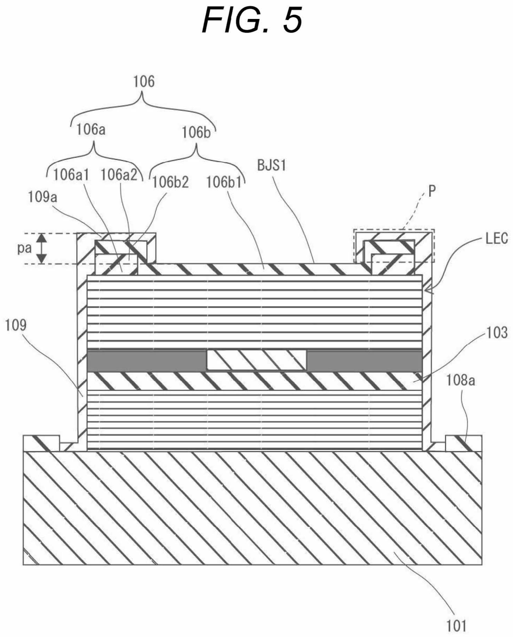

Fig. 1 is a cross-sectional view of a surface emitting element 10 according to Example 1 of one embodiment of the present technology. Fig. 2 is a plan view of the surface emitting element 10 according to Example 1 of one embodiment of the present technology. Fig. 3 is a cross-sectional view of a light emitting element constituent portion array of a surface emitting device SLD including the surface emitting element 10 according to Example 1 of one embodiment of the present technology. Fig. 4 is a plan view of the surface emitting device SLD including the surface emitting element 10 according to Example 1 of one embodiment of the present technology. Fig. 5 is a cross-sectional view of a light emitting unit of the surface emitting element 10 according to Example 1 of one embodiment of the present technology. Fig. 1 is a cross-sectional view taken along a line 1-1 in Fig. 2. Fig. 2 is a view illustrating an extracted portion surrounded by a two-dot chain line in Fig. 4. Fig. 3 is a cross-sectional view taken along a line 3-3 in Fig. 4. Fig. 5 is an enlarged view illustrating the light emitting unit in Fig. 1.

### <<Configurations of Surface Emitting Element and Light Source Device Including Surface Emitting Element>>

### (Overall Configuration of Surface Emitting Element)

As an example, the surface emitting element 10 according to the present technology constitutes a portion (for example, a portion surrounded by the two-dot chain line in Fig. 4) of the surface emitting device SLD illustrated in Fig. 4. The surface emitting device SLD has a chip shape and is also referred to as a "surface emitting chip".

As an example, as illustrated in Fig. 4, the surface emitting device SLD includes a first region A1 including a light emitting element constituent portion array LECA (see Fig. 3) in which a plurality of (for example, nine) light emitting element constituent portions LECs is arranged in an array (for example, a matrix), and a second region A2 including a dummy element constituent portion DEC around the first region A1. Here, in plan view, the first region A1 is sandwiched between the two second regions A2. In each of the second regions A2, the dummy element constituent portion DEC extends in a direction orthogonal to the arrangement direction of the first and second regions A1, A2 so as to correspond to all the light emitting element constituent portions LEC. Note that the second region A2 may be provided only on one side of the first region A1, or may be provided so as to surround the first region A2.

As illustrated in Fig. 1, the light emitting element constituent portion LEC and the dummy element constituent portion DEC are provided on an upper surface (here, an upper surface 101a of a substrate 101) of a base portion BP including the substrate 101 so as to be separated from each other in an in-plane direction (lateral direction). Here, the base portion BP is constituted with the substrate 101.

As an example, as illustrated in Figs. 1 and 2, the surface emitting element 10 includes at least one light emitting unit (see Fig. 5) including the base portion BP and the light emitting element constituent portion LEC. The light emitting unit is, for example, a backside emission type surface emitting laser (vertical cavity surface emitting laser (VCSEL)). The light emitting unit emits light to a side (lower side) opposite to a side of the light emitting element constituent portion LEC of the base portion BP. The surface emitting element 10 is driven by a driver (drive circuit) as an example.

In the surface emitting element 10, as an example, the light emitting unit includes a first structure 1S including a first semiconductor structure SS1, a second structure 2S stacked with the first structure 1S and including a second semiconductor structure SS2, and a light emitting layer 103 including a light emitting region 103a arranged between the first structure 1S and the second structure 2S. The first structure 1S further includes a substrate 101 (here, the base portion BP) arranged on a side (lower side) opposite to the side of the light emitting layer 103 of the first semiconductor structure SS1. The second structure 2S further includes an oxidation confinement layer 104 arranged between the second semiconductor structure SS2 and the light emitting layer 103.

The light emitting element constituent portion LEC includes at least a portion (for example, all) of the first semiconductor structure SS1, the light emitting layer 103, the oxidation confinement layer 104, and the second semiconductor structure SS2 in the light emitting unit. A convex portion P is provided in the second structure 2S (specifically, on the light emitting element constituent portion LEC). The dummy element constituent portion DEC has substantially the same layer configuration as the light emitting element constituent portion LEC.

As an example, the first semiconductor structure SS1 includes a first semiconductor multilayer film reflector 102. As an example, the second semiconductor structure SS2 includes a second semiconductor multilayer film reflector 105. The second semiconductor multilayer film reflector 105 is different in conductivity type from the first semiconductor multilayer film reflector 102.

In other words, in the surface emitting element 10, as an example, the first semiconductor multilayer film reflector 102, the light emitting layer 103, the oxidation confinement layer 104, and the second semiconductor multilayer film reflector 105 are stacked in this order on the substrate 101. Note that the stacking order of the light emitting layer 103 and the oxidation confinement layer 104 may be reversed.

The light emitting unit of the surface emitting element 10 has a double heterostructure in which the light emitting layer 103 is sandwiched between the first semiconductor multilayer film reflector 102 and the second semiconductor multilayer film reflector 105 having different conductivity types in a stacking direction (vertical direction), and can cause radiative recombination of holes and electrons in the light emitting layer 103.

The light emitting unit of the surface emitting element 10 includes the light emitting layer 103 and first and second semiconductor multilayer film reflectors 102, 105 sandwiching the light emitting layer 103 in the stacking direction to constitute a resonator.

Here, both the light emitting element constituent portion LEC and the dummy element constituent portion DEC have a mesa shape. Thus, hereinafter, the light emitting element constituent portion LEC is also referred to as a "light emitting mesa", and the dummy element constituent portion DEC is also referred to as a "dummy mesa". The dummy mesa is also referred to as a "pedestal portion".

As an example, the light emitting mesa and the dummy mesa have a height of several µm to several tens of µm (for example, about 3 to 10 µm). While a planar view shape of the light emitting mesa is circular here (see Fig. 2), the planar view shape of the light emitting mesa may be, for example, an elliptical shape or a polygonal shape such as a square, a rectangle, a hexagon, or an octagon.

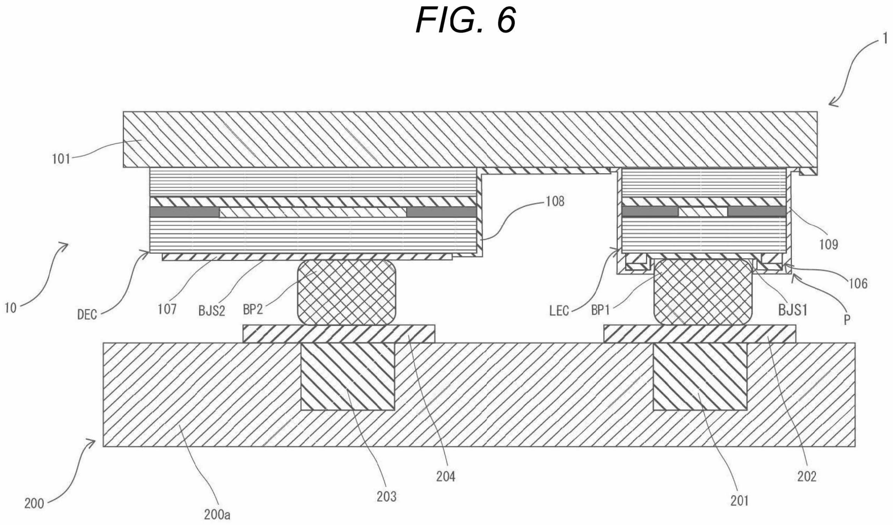

The second structure 2S further includes an anode electrode 106 including a first bump joint surface BSJ1 as an external joint surface on the light emitting element constituent portion LEC (on the top of the light emitting mesa) (on the side opposite to the side of the light emitting layer 103 of the second semiconductor structure SS2). The first bump joint surface BJS1 is, for example, a flat surface. The first bump joint surface BJS1 may have minute irregularities. The first bump joint surface BJS1 is bonded to another substrate 200 (such as, for example, a drive substrate and a wiring substrate) via a first bump BP1 (see Fig. 6). The anode electrode 106 includes, for example, Au/Pt/Ti, or the like.

A cathode electrode 107 including the second bump joint surface BJS2 as an external joint surface is provided on the dummy element constituent portion DEC (on the top of the dummy mesa). The cathode electrode 107 is solid as an example. The second bump joint surface BJS2 is, for example, a flat surface. The second bump joint surface BJS2 is bonded to the other substrate 200 (such as, for example, a drive substrate and a wiring substrate) via a second bump BP2 (see Fig. 6). The cathode electrode 107 includes, for example, Au/Ni/AuGe, or the like.

It is preferable that the first and second bump joint surfaces BJS1, BJS2 have the same height. Each bump joint surface can be rephrased as a "bump connection surface", an "external connection surface", or the like, in addition to the external joint surface.

At least a side surface of the light emitting mesa and a portion of the anode electrode 106 are covered with an insulating film 109 as a protective film. The insulating film 109 includes, for example, a dielectric such as SiO₂, SiN, or SiON.

The upper surface of the base portion BP (here, the upper surface 101a of the substrate 101) and a proximity portion DEC1 of the dummy element constituent portion DEC relatively close to the light emitting element constituent portion LEC are covered with a wiring 108. The wiring 108 is a wiring that makes the base portion BP and the cathode electrode 107 on each dummy element constituent portion DEC conductive with each other. As an example, the wiring 108 is a common wiring common to at least two (for example, nine) light emitting element constituent portions LEC.

The second bump joint surface BJS2 is continuously provided from the proximity portion DEC1 to a remote portion DEC2 relatively far from the light emitting element constituent portion LEC of the dummy element constituent portion DEC. The dummy element constituent portion DEC includes an intermediate portion DCE3 between the proximity portion DEC1 and the remote portion DEC2 (see Fig. 2).

As is apparent from the above description, the surface emitting device SLD has an anode-independent and cathode-common electrode layout, and can independently drive each of the light emitting element constituent portions LEC.

### (Substrate)

The substrate 101 includes GaAs (for example, n-GaAs) as an example.

### (First Semiconductor Multilayer Film Reflector)

As an example, the first semiconductor multilayer film reflector 102 is a semiconductor multilayer film reflector doped with n-type impurities, has little light absorption, and has high reflectance and conductivity. The semiconductor multilayer film reflector has a structure in which a plurality of types (for example, two types) of semiconductor layers (for example, AlGaAs layers) having different refractive indexes is alternately stacked with an optical thickness of 1/4 wavelength of an emission wavelength. Examples of the n-type impurities (dopants) include Si, Se, Ge, and the like.

### (Light Emitting Layer)

As an example, the light emitting layer 103 includes a compound semiconductor having band gap energy smaller than those of the first and second semiconductor structures SS1, SS2. The light emitting layer 103 includes, for example, a GaAs-based compound semiconductor (such as, for example, GaAs, AlGaAs, GaInAs and GaInAsN). The light emitting layer 103 may have a quantum well structure, a multiple quantum well structure, or a quantum dot structure. The light emitting layer 103 is also referred to as an "active layer". The light emitting layer 103 includes a light emitting region 103a that is a region (current injection region) into which a current is injected in the light emitting layer 103 and is a region that emits light. The light emitting region 103a is set by an oxidized region 104b of the oxidation confinement layer 104 described later.

### (Oxidation Confinement Layer)

The oxidation confinement layer 104 includes a non-oxidized region 104a that is a region corresponding to the light emitting region 103a and the oxidized region 104b as a current confinement region that surrounds the non-oxidized region 104a. The non-oxidized region 104a includes a compound semiconductor (such as, for example, AlGaAs and AlAs). The oxidized region 104b includes an insulator (for example, an oxide such as AlₓO_{y}). The oxidized region 104b has a higher resistance and a lower refractive index than those of the non-oxidized region 104a, and thus, the non-oxidized region 104a functions as a current/light passing region, and the oxidized region 104b functions as a current/light confinement region. In other words, the oxidized region 104b has both functions of a current confinement region and a light confinement region (light confinement region).

### (Second Semiconductor Multilayer Film Reflector)

As an example, the second semiconductor multilayer film reflector 105 is a semiconductor multilayer film reflector doped with p-type impurities, has little light absorption, and has high reflectance and conductivity. The semiconductor multilayer film reflector has a structure in which a plurality of types (for example, two types) of semiconductor layers (such as, for example, AlGaAs layers) having different refractive indexes is alternately stacked with an optical thickness of 1/4 wavelength of an emission wavelength. Examples of the p-type impurities (dopants) include, for example, Zn, Mg, Be, C, and the like. The second semiconductor multilayer film reflector 105 is set slightly higher in reflectance than the first semiconductor multilayer film reflector 102.

### (Wiring)

The wiring 108 includes, for example, Au/Ni/AuGe, and the like. The wiring 108 includes a first wiring portion 108a that covers the upper surface of the base portion BP (here, the upper surface 101a of the substrate 101), a second wiring portion 108b that is continuous with the first wiring portion 108a and covers a side surface of the proximity portion DEC1 of the dummy element constituent portion DEC on a side of the light emitting element constituent portion LEC, and a third wiring portion 108c that is continuous with the second wiring portion 108b and covers an upper surface of the proximity portion DEC1.

### (Anode Electrode)

As an example, as illustrated in Fig. 5, the anode electrode 106 includes first and second electrodes 106a, 106b.

The first electrode 106a is provided in a circular shape (for example, a ring shape) on the top of the light emitting mesa so as to surround the light emitting region 103a in plan view. The first electrode 106a includes a lower portion 106a1 located on the side of the light emitting layer 103 (lower side) with respect to the first bump joint surface BJS1, and an upper portion 106a2 located on an opposite side (upper side) to the side of the light emitting layer 103 with respect to the first bump joint surface BJS2. Hereinafter, the first electrode 106a is also referred to as a "ring electrode".

In the second electrode 106b, a bump joint portion 106b1 (flat portion) which is a portion having the first bump joint surface BJS1 is located on the top of the light emitting mesa (here, on the second semiconductor multilayer film reflector 105) and on an inner peripheral side of the first electrode 106a, and an outer peripheral portion 106b2 which is a portion on an outer peripheral side of the bump joint portion 106b1 is located on the first electrode 106b. The second electrode 106b is an electrode to be bonded to the other substrate 200 via the first bump BP1, and is also referred to as a "bonding electrode".

Here, a thickness of the first electrode 106a is thicker than a thickness of the bump joint portion 106b1 of the second electrode 106b, but may be thin or the same thickness.

The first bump joint surface BJS1 overlaps at least the light emitting region 103a in plan view. In other words, the first bump joint surface BJS1 overlaps a region including the light emitting region 103a in plan view.

### (Convex Portion)

The convex portion P has a bump position control function when the anode electrode 106 is bonded to the other substrate 200 via a bump (specifically, the first bump BP1) (at the time of bump bonding). The bump position control function is, for example, a stopper function of suppressing protrusion of the bump from the bump joint portion 106b1, a function of self-aligning the bump on the bump joint portion 106b1, and the like. Note that the convex portion P can also be referred to as a "protrusion", a "protruding portion", a "ridge", or the like.

The convex portion P protrudes to a side (upper side) opposite to the side of the light emitting layer 103 more than the first bump joint surface BJS1. Here, the convex portion P is provided on the light emitting element constituent portion LEC (on the top of the light emitting mesa).

The convex portion P does not overlap the light emitting region 103a (region corresponding to the non-oxidized region 104a of the light emitting layer 103) in plan view.

The convex portion P is provided so as to correspond to at least a portion (for example, all) of the outer periphery (outer edge) of the light emitting region 103a in plan view. More specifically, the convex portion P is provided in a circular shape (for example, a ring shape) so as to surround the light emitting region 103a in plan view. Here, the convex portion P is continuously provided corresponding to the entire outer periphery of the light emitting region 103a.

The convex portion P includes a plurality of portions facing each other in the in-plane direction. Here, the convex portion P includes a set of a plurality of portions facing each other across the light emitting region 103a at an arbitrary position in a circumferential direction in plan view.

A protruding amount pa of the convex portion P with respect to the first bump joint surface BJS1 is preferably 1/3 or more, more preferably 1/2 or more, more preferably 2/3 or more, and more preferably 3/4 or more of a thickness of the bump joint portion 106b1 which is a portion including the first bump joint surface BJS1 of the second electrode 106b. The protruding amount pa is preferably, for example, 0.5 µm to 5.0 µm.

As an example, the convex portion P includes an upper portion 106a2 of the first electrode 106a, an outer peripheral portion 106b2 of the second electrode 106b, and a portion 109a on the outer peripheral portion 106b2 of the insulating film 109. In this case, the protruding amount pa of the convex portion P is a value obtained by adding a value obtained by subtracting the thickness of the bump joint portion 106b1 from the thickness of the first electrode 106a, the thickness of the outer peripheral portion 106b2 of the second electrode 106b, and the thickness of the portion 109a on the outer peripheral portion 106b2 of the insulating film 109.

Note that, for example, the thickness of the first electrode 106a may be made smaller than the thickness of the bump joint portion 106b1, and the convex portion P may include the outer peripheral portion 106b2 of the second electrode 106b and the portion on the outer peripheral portion 106b2 of the insulating film 109. In this case, the protruding amount pa of the convex portion P is a value obtained by adding the thickness of the outer peripheral portion 106b2 of the second electrode 106b and the thickness of the portion 109a on the outer peripheral portion 106b2 of the insulating film 109.

### (Light Source Device Including Surface Emitting Element)

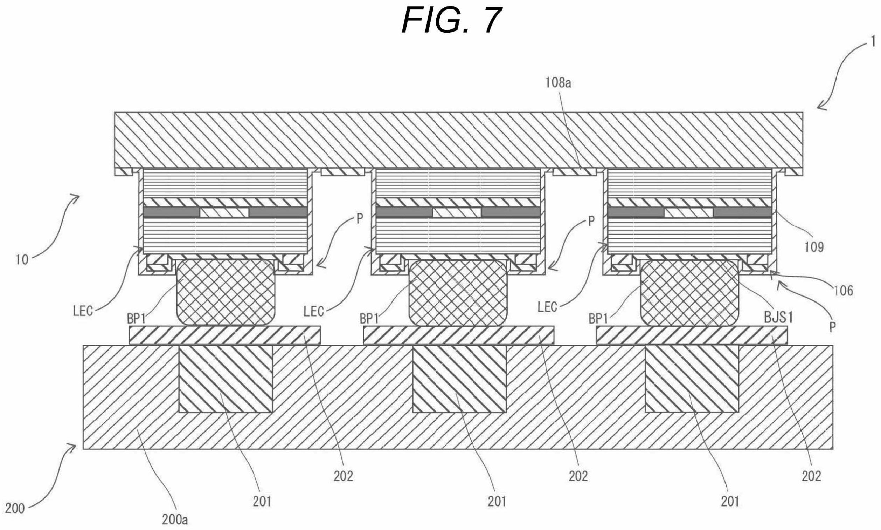

Fig. 6 is a cross-sectional view of a portion including the surface emitting element 10 of the light source device 1 including the surface emitting device SLD including the surface emitting element 10 according to Example 1 of one embodiment of the present technology. Fig. 7 is a cross-sectional view of a portion including the light emitting element constituent portion array LECA of the light source device 1 including the surface emitting device SLD including the surface emitting element 10 according to Example 1 of one embodiment of the present technology.

As illustrated in Figs. 6 and 7, the light source device 1 includes, as an example, the surface emitting device SLD and the other substrate 200.

The other substrate 200 may be a drive substrate including a drive circuit (driver) or a wiring substrate to be connected to the drive circuit (driver). As an example, the driver includes a power supply and a transistor that controls on/off of energization from the power supply to the surface emitting element 10.

As an example, the other substrate 200 includes a substrate portion 200a (such as, for example, a semiconductor substrate, a semi-insulating substrate and an insulating substrate), first and second wirings 201, 203, and first and second electrodes 202, 204. The first wiring 201 (for example, an anode wiring) is embedded in a recess provided at a position corresponding to the light emitting element constituent portion LEC on a surface of the substrate portion 200a on a side of the surface emitting element 10. The first electrode 202 is provided on a first wiring 201 and is electrically connected to the first wiring 201. A second wiring 203 (for example, a cathode wiring) is embedded in a recess provided at a position corresponding to the dummy element constituent portion DEC on a surface of the substrate portion 200a on a side of the surface emitting element 10. The second electrode 204 is provided on the second wiring 203 and is electrically connected to the second wiring 203.

The anode electrode 106 provided on each of the light emitting element constituent portions LEC and the corresponding first electrode 202 are bonded via the first bump BP1 (conductive bump). The cathode electrode 107 provided on each dummy element constituent portion DEC and the corresponding second electrode 204 are bonded via the second bump BP2 (conductive bump). The first and second bumps BP1, BP2 include, for example, Au, Ag, Cu, solder, and the like.

In the light source device 1, a position of the first bump BP1 is controlled to an appropriate position (position not protruding from the bump joint portion 106b1) by the convex portion P on the light emitting element constituent portion LEC. As an example, in plan view, the position of the first bump BP1 where the center of the first bump BP1 and the center of the light emitting region 103a coincide with each other can be set as an optimum position (ideal position).

### <<Operation of Surface Emitting Element>>

Hereinafter, operation of the surface emitting element 10 will be described. If a power supply voltage of the driver is applied to the surface emitting element 10, a current from the anode side of the driver is injected into the light emitting region 103a of the light emitting layer 103 confined by the oxidation confinement layer 104 through the anode electrode 106 and the second semiconductor multilayer film reflector 105 in this order. In this event, the light emitting region 103a emits light, and the light travels between the first and second semiconductor multilayer film reflectors 102, 105 while being amplified by the light emitting layer 103 and confined by the oxidation confinement layer 104, and is emitted as laser light to a back surface (lower surface side) of the substrate 101 when an oscillation condition is satisfied. The current injected into the light emitting region 103a flows out to the cathode side of the driver through the first semiconductor multilayer film reflector 102, the substrate 101, the wiring 108, and the cathode electrode 107 in this order.

### <<Method for Manufacturing Surface Emitting Device Including Surface Emitting Element>>

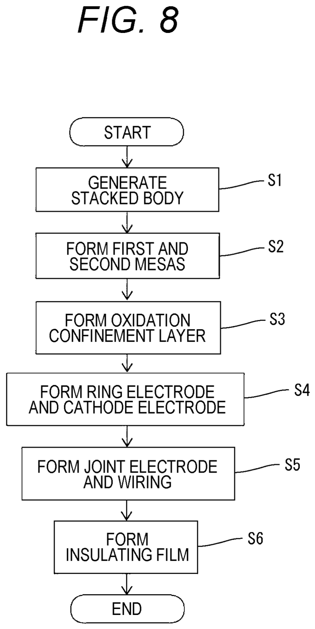

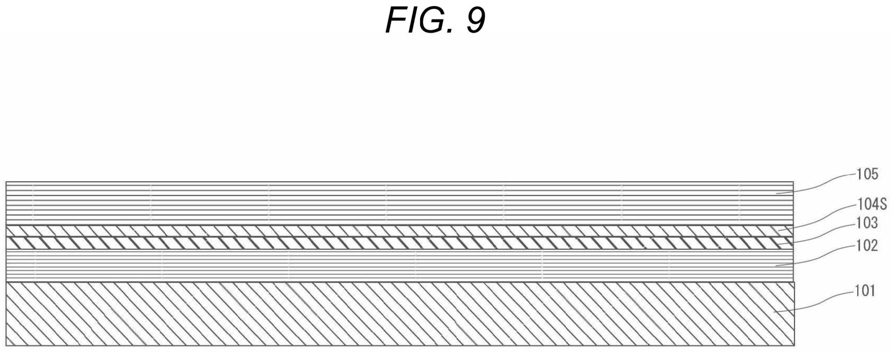

Hereinafter, an example of a method for manufacturing the surface emitting device SLD including the surface emitting element 10 will be described with reference to the flowchart of Fig. 8 and cross-sectional views (Figs. 9 to 15) corresponding to Fig. 1 for each manufacturing process of the surface emitting element 10. As overall flow, first, a plurality of surface emitting devices SLD each including the surface emitting element 10 is simultaneously generated on one wafer (hereinafter, referred to as the "substrate 101" for convenience) which is a base material of the substrate 101 by a semiconductor manufacturing method using a semiconductor manufacturing device. Next, the plurality of continuous integrated surface emitting devices SLD is separated from each other by dicing to obtain a chip-shaped surface emitting device SLD.

In the first step S1, a stacked body is generated (see Fig. 9). Specifically, for example, the first semiconductor multilayer film reflector 102, the light emitting layer 103, and the oxidized layer 104S (such as, for example, an AlGaAs layer and an AlAs layer), and the second semiconductor multilayer film reflector 105 are stacked in this order on the substrate 101 as a growth substrate by an epitaxial crystal growth method such as a metal organic chemical vapor deposition (MOCVD) method to generate a stacked body. In this event, as raw materials of the compound semiconductor, for example, a methyl-based organometallic gas such as trimethylaluminum (TMAl), trimethylgallium (TMGa), or trimethylindium (TMIn) and an arsine (AsH₃) gas are used, as raw materials of donor impurities, for example, disilane (Si₂H₆) is used, and as raw materials of acceptor impurities, for example, carbon tetrabromide (CBr₄) is used.

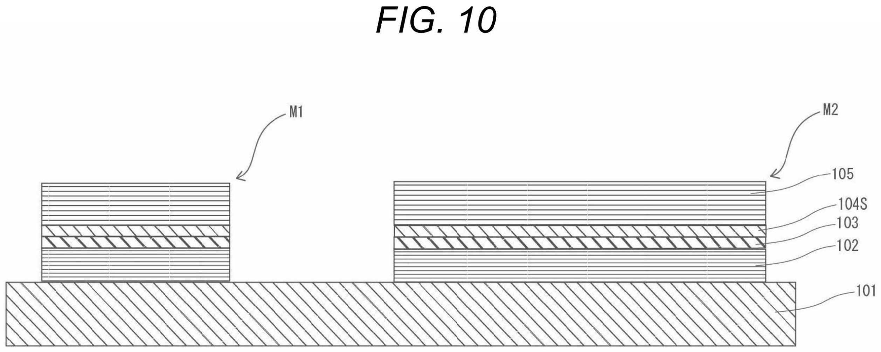

In the next step S2, the first and second mesas M1, M2 are formed (see Fig. 10). Specifically, a resist pattern covering a portion where the first and second mesas M1, M2 are to be formed is formed on the stacked body by photolithography, and the stacked body is etched by dry etching or wet etching using the resist pattern as a mask. The etching depth at this time is, for example, until the substrate 101 is exposed. As a result, the first and second mesas M1, M2 are formed. Thereafter, the resist pattern is removed.

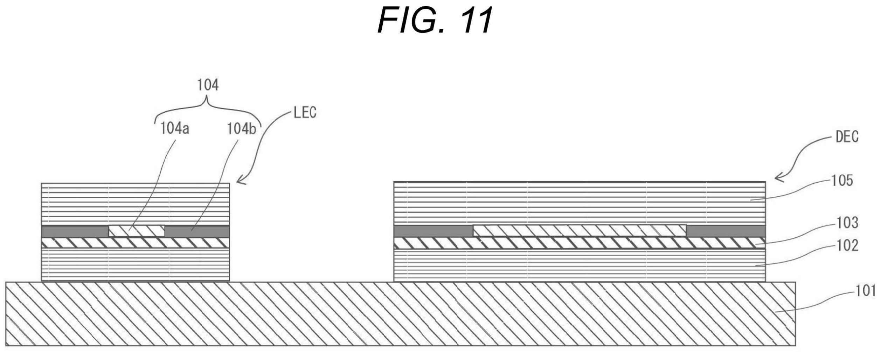

In the next step S3, the oxidation confinement layer 104 is formed (see Fig. 11). Specifically, the first and second mesas M1, M2 (see Fig. 10) are exposed to a high-temperature water vapor atmosphere, and the oxidized layer 104S is selectively oxidized by a predetermined distance from the side surface. As a result, the oxidation confinement layer 104 in which the non-oxidized region 104a is surrounded by the oxidized region 104b is formed in the first mesa M1, and thereby, the light emitting mesa is generated. A layer in which the non-oxidized region is surrounded by the oxidized region is also formed in the second mesa M2, and thereby, the dummy mesa is generated.

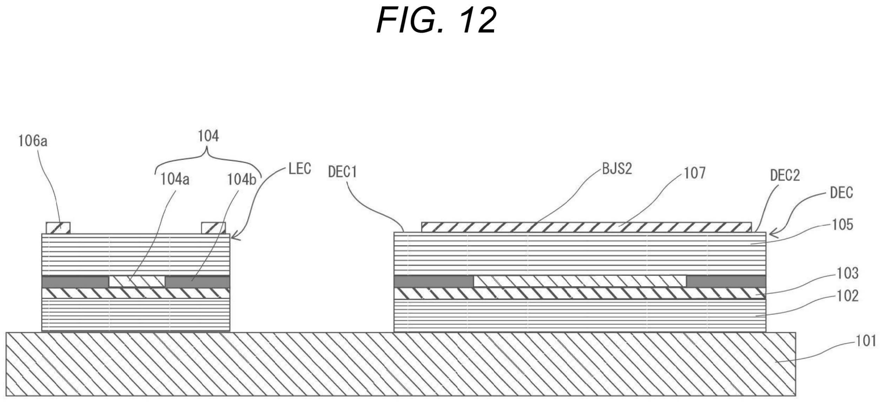

In the next step S4, a ring electrode that is the first electrode 106a of the anode electrode 106, and the cathode electrode 107 are formed (see Fig. 12). Specifically, for example, the first electrode 106a is formed in a ring shape on the top of the light emitting mesa and the cathode electrode 107 is formed in a solid shape on the top of the dummy mesa by a lift-off method. In this event, for example, vapor deposition, sputtering, or the like, is used for forming an electrode material.

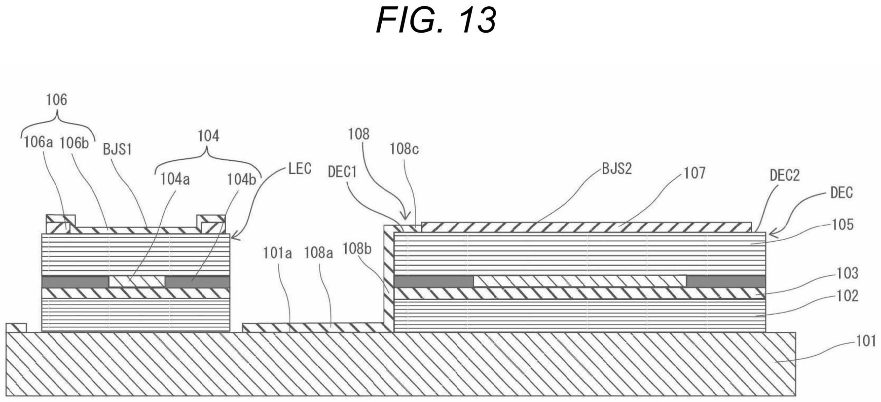

In the next step S5, a bonding electrode which is the second electrode 106b of the anode electrode 106 and the wiring 108 are formed (see Fig. 13). Specifically, for example, by a lift-off method, the bonding electrode is formed such that the bump joint portion (the portion having the first bump joint surface BJS1) is located on the light emitting mesa, and the outer peripheral portion is located on the ring electrode. For example, by the lift-off method, the wiring 108 is formed such that the first wiring portion 108a covers the upper surface of the substrate 101, the second wiring portion 108b covers the side surface on the light emitting mesa side of the proximity portion of the dummy mesa, and the third wiring portion 108c is in contact with the cathode electrode 107 on the proximity portion. In this event, for example, vapor deposition, sputtering, or the like, is used for forming an electrode material.

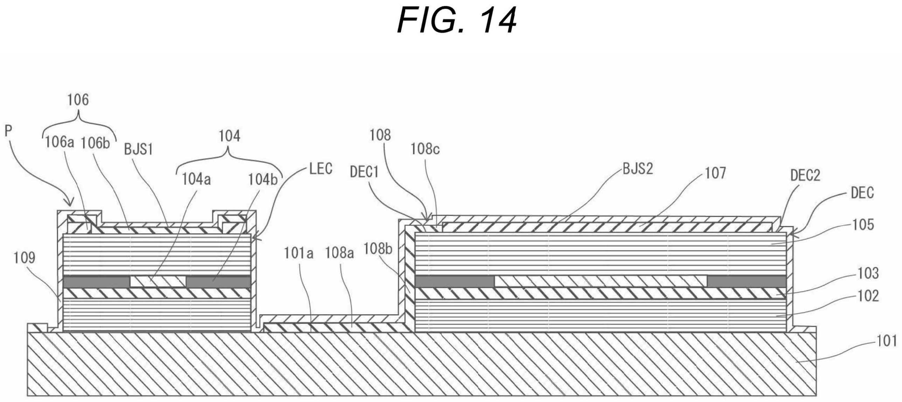

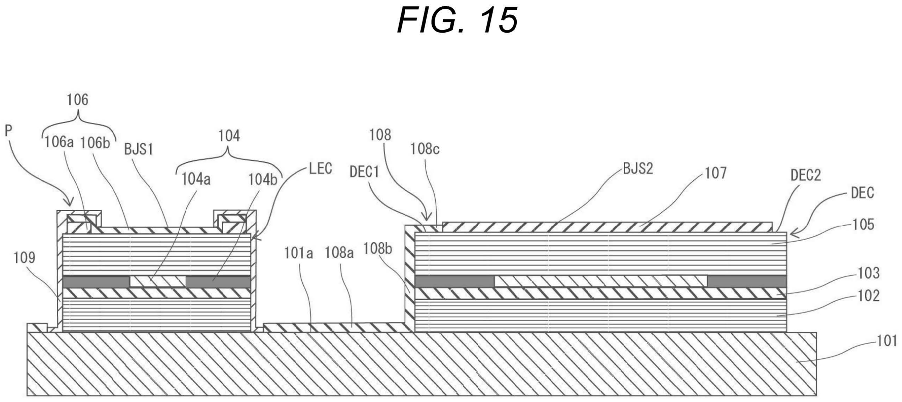

In the last step S6, the insulating film 109 is formed. Specifically, first, the insulating film 109 is formed on the entire surface (see Fig. 14). Next, the insulating film 109 other than the insulating film 109 covering the side surface of the light emitting mesa and the outer peripheral portion of the bonding electrode is removed by photolithography and etching to expose the first bump joint surface BJS1 of the bonding electrode, the second bump joint surface BJS2 of the cathode electrode 107, and the like, (see Fig. 15).

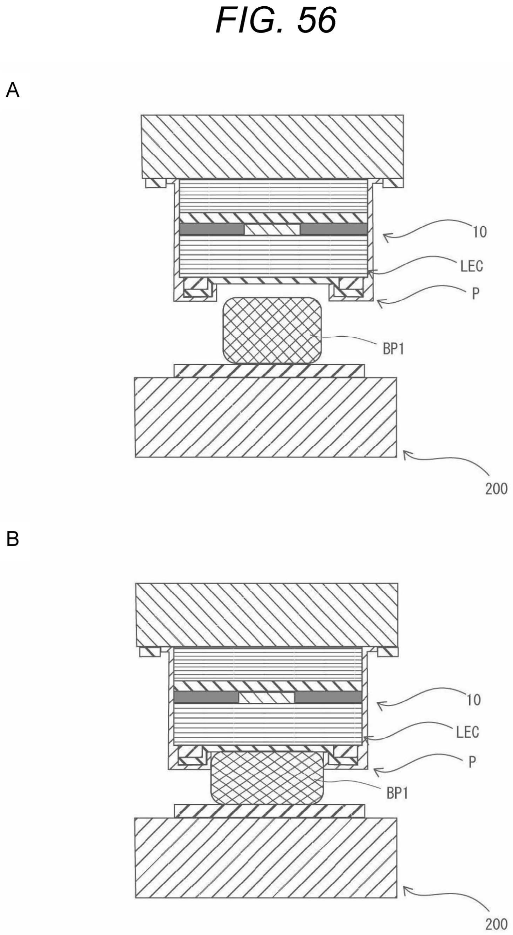

As illustrated in Figs. 6 and 7, the surface emitting device SLD manufactured as described above is bonded to the other substrate 200 via the first and second bumps BP1 and BP2 (junction-down mounted). In this event, when the state shifts from the state before bump bonding illustrated in Fig. 56A to the state at the time of bump bonding illustrated in Fig. 56B (pressurized state), the first bump BP1 expands in a lateral direction while being crushed, but the expansion is restricted from all directions in a circumferential direction by the convex portion P, and thus, the first bump BP1 self-aligns at an appropriate position without bias with respect to the bump joint portion of the bonding electrode.

### <<Effects of Surface Emitting Element>>

Hereinafter, effects of the surface emitting element 10 will be described.

The surface emitting element 10 includes a first structure 1S including a first semiconductor structure SS1, a second structure 1S stacked with the first structure 1S and including a second semiconductor structure SS2, and a light emitting layer 103 including a light emitting region 103a arranged between the first structure and the second structure. The second structure 2S further includes an anode electrode 106 (electrode) including a first bump joint surface BJS1 (external joint surface) on the side opposite to the side of the light emitting layer 103 of the second semiconductor structure SS2, and the convex portion P protruding to the side opposite to the side of the light emitting layer 103 more than the first bump joint surface BJS1 is provided in the second structure 2S.

In this case, when the anode electrode 106 and the other substrate 200 (substrate) are bonded via the first bump BP1, the position of the first bump BP1 is restricted by the convex portion P. As a result, protrusion, or the like, due to the first bump BP1 being crushed is suppressed.

As a result, according to the surface emitting element 10, it is possible to provide a surface emitting element having position controllability of the bump when the electrode and the substrate are bonded via the bump. The fact that the position of the bump can be appropriately controlled by the surface emitting element having the position controllability of the bump is extremely effective in securing reliability because it is possible to suppress bias of a current path, a joint failure caused by protrusion or bias of the bump or element destruction due to local stress generated in the light emitting unit due to bias of the bump.

The convex portion P does not overlap the light emitting region 103a in plan view. As a result, the convex portion P can have a function of restricting displacement of the first bump BP1 in a direction away from the center of the light emitting region 103a in plan view.

The first bump joint surface BJS1 overlaps at least the light emitting region 103a in plan view. As a result, the first bump joint surface BJS1 can be positioned at a position where a current path can be appropriately formed.

The first bump joint surface BJS1 is a flat surface to be bonded to the other substrate 200 via the first bump BP1. As a result, the first bump joint surface BJS1 can be a surface suitable for bump bonding.

The protruding amount pa of the convex portion P with respect to the first bump joint surface BJS1 is preferably 1/3 or more of the thickness of the bump joint portion which is a portion including the first bump joint surface BJS1 of the anode electrode 106. As a result, effectiveness of the stopper function of the convex portion P can be enhanced.

The convex portion P includes a plurality of portions facing each other in the in-plane direction. As a result, the convex portion P can have a function of self-aligning the first bump BP1.

The convex portion P is provided so as to correspond to at least a portion (for example, all) of the outer periphery of the light emitting region 103a in plan view. As a result, a function of restricting displacement of the first bump BP1 in a direction away from the center of the light emitting region 103a in plan view can be imparted to the convex portion P with a width in the in-plane direction.

The convex portion P surrounds the light emitting region 103a in plan view. As a result, the convex portion P restricts displacement of the first bump BP1 from the center of the light emitting region 103a from all directions in the circumferential direction in plan view, and thus, the first bump BP1 can be positioned with respect to the light emitting region 103a by highly accurate self-alignment in plan view.

The oxidation confinement layer 104 including the oxidized region 104b as a current confinement region for setting the light emitting region 103a is provided between the surface of the second structure 2S on the side (upper side) opposite to the side of the light emitting layer 103 and the light emitting layer 103. As a result, a current/light confinement function can be obtained.

Each of the first and second semiconductor structures SS1, SS2 has a semiconductor multilayer film reflector. As a result, the surface emitting element 10 can constitute a high-efficiency and high-output surface emitting laser.

The light source device 1 includes the surface emitting element 10 and the other substrate 200, and the anode electrode 106 and the other substrate 200 are bonded via the first bump BP1, and the cathode electrode 107 and the other substrate 200 are bonded via the second bump BP2. Accordingly, a light source device having excellent reliability can be provided.

### <2. Surface Emitting Element According to Example 2 of One Embodiment of Present Technology>

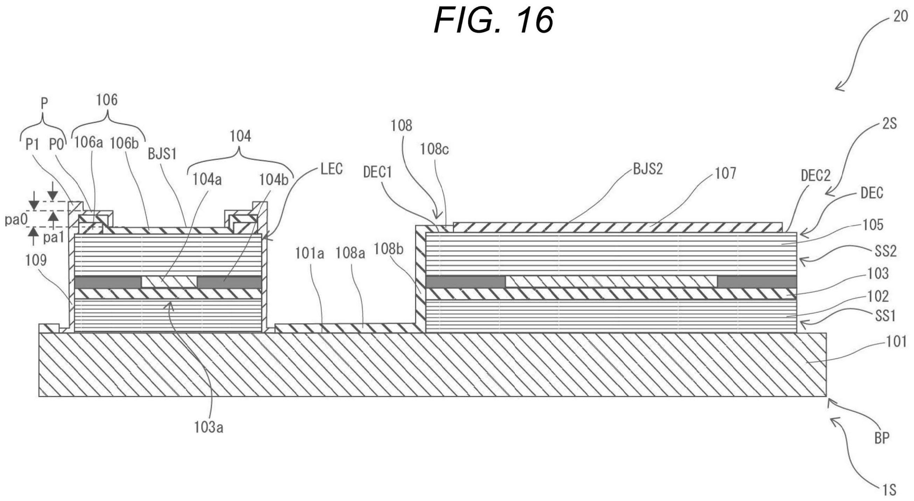

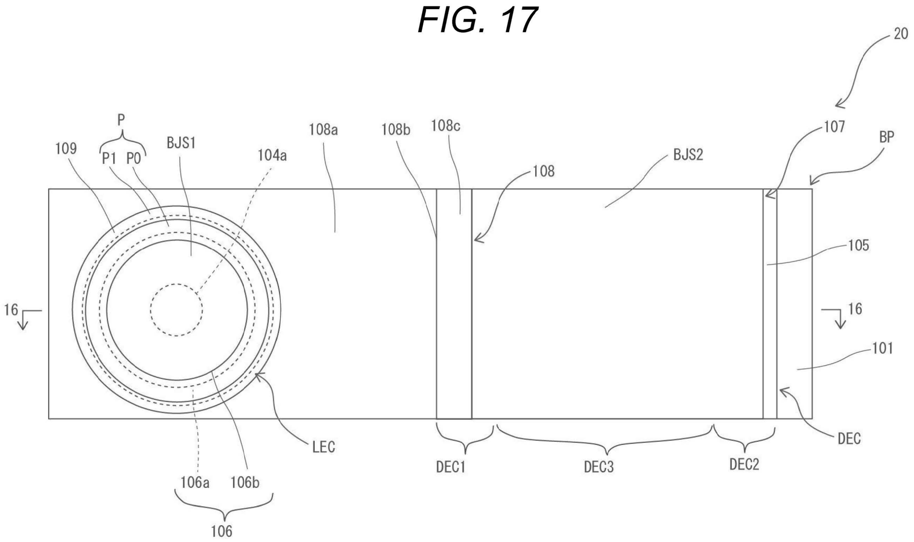

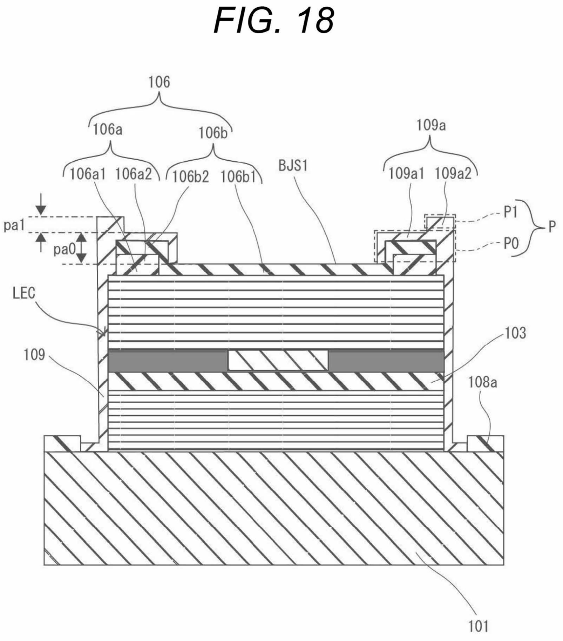

Fig. 16 is a cross-sectional view of a surface emitting element 20 according to Example 2 of one embodiment of the present technology. Fig. 17 is a plan view of the surface emitting element 20 according to Example 2 of one embodiment of the present technology. Fig. 16 is a cross-sectional view taken along a line 16-16 in Fig. 17. Fig. 18 is a cross-sectional view of a light emitting unit of the surface emitting element 20 according to Example 2 of one embodiment of the present technology.

As illustrated in Figs. 16 to 18, the surface emitting element 20 has a configuration similar to that of the surface emitting element 10 according to Example 1 except that the convex portion P is a stepped convex portion.

As an example, as illustrated in Fig. 18, the convex portion P includes a base portion P0 and at least one (for example, one) protrusion P1 protruding from the base portion P0 to a side (upper side) opposite to the side of the light emitting layer 103. The base portion P0 is a portion in a circular shape (for example, a ring shape) that goes around so as to surround the light emitting region 103a in plan view. The protrusion P1 is a portion in a circular shape (for example, a ring shape) that goes around on the outer peripheral portion of the base portion P0 in plan view.

As an example, the base portion P0 includes an upper portion 106a2 of the first electrode 106a, an outer peripheral portion 106b2 of the second electrode 106b, and a portion 109a1 on the outer peripheral portion 106b2 of the insulating film 109. As an example, the protrusion P1 includes a portion 109a2 located on the outer peripheral portion of the base portion P0 of the insulating film 109.

In the surface emitting element 20, at the time of bump bonding, the base portion P0 functions as a first stopper with respect to the first bump BP1, and the protrusion P1 functions as a second stopper.

When a protruding amount of the base portion P0 with respect to the first bump joint surface BJS1 is set as pa0 and a protruding amount of the protrusion P1 with respect to the base portion P0 is set as pa1, it is preferable that pa0 and pa1 satisfy pa0 > pa1. to increase a function of the first stopper to a certain level, and cause the second stopper to fulfill a secondary stopper function when the protrusion of the bump cannot be prevented by the first stopper. Note that pa0 and pa1 may satisfy pa0 ≤ pa1.

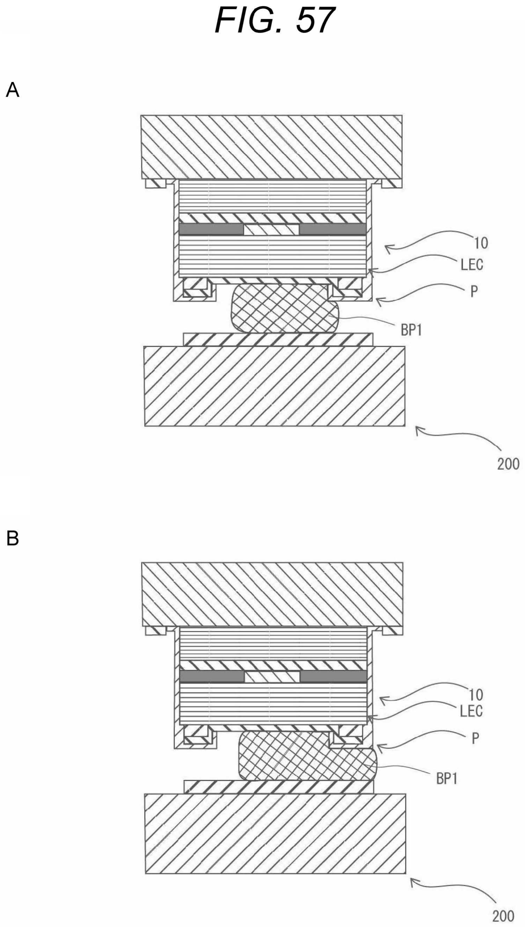

Here, for example, as illustrated in Figs. 57A and 57B, when the surface emitting element 10 according to Example 1 is bonded to the other substrate 200 via the first bump BP1, there is a possibility that the first bump BP1 is crushed due to overload, or the like, and protrudes beyond the convex portion P.

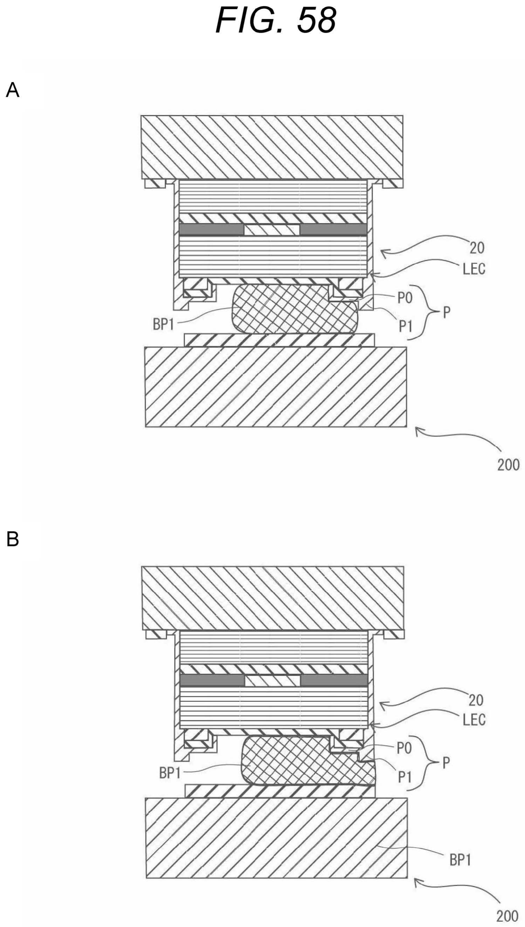

On the other hand, as illustrated in Fig. 58A, when the surface emitting element 20 according to Example 2 is bonded to the other substrate 200 via the first bump BP1, even if the first bump BP1 is crushed and goes beyond the base portion P0 due to overload, or the like, protrusion of the first bump BP1 can be suppressed by the protrusion P1. As described above, in the surface emitting element 20, the convex portion P has a two-stage stopper structure.

According to the surface emitting element 20, the protrusion of the bump is further suppressed by the convex portion P, so that reliability can be further improved.

### <3. Surface Emitting Element According to Example 3 of One Embodiment of Present Technology>

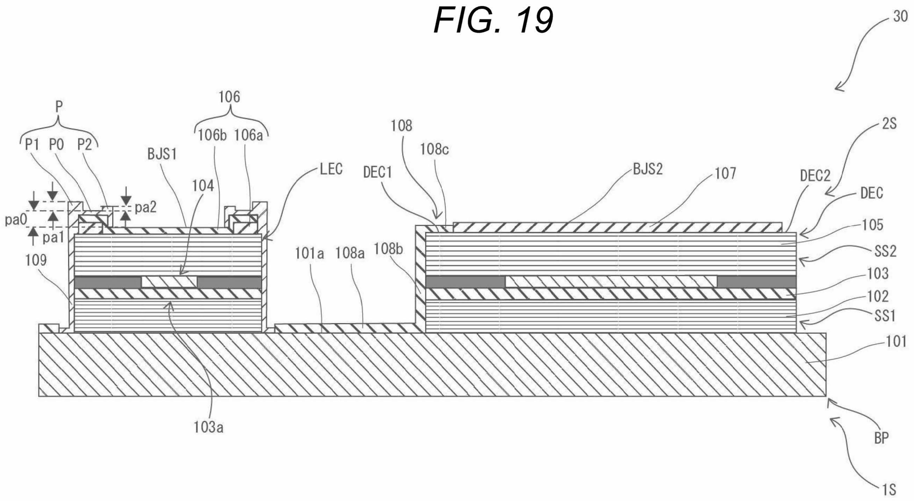

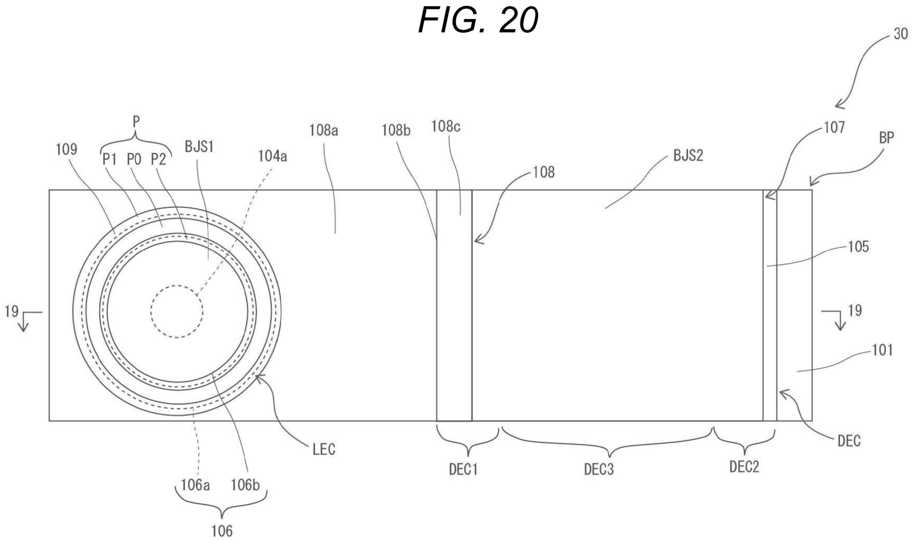

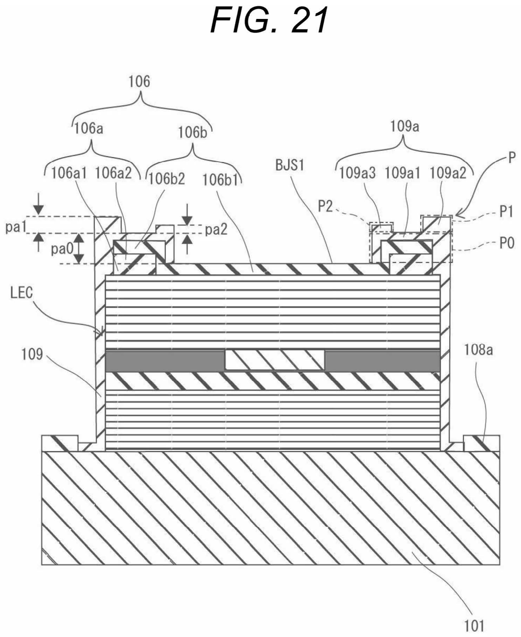

Fig. 19 is a cross-sectional view of a surface emitting element 30 according to Example 3 of one embodiment of the present technology. Fig. 20 is a plan view of the surface emitting element 30 according to Example 3 of one embodiment of the present technology. Fig. 19 is a cross-sectional view taken along a line 19-19 in Fig. 20. Fig. 21 is a cross-sectional view of a light emitting unit of the surface emitting element 30 according to Example 3 of one embodiment of the present technology.

As illustrated in Figs. 19 to 21, the surface emitting element 30 has a configuration similar to that of the surface emitting element 20 according to Example 2 except that at least one protrusion is a plurality of protrusions (for example, protrusions P1, P2) having different protruding amounts.

As an example, the protrusion P1 is a portion in a circular shape (for example, a ring shape) that goes around on an outer peripheral portion of the base portion P0 in plan view. The protrusion P2 is a portion in a circular shape (for example, a ring shape) that goes around on an inner peripheral portion of the base portion P0 in plan view.

As an example, as illustrated in Fig. 21, the base portion P0 includes an upper portion 106a2 of the first electrode 106a, an outer peripheral portion 106b2 of the second electrode 106b, and a portion 109a1 on the outer peripheral portion 106b2 of the insulating film 109. As an example, the protrusion P1 includes a portion 109a2 located on the outer peripheral portion of the base portion P0 of the insulating film 109. As an example, the protrusion P2 includes a portion 109a3 located on the inner peripheral portion of the base portion P0 of the insulating film 109.

In the surface emitting element 30, at the time of bump bonding, the base portion P0 and the protrusion P2 function as a first stopper with respect to the first bump BP1, and the protrusion P1 functions as a second stopper.

It is preferable that the plurality of protrusions P1, P2 farther from the light emitting region 103a in plan view has a larger protruding amount. More specifically, when a protruding amount of the protrusion P1 relatively far from the light emitting region 103a out of the protrusions P1, P2 with respect to the base portion P0 is set as pa1, and a protruding amount of the protrusion P2 relatively close to the light emitting region 103a with respect to the base portion P0 is set as pa2, it is preferable that pa1 and pa2 satisfy pa1 > pa2. Note that pa1 and pa2 may satisfy pa1 ≤ pa2.

It is preferable that the protruding amount pa0 of the base portion P0 with respect to the first bump joint surface BJS1 satisfies pa0 > pa1 and/or pa0 > pa2. Note that pa0 may satisfy pa0 ≤ pa1 and/or pa0 ≤ pa2.

Here, for example, as illustrated in Fig. 58B, when the surface emitting element 20 according to Example 2 is bonded to the other substrate 200 via the first bump BP1, the first bump BP1 may be crushed due to overload, or the like, and may protrude beyond the base portion P0 and further beyond the protrusion P1.

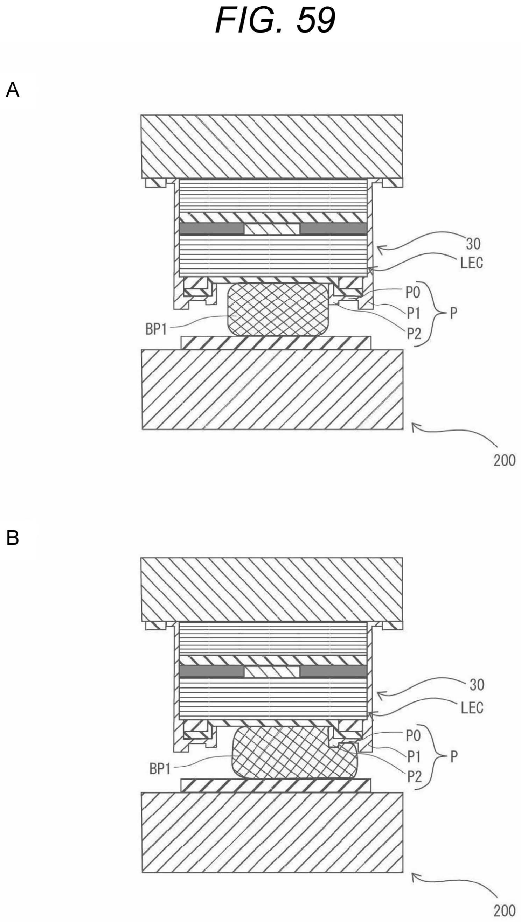

On the other hand, as illustrated in Fig. 59A, when the surface emitting element 30 according to Example 3 is bonded to the other substrate 200 via the first bump BP1, even if the first bump BP1 is crushed due to overload, or the like, the protrusion of the first bump BP1 can be further suppressed by the base portion P0 and the protrusion P2 having a higher stopper function than that of the base portion P0 alone. As illustrated in Fig. 59B, even if the first bump BP1 goes beyond the protrusion P2, the protrusion P1 functions as a second stopper, and the protrusion P2 bites into the first bump BP1 like a wedge to suppress sliding of the first bump BP1 and further suppresses protrusion of the first bump BP1.

According to the surface emitting element 30, the protrusion of the bump is further suppressed by the convex portion P, so that reliability can be further improved. Note that the number of protrusions on the base portion P0 may be three or more. Also in this case, it is preferable that the plurality of protrusions farther from the light emitting region in plan view has a larger protruding amount.

### <4. Surface Emitting Element According to Example 4 of One Embodiment of Present Technology>

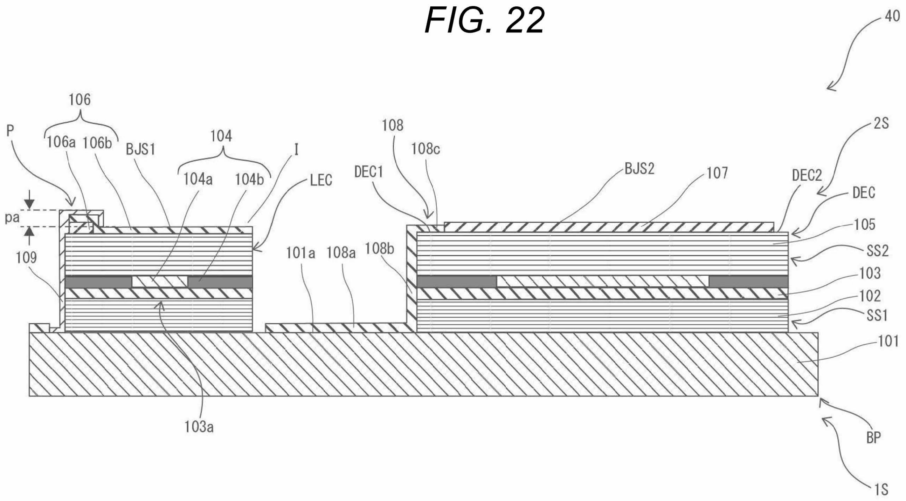

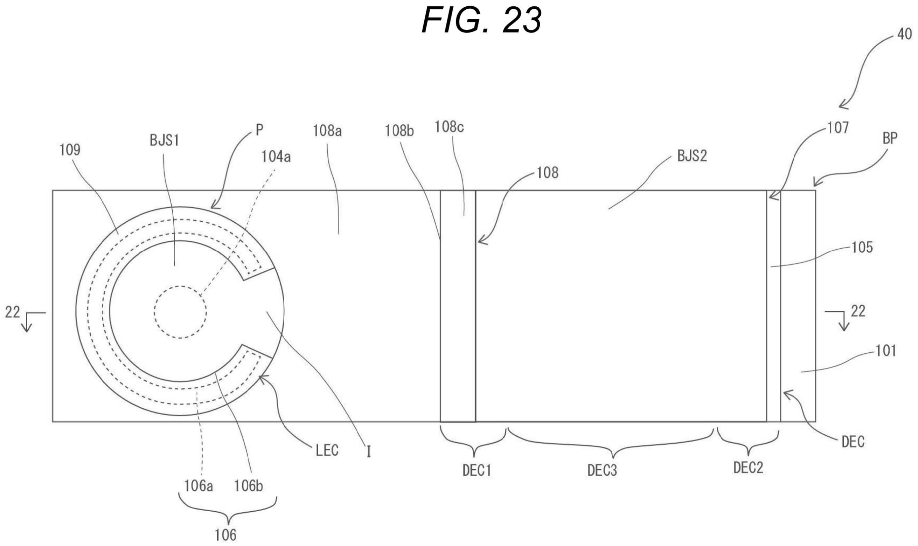

Fig. 22 is a cross-sectional view of a surface emitting element 40 according to Example 4 of one embodiment of the present technology. Fig. 23 is a plan view of the surface emitting element 40 according to Example 4 of one embodiment of the present technology. Fig. 22 is a cross-sectional view taken along a line 22-22 in Fig. 23.

As illustrated in Figs. 22 and 23, the surface emitting element 40 has a configuration similar to that of the surface emitting element 10 according to Example 1 except that the convex portion P is provided so as to correspond to a portion of the outer periphery of the light emitting region 103a in plan view.

In the surface emitting element 40, the convex portion P has an intermittent portion I (cut, notch) in the circumferential direction. In the convex portion P, a ratio of the intermittent portion I to the entire circumference is preferably 5% or more and 45% or less. Here, as an example, the convex portion P has a C-shape in plan view.

### <5. Surface Emitting Element According to Example 5 of One Embodiment of Present Technology>

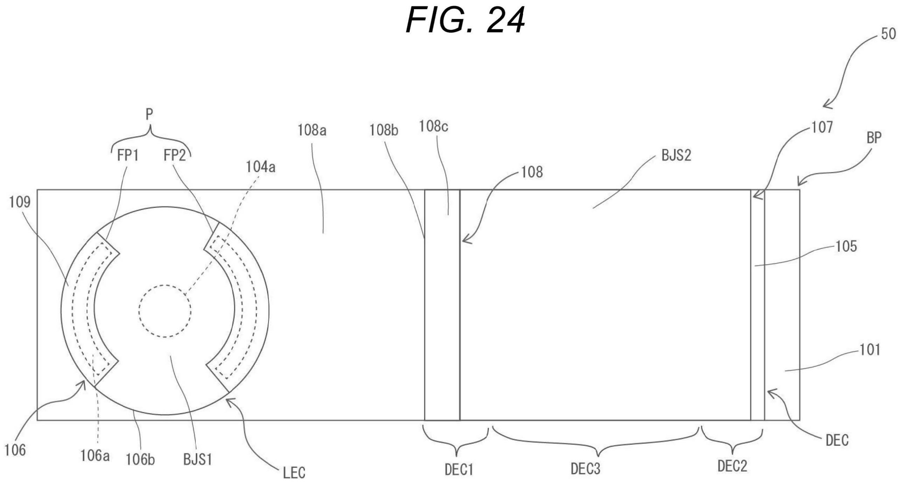

Fig. 24 is a plan view of a surface emitting element 50 according to Example 5 of one embodiment of the present technology.

As illustrated in Fig. 24, the surface emitting element 50 has a configuration similar to that of the surface emitting element 10 according to Example 1 except that the convex portion P is provided so as to correspond to a portion of the outer periphery of the light emitting region 103a in plan view.

The surface emitting element 50 has a configuration similar to that of the surface emitting element 10 according to Example 1 except that the convex portion P has two portions facing each other in the in-plane direction, that is, first and second portions FP1, FP2 separated from each other.

The first and second portions FP1, FP2 are arranged across the light emitting region 103a in plan view. As an example, each of the first and second portions FP1, FP2 has an arc shape in plan view. Here, sizes of the first and second portions FP1, FP2 are the same, but may be different. In the convex portion P, a sum of the ratios of the first and second portions FP1, FP2 to the entire circumference is preferably 55% or more and 95% or less.

### <6. Surface Emitting Element According to Example 6 of One Embodiment of Present Technology>

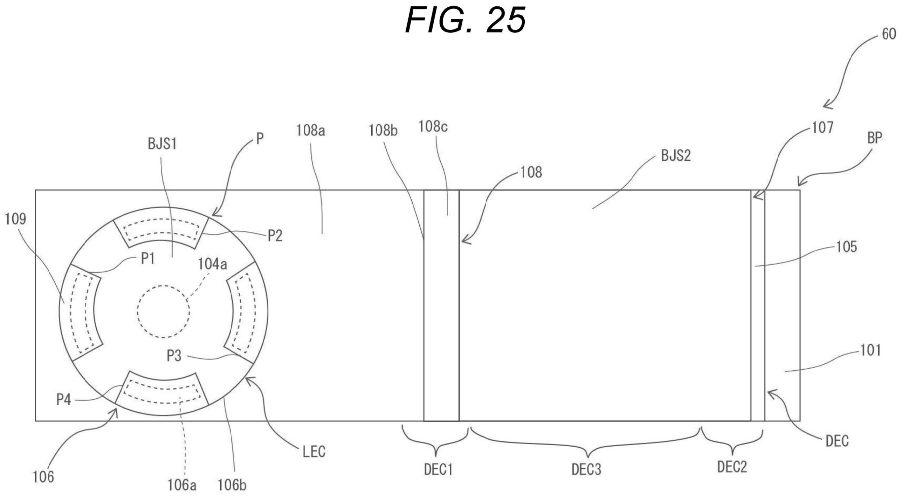

Fig. 25 is a plan view of a surface emitting element 60 according to Example 6 of one embodiment of the present technology.

As illustrated in Fig. 25, the surface emitting element 60 has a configuration similar to that of the surface emitting element 10 according to Example 1 except that the convex portion P is provided so as to correspond to a portion of the outer periphery of the light emitting region 103a in plan view.

In the surface emitting element 60, the convex portion P has a plurality of (for example, four) portions SP1, SP2, SP3, SP4 arranged so as to surround the light emitting region 103a in plan view.

As an example, the four portions SP1, SP2, SP3, SP4 surround the light emitting region 103a from four sides in plan view. Each portion has an arc shape in plan view, for example.

Here, sizes of the four portions SP1, SP2, SP3, SP4 are the same, but may be different. In the convex portion P, a sum of ratios of the four portions SP1, SP2, SP3, SP4 to the entire circumference is preferably 55% or more and 95% or less.

### <7. Surface Emitting Element According to Example 7 of One Embodiment of Present Technology>

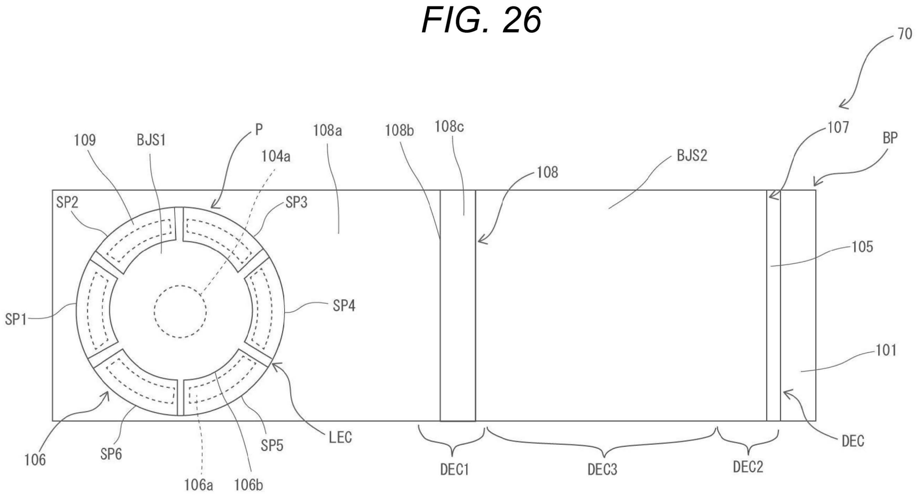

Fig. 26 is a plan view of a surface emitting element 70 according to Example 7 of one embodiment of the present technology.

As illustrated in Fig. 26, the surface emitting element 70 has a configuration similar to that of the surface emitting element 10 according to Example 1 except that the convex portion P is provided so as to correspond to a portion of the outer edge of the light emitting region 103a in plan view.

In the surface emitting element 70, the convex portion P has a plurality of (for example, six) portions SP1, SP2, SP3, SP4, SP5, SP6 arranged so as to surround the light emitting region 103a in plan view.

As an example, the six portions SP1, SP2, SP3, SP4, SP5, SP6 surround the light emitting region 103a from six sides in plan view. Each portion has an arc shape in plan view, for example.

Here, sizes of the six portions SP1, SP2, SP3, SP4, SP6 are the same, but may be different. In the convex portion P, a sum of ratios of the six portions SP1, SP2, SP3, SP4, SP5, SP6 to the entire circumference is preferably 55% or more and 95% or less.

### <8. Surface Emitting Element According to Example 8 of One Embodiment of Present Technology>

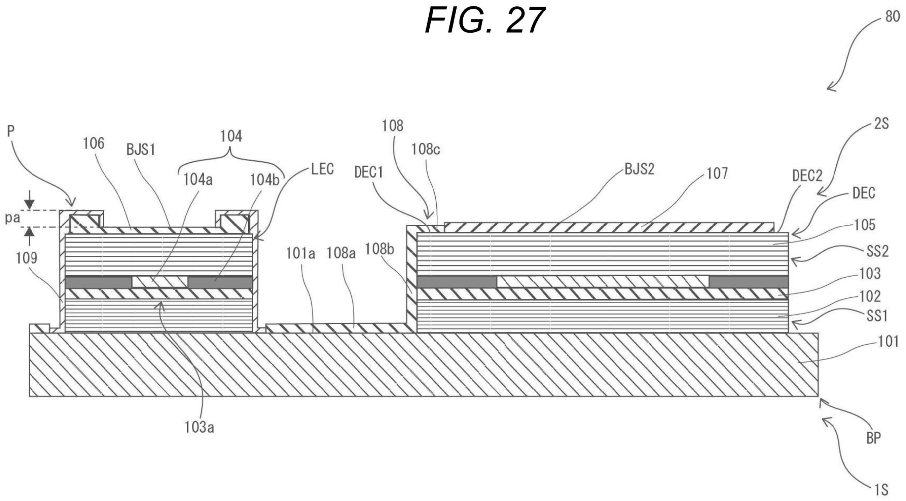

Fig. 27 is a cross-sectional view of a surface emitting element 80 according to Example 8 of one embodiment of the present technology.

As illustrated in Fig. 27, the surface emitting element 80 has a configuration similar to that of the surface emitting element 10 according to Example 1 except that the anode electrode 106 includes a single member, and the thickness of the outer peripheral portion of the anode electrode 106 is thicker than the thickness of the bump joint portion.

In the surface emitting element 80, the convex portion P includes an upper portion of the outer peripheral portion of the anode electrode 106 (portion protruding to the side opposite to the side of the light emitting layer 103 with respect to the first bump joint surface BJS1) and a portion of the insulating film 109 on the upper portion of the outer peripheral portion.

### <9. Surface Emitting Element According to Example 9 of One Embodiment of Present Technology>

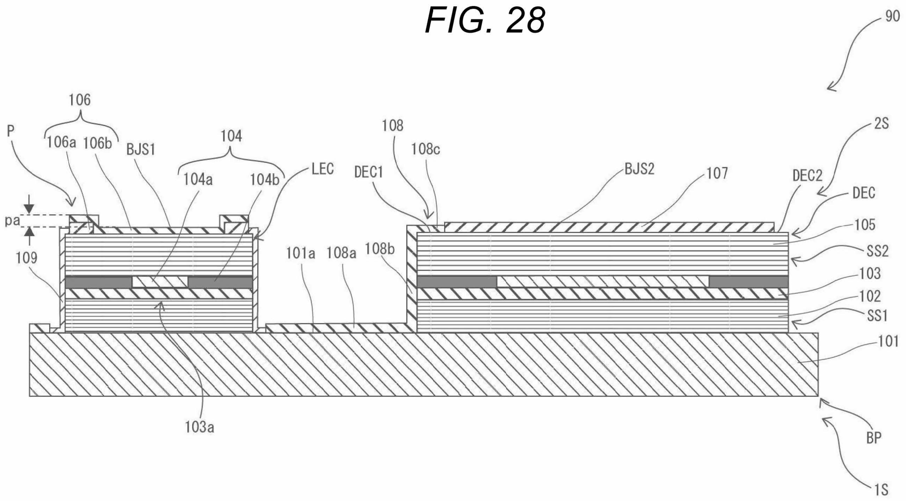

Fig. 28 is a cross-sectional view of a surface emitting element 90 according to Example 9 of one embodiment of the present technology.

As illustrated in Fig. 28, the surface emitting element 90 has a configuration similar to that of the surface emitting element 10 according to Example 1 except that the insulating film 109 does not cover the outer peripheral portion of the second electrode 106b (bonding electrode).

In the surface emitting element 90, the convex portion P includes an upper portion (portion protruding to the side opposite to the side of the light emitting layer 103 with respect to the first bump joint surface BJS1) of the first electrode 106a (ring electrode) and an outer peripheral portion of the bonding electrode.

### <10. Surface Emitting Element According to Example 10 of One Embodiment of Present Technology>

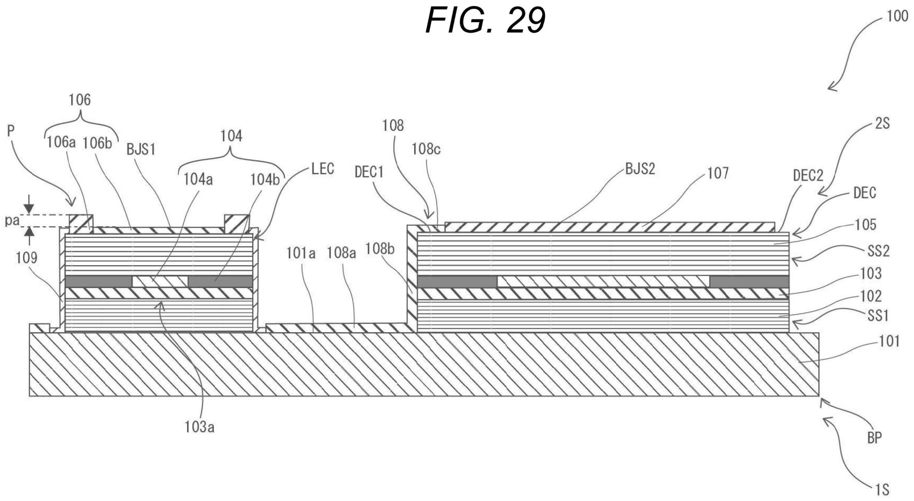

Fig. 29 is a cross-sectional view of a surface emitting element 100 according to Example 10 of one embodiment of the present technology.

As illustrated in Fig. 29, the surface emitting element 100 has a configuration similar to that of the surface emitting element 10 according to Example 1 except that the bonding electrode has only a bump joint portion (flat portion).

In the surface emitting element 100, the convex portion P includes an upper portion of the ring electrode (portion protruding to the side opposite to the side of the light emitting layer 103 with respect to the first bump joint surface BJS1).

### <11. Surface Emitting Element According to Example 11 of One Embodiment of Present Technology>

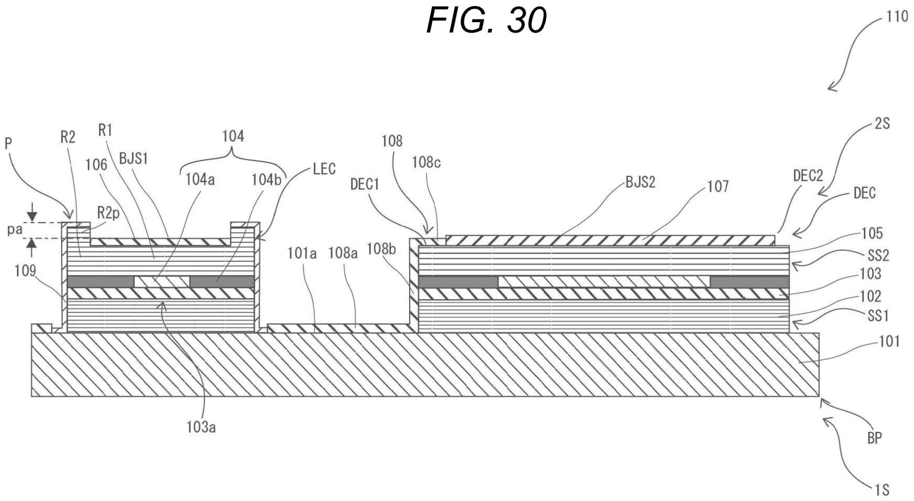

Fig. 30 is a cross-sectional view of a surface emitting element 110 according to Example 11 of one embodiment of the present technology.

As illustrated in Fig. 30, the surface emitting element 110 has a configuration similar to that of the surface emitting element 10 according to Example 1 except that the second semiconductor structure SS2 includes a solid anode electrode 106 provided on the first region R1 including the region corresponding to the light emitting region 103a on the side opposite to the side of the light emitting layer 103, the second region R2 around the first region R1 includes a protruding portion R2p protruding to the side (upper side) opposite to the side of the light emitting layer 103 with respect to the first region R1, and the convex portion P includes a portion (upper portion) of the protruding portion R2p.

The second region R2 has a circular shape (for example, a ring shape) surrounding the first region A1. In the surface emitting element 110, the second semiconductor multilayer film reflector 105 included in the second semiconductor structure SS2 of the light emitting element constituent portion LEC includes the first and second regions R1, R2.

### <12. Surface Emitting Element According to Example 12 of One Embodiment of Present Technology>

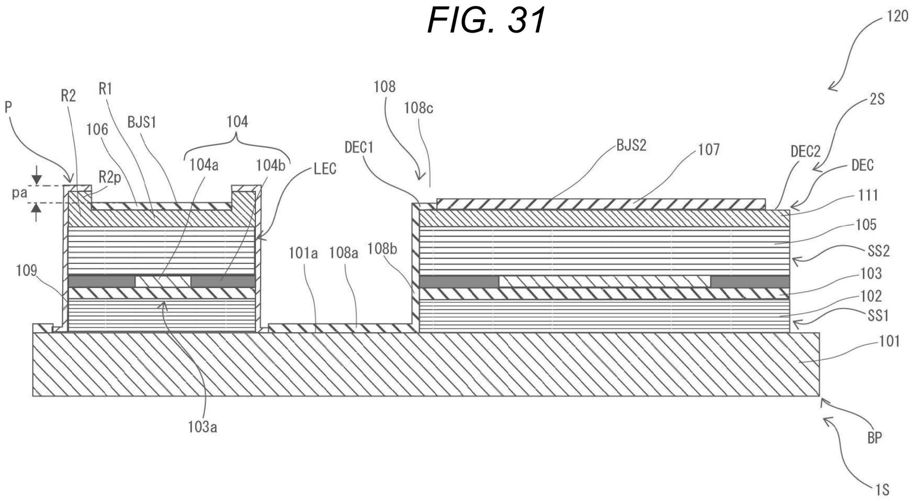

Fig. 31 is a cross-sectional view of a surface emitting element 120 according to Example 12 of one embodiment of the present technology.

As illustrated in Fig. 31, the surface emitting element 120 has a configuration similar to that of the surface emitting element 10 according to Example 1 except that the second semiconductor structure SS2 includes a solid anode electrode 106 provided on the first region R1 including the region corresponding to the light emitting region 103a on the side opposite to the side of the light emitting layer 103, the second region R2 around the first region R1 includes a protruding portion R2p protruding to the side (upper side) opposite to the side of the light emitting layer 103 with respect to the first region R1, and the convex portion P includes a portion (upper portion) of the protruding portion R2p.

The second region R2 has a circular shape (for example, a ring shape) surrounding the first region A1. In the surface emitting element 120, a contact layer 111 (for example, a p-AlGaAs layer) arranged on the second semiconductor multilayer film reflector 105 of the second semiconductor structure SS2 of the light emitting element constituent portion LEC includes the first and second regions R1, R2.

### <13. Surface Emitting Element According to Example 13 of One Embodiment of Present Technology>

### <<Configuration of Surface Emitting Element>>

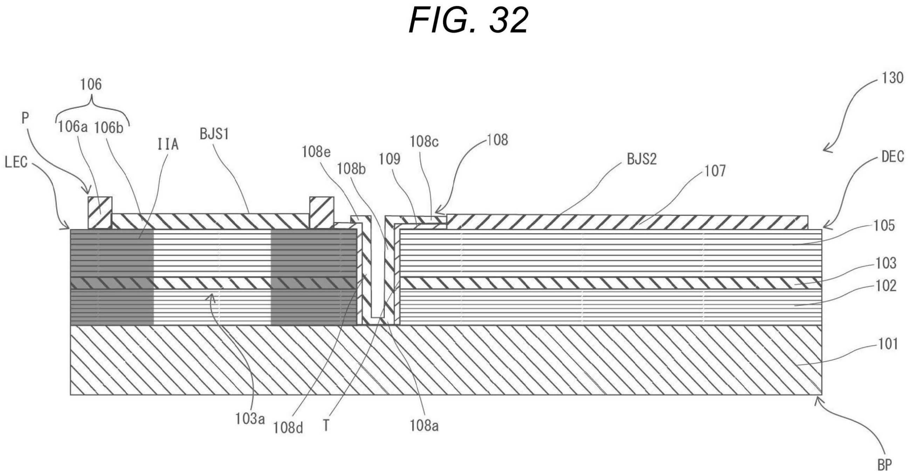

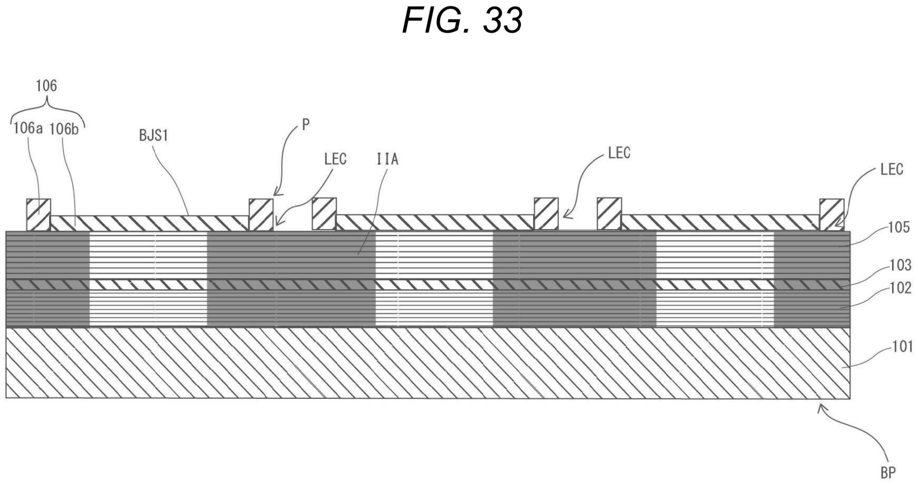

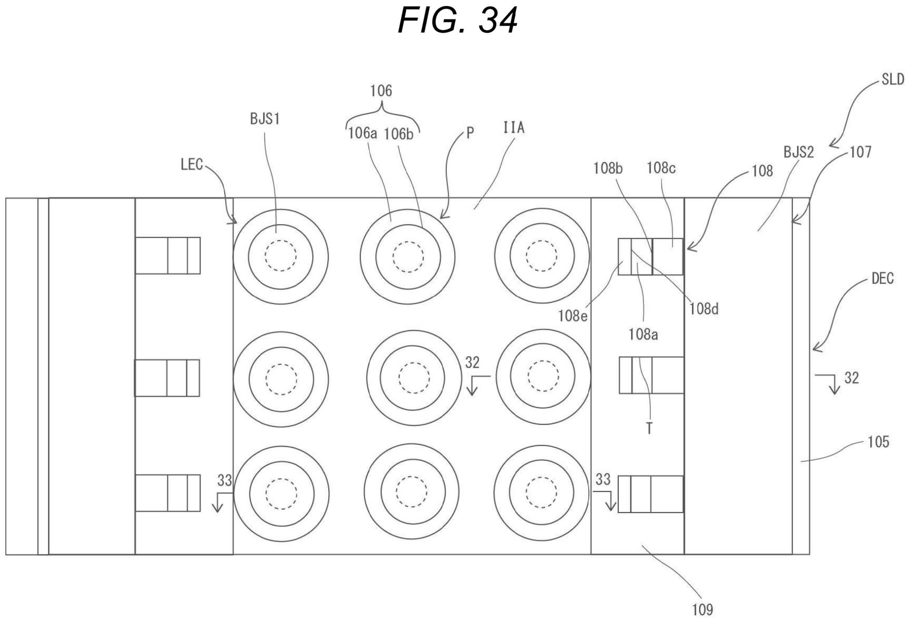

Fig. 32 is a cross-sectional view of a surface emitting element 130 according to Example 13 of one embodiment of the present technology. Fig. 33 is a cross-sectional view of a light emitting element constituent portion array of a surface emitting device SLD including the surface emitting element 130 according to Example 13 of one embodiment of the present technology. Fig. 34 is a plan view of the surface emitting device SLD including the surface emitting element 130 according to Example 13 of one embodiment of the present technology. Fig. 32 is a cross-sectional view taken along a line 32-32 in Fig. 34. Fig. 33 is a cross-sectional view taken along a line 33-33 in Fig. 34.

As illustrated in Figs. 32 to 34, the surface emitting element 130 has a configuration substantially similar to that of the surface emitting element 100 (see Fig. 29) according to Example 10 except that both the light emitting element constituent portion LEC and the dummy element constituent portion DEC do not have a mesa shape (have a mesa-less structure) and an ion implantation region IIA is provided instead of the oxidation confinement layer 104.

In the surface emitting element 130, as an example, the light emitting element constituent portion LEC includes the first semiconductor multilayer film reflector 102, the light emitting layer 103, and the second semiconductor multilayer film reflector 105. The base portion BP includes the substrate 101.

The ion implantation region IIA as a current confinement region is provided so as to surround a region immediately below the central portion of the anode electrode 106 of the light emitting element constituent portion LEC. Here, the ion implantation region IIA is provided in the entire region in a stacking direction (vertical direction) of the light emitting element constituent portion LEC. Also in the surface emitting element 110, a lateral current path is formed in the substrate 101.

Examples of the ion species to be used for the ion implantation region IIA include such as H⁺ and B⁺, for example.

A trench T is provided between the light emitting element constituent portion LEC and the dummy element constituent portion DEC. Here, a bottom surface of the trench T coincides with the upper surface of the substrate 101. One of one side surface and the other side surface facing each other of the trench T is a side surface of the light emitting element constituent portion LEC, and the other is a side surface of the dummy element constituent portion DEC. The trench means a "groove" in a narrow sense, but includes a "hole", a "concave portion", a "recess", and the like, in a broad sense.

The side surface of the trench T and a region around an opening end are covered with the insulating film 109.

The wiring 108 includes first to fifth wiring portions 108a, 108b, 108c, 108d, 108e. The first wiring portion 108a is provided on the bottom surface of the trench T. The second wiring portion 108b is provided along the insulating film 109 covering the side surface of the trench T on a side of the dummy element constituent portion DEC. The third wiring portion 108c is provided on the insulating film 109 covering the upper surface of the proximity portion of the dummy element constituent portion DEC so as to be in contact with the cathode electrode 107. The fourth wiring portion 108d is provided along the insulating film 109 covering the side surface of the trench T on a side of the light emitting element constituent portion LEC. The fifth wiring portion 108e is provided on the insulating film 109 covering the upper surface of the light emitting element constituent portion LEC. The wiring 108 configured as described above ensures favorable conductivity between the substrate 101 and the cathode electrode 107.

### <<Method for Manufacturing Surface Emitting Device Including Surface Emitting Element>>

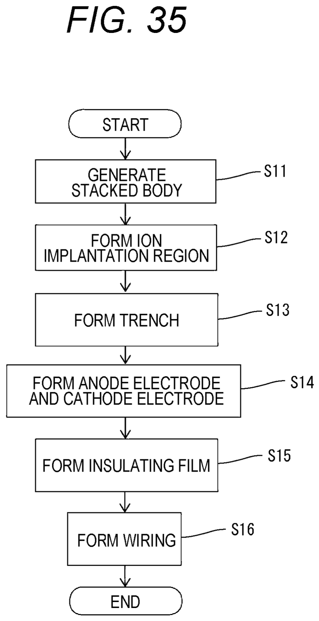

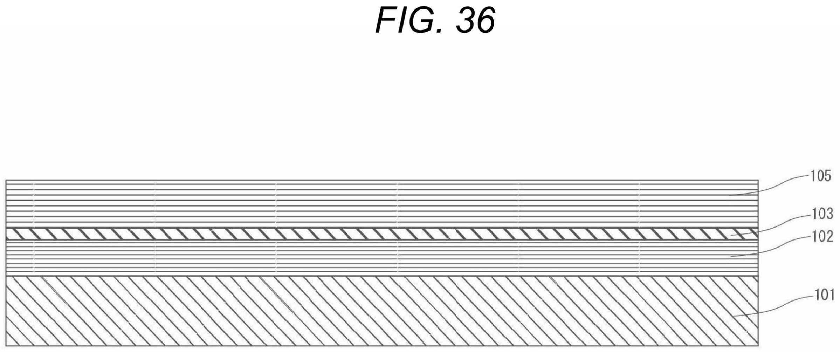

Hereinafter, an example of a method for manufacturing the surface emitting device SLD including the surface emitting element 130 will be described with reference to the flowchart of Fig. 35 and cross-sectional views (Figs. 36 to 42) corresponding to Fig. 32 for each manufacturing process of the surface emitting element 110. As overall flow, first, a plurality of surface emitting devices SLD each including the surface emitting element 130 is simultaneously generated on one wafer (hereinafter, referred to as the "substrate 101" for convenience) which is a base material of the substrate 101 by a semiconductor manufacturing method using a semiconductor manufacturing device. Next, the plurality of continuous integrated surface emitting devices SLD is separated from each other by dicing to obtain a chip-shaped surface emitting device SLD.

In the first step S11, a stacked body is generated (see Fig. 36). Specifically, for example, the first semiconductor multilayer film reflector 102, the light emitting layer 103, and the second semiconductor multilayer film reflector 105 are stacked in this order on the substrate 101 as a growth substrate by an epitaxial crystal growth method such as a metal organic chemical vapor deposition (MOCVD) method to generate a stacked body. In this event, as raw materials of the compound semiconductor, for example, a methyl-based organometallic gas such as trimethylaluminum (TMAl), trimethylgallium (TMGa), or trimethylindium (TMIn) and an arsine (AsH₃) gas are used, as raw materials of donor impurities, for example, disilane (Si₂H₆) is used, and as raw materials of acceptor impurities, for example, carbon tetrabromide (CBr₄) is used.

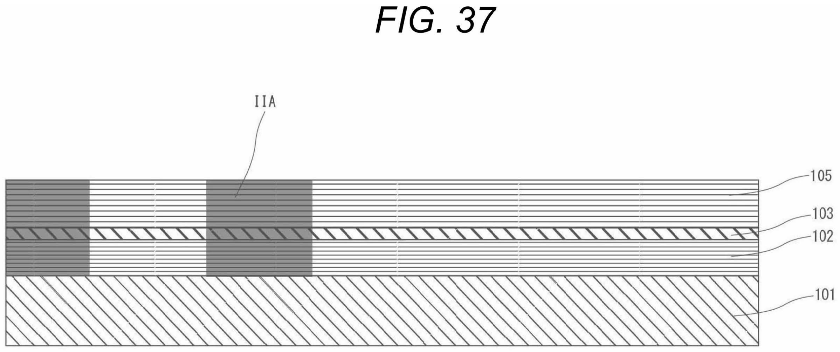

Next, in step S12, the ion implantation region IIA is formed (see Fig. 37). Specifically, a resist pattern covering a portion other than a portion where the ion implantation region IIA is to be formed on the upper surface (upper surface of the second semiconductor multilayer film reflector 105) of the stacked body is formed, and ion implantation is performed using the resist pattern as a mask. The implantation depth of the ions at this time is set to a level until the ions reach the upper surface of the substrate 101.

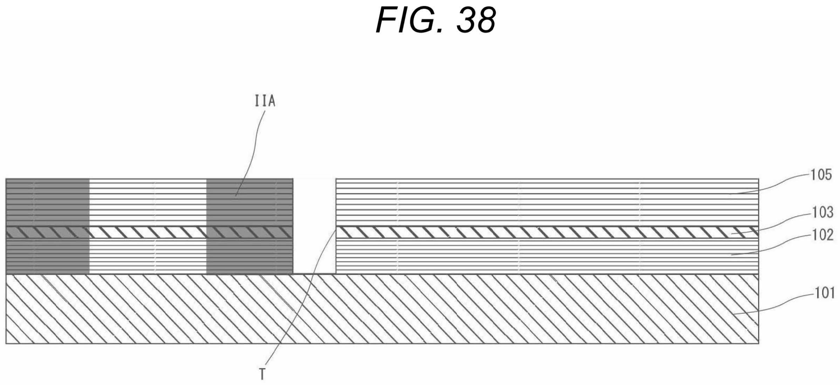

In the next step S13, the trench T is formed (see Fig. 38). Specifically, a resist pattern covering a portion other than a portion where the trench T is to be formed on the upper surface (upper surface of the second semiconductor multilayer film reflector 105) of the stacked body is formed, and the stacked body is etched by dry etching or wet etching using the resist pattern as a mask. The etching depth at this time is set to a level until the etching bottom surface reaches the upper surface of the substrate 101.

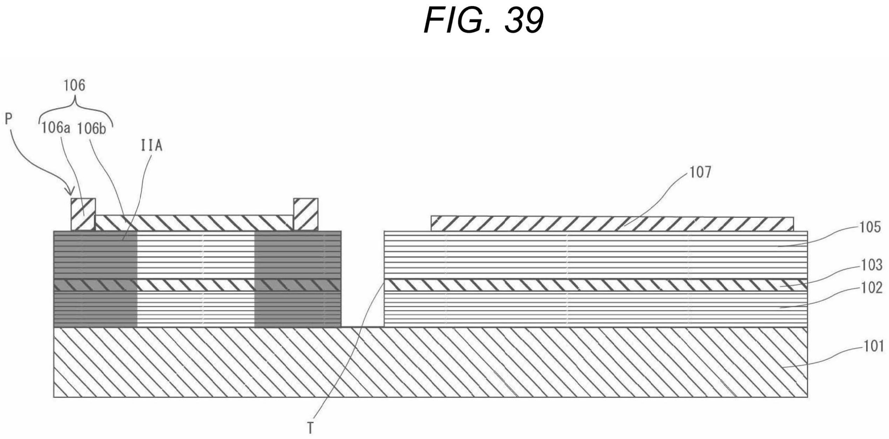

In the next step S14, the anode electrode 106 and the cathode electrode 107 are formed (see Fig. 39). Specifically, for example, by a lift-off method, the first electrode 106a of the anode electrode 106 is formed in a ring shape on the light emitting element constituent portion, the second electrode 106b is formed in a solid shape, and the cathode electrode 107 is formed in a solid shape on the dummy element constituent portion. In this event, for example, vapor deposition, sputtering, or the like, is used for forming an electrode material.

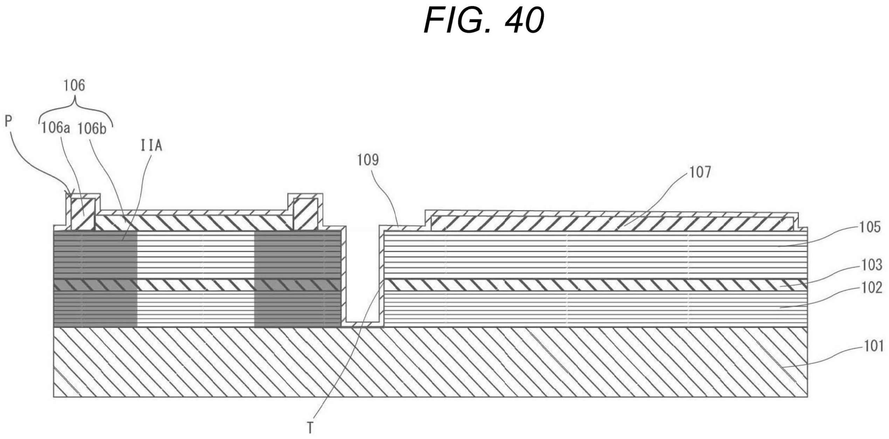

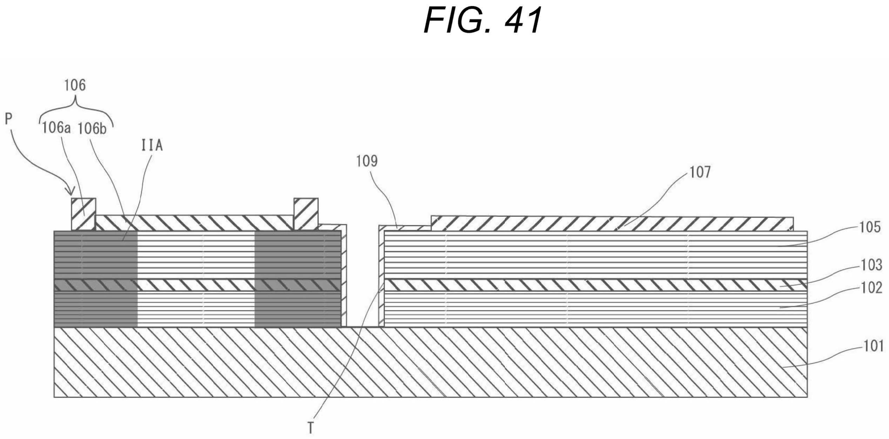

In the next step S15, the insulating film 109 is formed. Specifically, first, the insulating film 109 is formed on the entire surface (see Fig. 40). Next, the insulating film 109 other than the insulating film 109 covering the side surface of the trench T and the region around the opening end is removed by photolithography and etching to expose the anode electrode 106, the cathode electrode 107, and the bottom surface of the trench T (upper surface of the substrate 101) (see Fig. 41).

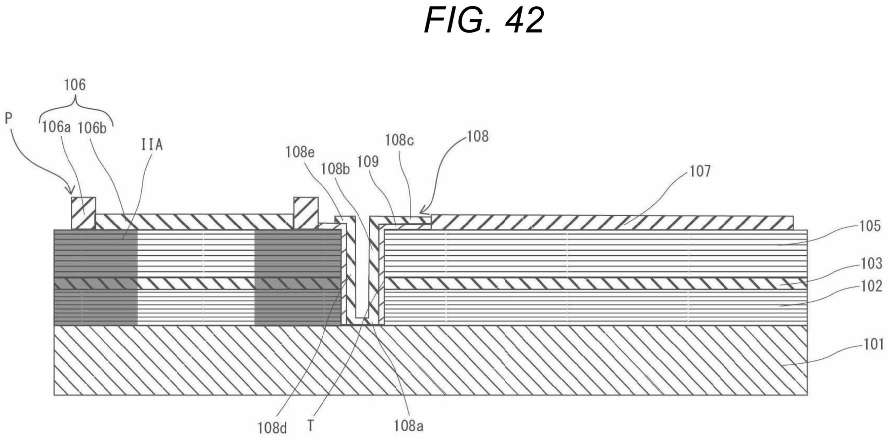

In the last step S16, the wiring 108 is formed (see Fig. 42). Specifically, for example, by a lift-off method, the first wiring portion 108a covers the upper surface of the substrate 101, the second wiring portion 108b is formed along the insulating film 109 covering the side surface of the proximity portion of the dummy element constituent portion DEC on the side of the light emitting element constituent portion LEC, the third wiring portion 108c is in contact with the cathode electrode 107 on the insulating film 109 covering the upper surface of the proximity portion, the fourth wiring portion 108d is formed along the insulating film 109 covering the side surface of the light emitting element constituent portion LEC on the side of the dummy element constituent portion DEC, and the fifth wiring portion 108e is located on the insulating film 109 covering the upper surface of the light emitting element constituent portion LEC. In this event, for example, vapor deposition, sputtering, or the like, is used for forming an electrode material.

### <14. Surface Emitting Element According to Example 14 of One Embodiment of Present Technology>

### <<Configuration of Surface Emitting Element>>

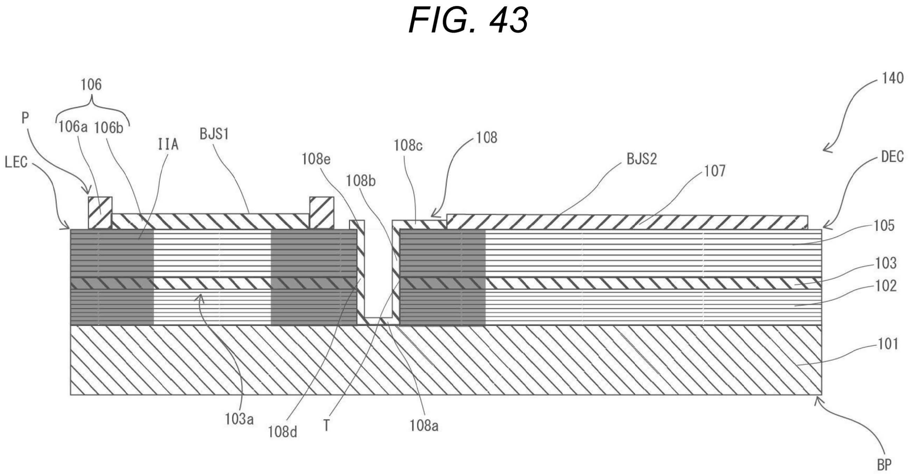

Fig. 43 is a cross-sectional view of a surface emitting element 140 according to Example 14 of one embodiment of the present technology.

The surface emitting element 140 has a configuration similar to that of the surface emitting element 130 according to Example 13 except that the ion implantation region IIA is also provided so as to surround the trench T, and the wiring 108 is also directly provided on the side surface of the trench T and the region around the opening end.

In the surface emitting element 140, the insulating film 109 is not provided, and the region around the side surface and the opening end of the trench T is insulated from the wiring 108 by the ion implantation region IIA.

According to the surface emitting element 140, effects similar to those of the surface emitting element 130 according to Example 13 are obtained, and the insulating film 109 is unnecessary, so that the configuration can be simplified and the manufacturing process can be simplified.

### <15. Surface Emitting Element According to Example 15 of One Embodiment of Present Technology>

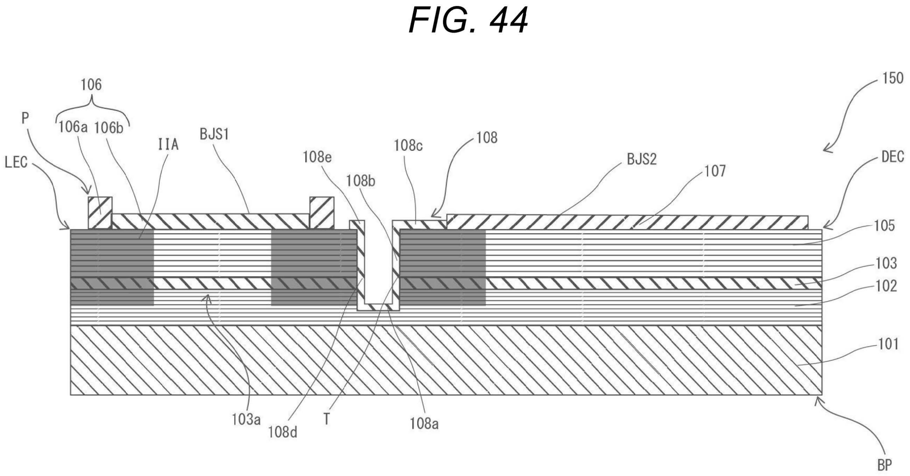

Fig. 44 is a cross-sectional view of a surface emitting element 150 according to Example 15 of one embodiment of the present technology.

The surface emitting element 150 has a configuration similar to that of the surface emitting element 140 according to Example 14 except that the bottom surface of the trench T is located in the first semiconductor multilayer film reflector 102.

In the surface emitting element 150, the ion implantation region IIA is not provided below the first semiconductor multilayer film reflector 102, and a lateral current path is formed below the first semiconductor multilayer film reflector 102. In the surface emitting element 150, a semi-insulating substrate (for example, an i-GaAs substrate) can also be used as the substrate 101.

According to the surface emitting element 150, effects similar to those of the surface emitting element 140 can be obtained, series resistance can be reduced, and low power consumption can be achieved.

### <16. Modifications of Present Technology>

The present technology is not limited to the above examples of one embodiment, and can be appropriately changed.

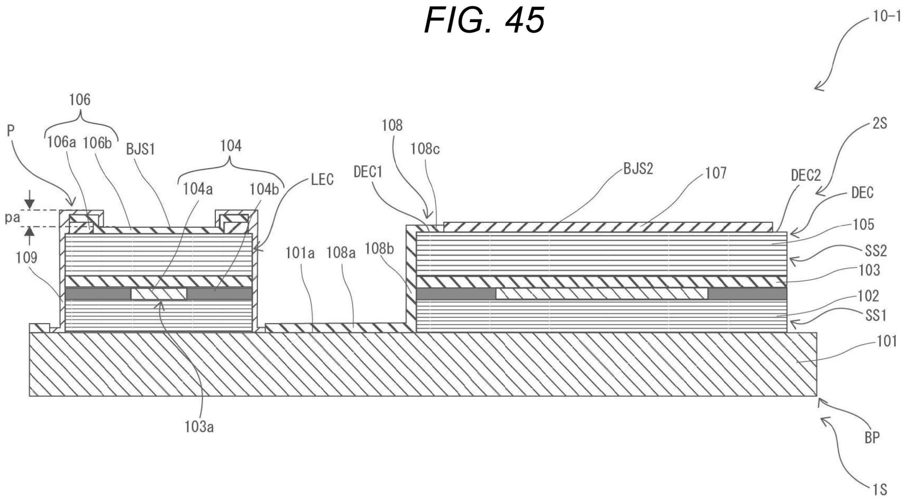

For example, as in a surface emitting element 10-1 according to Modification 1 of Example 1 of one embodiment illustrated in Fig. 45, a positional relationship between the light emitting layer 103 and the oxidation confinement layer 104 may be reverse to that in the surface emitting element 10 according to Example 1 (the oxidation confinement layer 104 is arranged on the side of the substrate 101 of the light emitting layer 103).

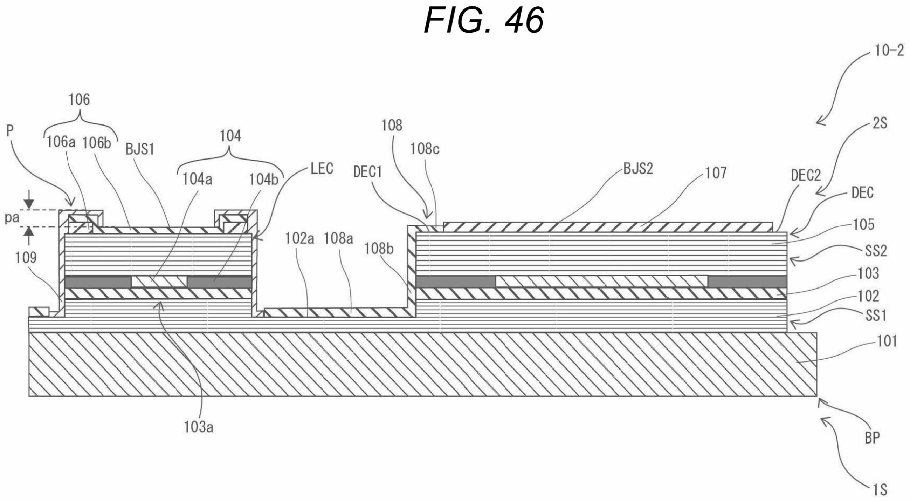

For example, as in a surface emitting element 10-2 according to Modification 2 of Example 1 of one embodiment illustrated in Fig. 46, the base portion BP may include the substrate 101 and a portion (lower portion) of the first semiconductor multilayer film reflector 102. In the surface emitting element 10-2, each of the light emitting element constituent portion LEC and the dummy element constituent portion DEC includes the other portion (upper portion) of the first semiconductor multilayer film reflector 102, the oxidation confinement layer 104, the light emitting layer 103, and the second semiconductor multilayer film reflector 105. In the surface emitting element 10-2, a portion of the wiring 108 is provided on the first semiconductor multilayer film reflector 102, and a current path is formed below the first semiconductor multilayer film reflector 102. Thus, a semi-insulating substrate (for example, an i-GaAs substrate) can also be used as the substrate 101.

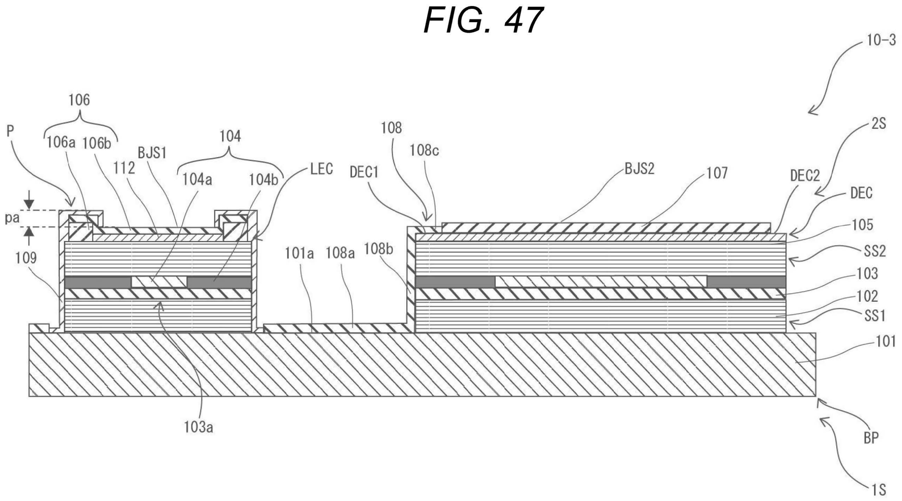

For example, as in a surface emitting element 10-3 according to Modification 3 of Example 1 of one embodiment illustrated in Fig. 47, the second structure 2S may further include a dielectric layer 112 arranged between the second semiconductor structure SS2 and a bump joint portion which is a portion including the first bump joint surface BJS1 of the anode electrode 106. As an example, the dielectric layer 112 constitutes a dielectric mirror and has a function of adjusting a reflectance on the side of the second semiconductor multilayer film reflector 105.

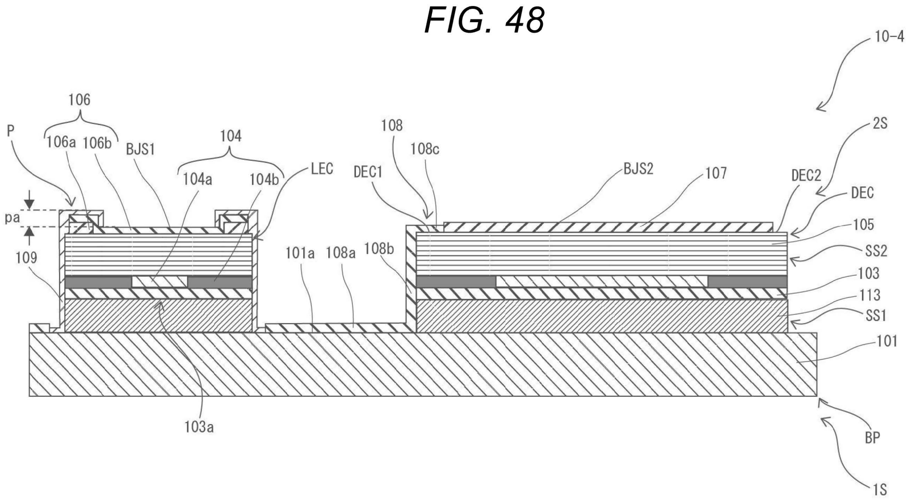

For example, as in a surface emitting element 10-4 according to Modification 4 of Example 1 of one embodiment illustrated in Fig. 48, a cladding layer 113 (for example, an n-AlGaAs layer) may be provided instead of the first semiconductor multilayer film reflector 102 to constitute a backside emission type high-output light emitting diode (LED).

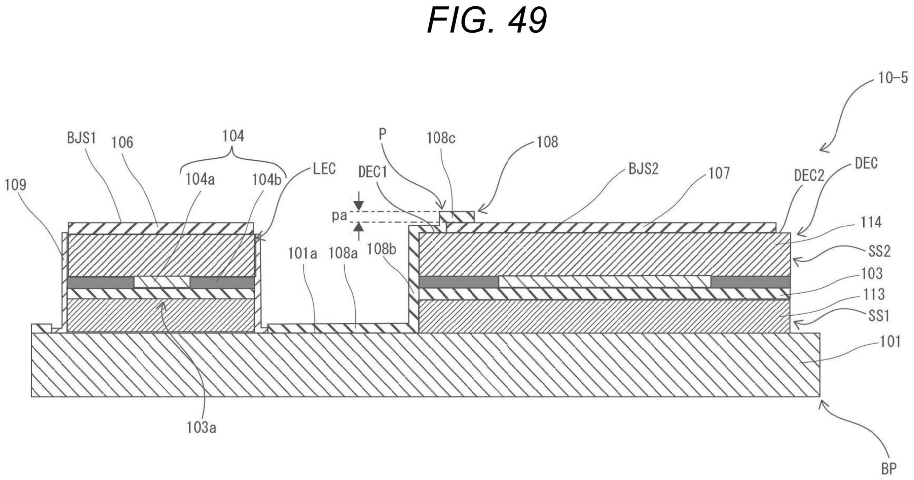

For example, as in a surface emitting element 10-5 according to Modification 5 of Example 1 of one embodiment illustrated in Fig. 49, a cladding layer 113 (for example, an n-AlGaAs layer) may be provided instead of the first semiconductor multilayer film reflector 102 and a cladding layer 114 (for example, a p-AlGaAs layer) may be provided instead of the second semiconductor multilayer film reflector 105 to constitute a backside emission type light emitting diode (LED).

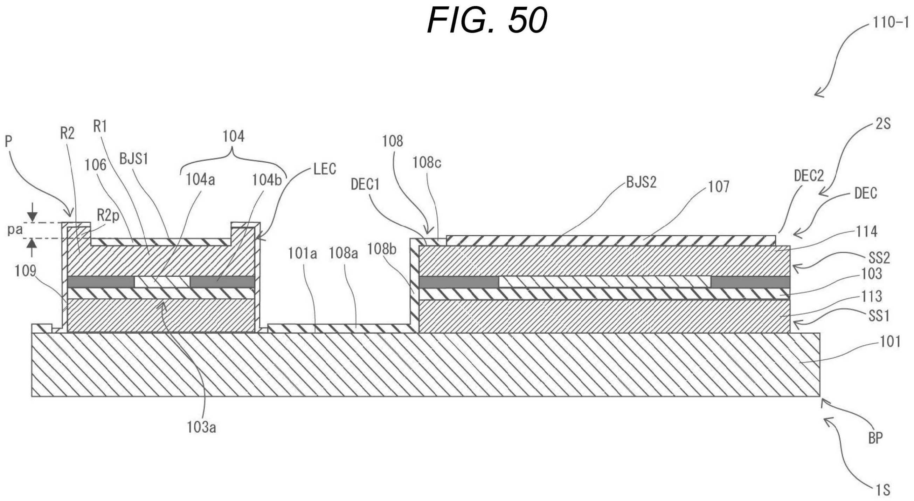

For example, as in a surface emitting element 110-1 according to Modification 1 of Example 11 of one embodiment illustrated in Fig. 50, the cladding layer 114 as the second semiconductor structure SS2 may be provided with the anode electrode 106 on the first region R1 including the region corresponding to the light emitting region 103a on the side opposite to the side of the light emitting layer 103, the second region R2 around the first region R1 may include the protruding portion R2p protruding to the side opposite to the side of the light emitting layer 103 more than the first region R1, and the convex portion P may include a portion (upper portion) of the protruding portion R2p.

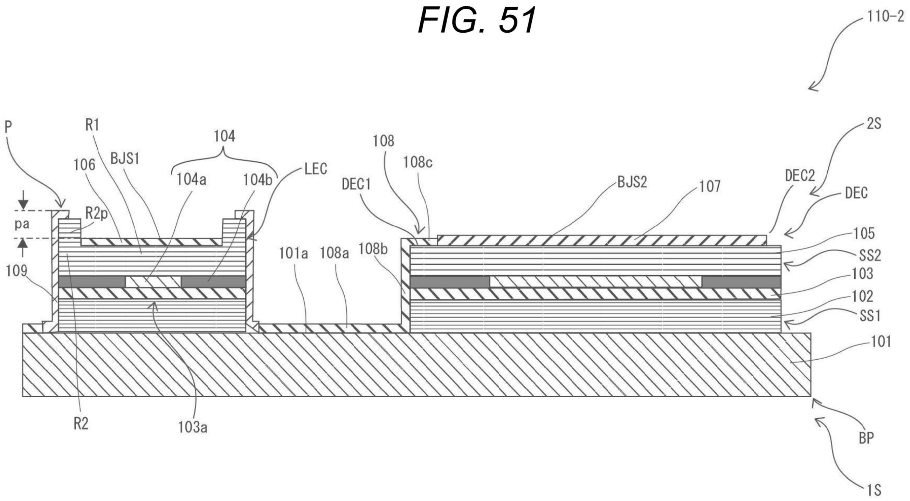

For example, as in a surface emitting element 110-2 according to Modification 2 of Example 11 of one embodiment illustrated in Fig. 51, the insulating film 109 may cover only the outer peripheral portion of the protruding portion R2p of the second region R2 to form a step portion with the protruding portion R2p and the insulating film 109, thereby constituting the two-stepped convex portion P having a circular shape.

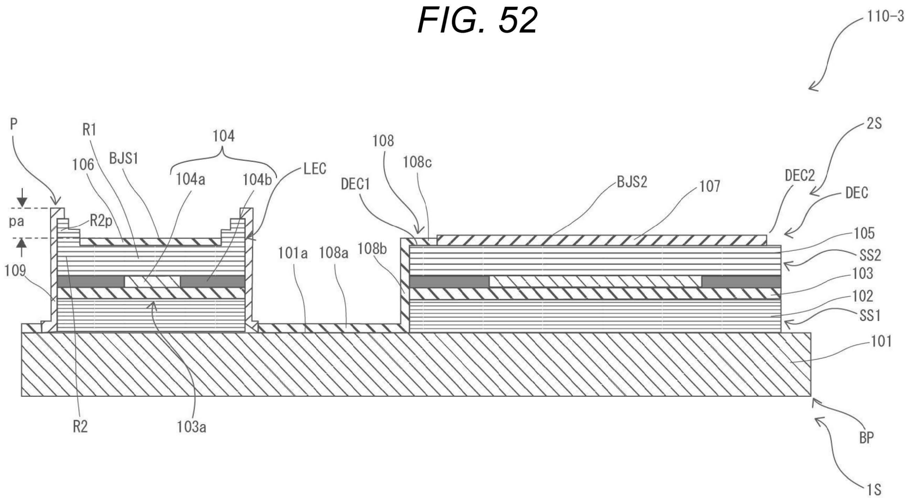

For example, as in a surface emitting element 110-3 according to Modification 3 of Example 11 of one embodiment illustrated in Fig. 52, the stepped portion having a circular shape may be formed on the inner peripheral side of the protruding portion R2p of the second region R2, and only the outer peripheral portion of the upper stage of the stepped portion may be covered with the insulating film 109 to constitute a three-stepped convex portion P having a circular shape.

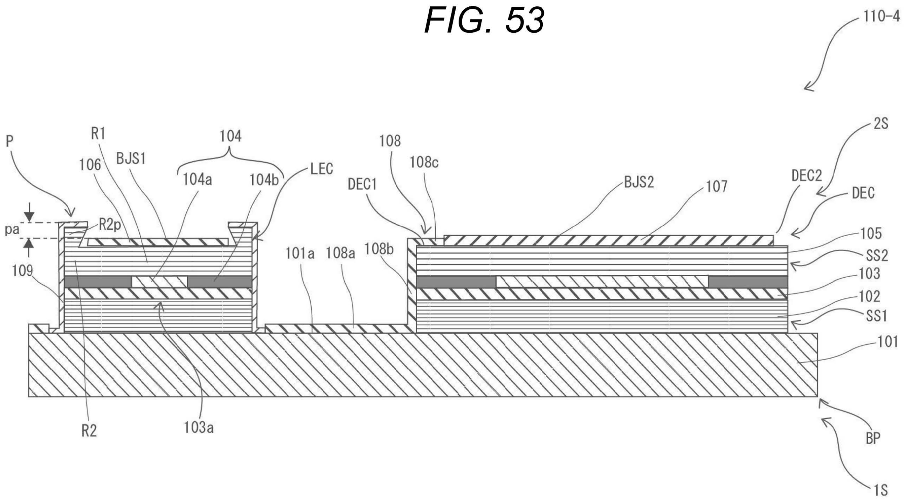

For example, as in a surface emitting element 110-4 according to Modification 4 of Example 11 of one embodiment illustrated in Fig. 53, the protruding portion R2p of the second region R2 may be formed in a reverse tapered shape (overhanging shape).

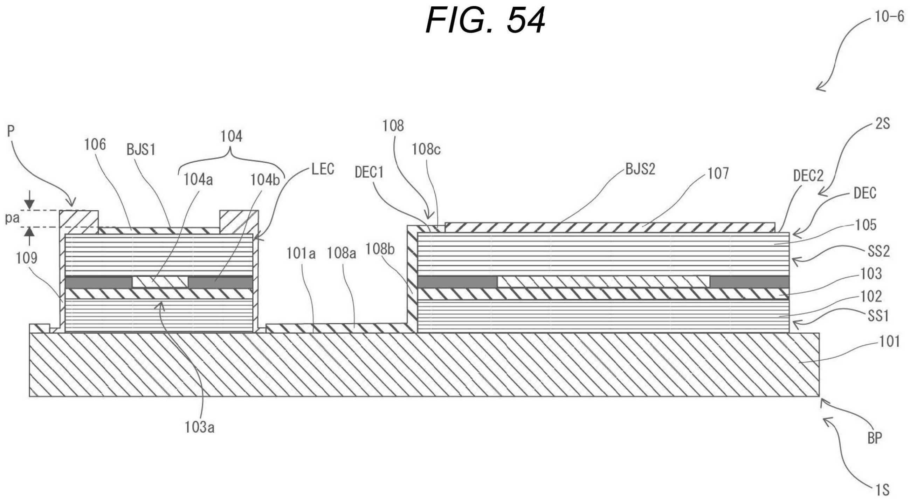

For example, as in a surface emitting element 10-6 according to Modification 6 of Example 1 of one embodiment illustrated in Fig. 54, the convex portion P may include only at least a portion (for example, a portion) of the insulating film 109.

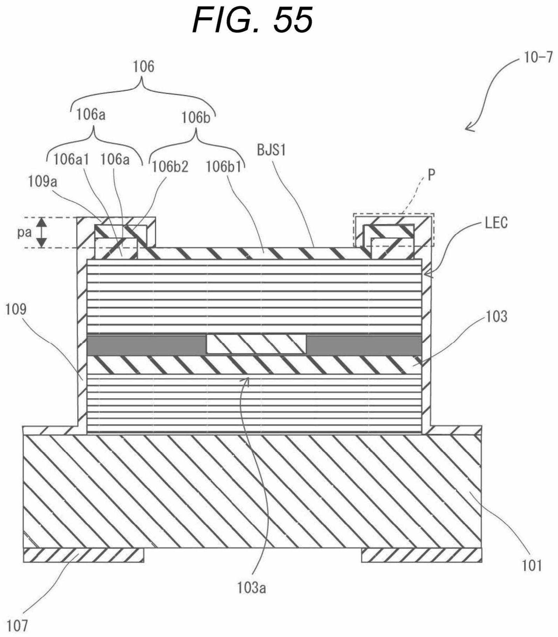

For example, as in a surface emitting element 10-7 according to Modification 7 of Example 1 of one embodiment illustrated in Fig. 55, the cathode electrode 107 surrounding a light emitting region in plan view may be provided on the back surface (lower surface) of the substrate 101. In this case, the dummy element constituent portion DEC is not essential.

### (Modification 8 of Example 1 of One Embodiment of Present Technology)

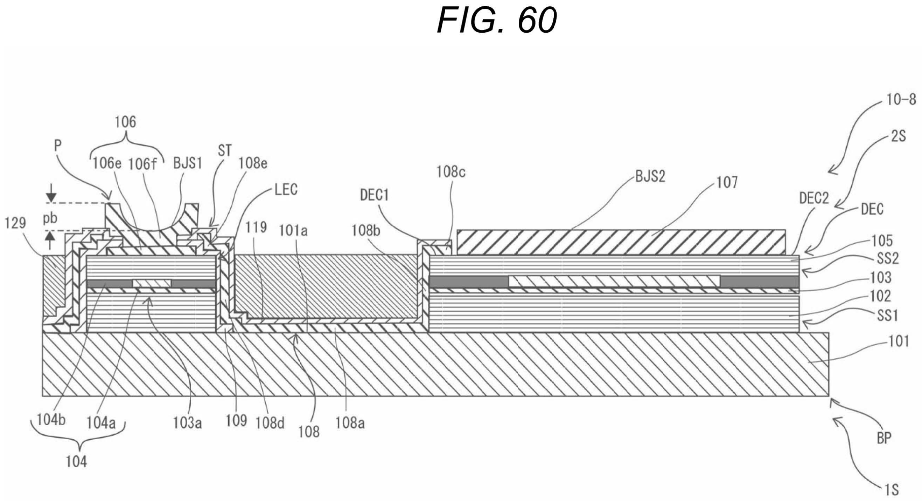

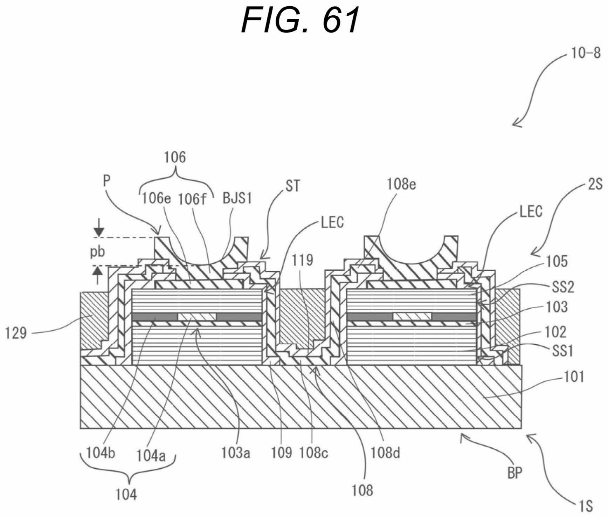

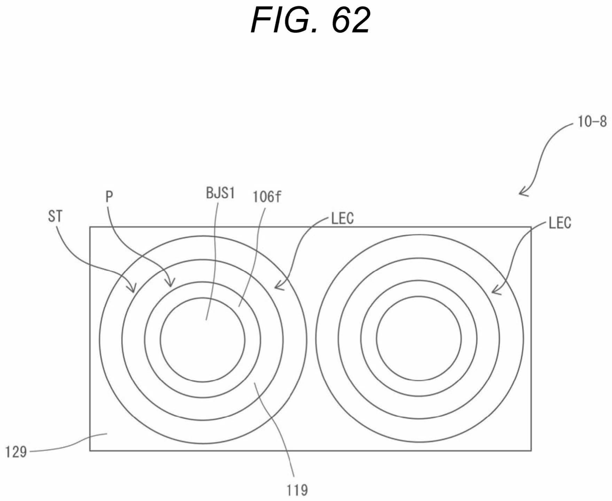

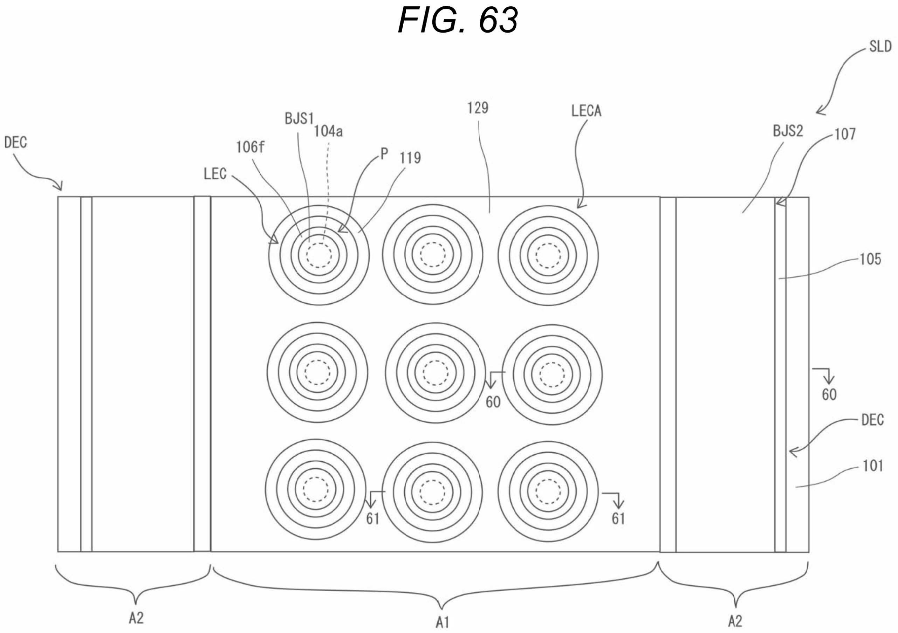

Fig. 60 is a cross-sectional view of a surface emitting element 10-8 according to Modification 8 of Example 1 of one embodiment of the present technology. Fig. 61 is a partial cross-sectional view of a light emitting element constituent portion array of a surface emitting device SLD including the surface emitting element 10-8 according to Modification 8 of Example 1 of one embodiment of the present technology. Fig. 62 is a partial plan view of the light emitting element constituent portion array of the surface emitting device SLD including the surface emitting element 10-8 according to Modification 8 of Example 1 of one embodiment of the present technology. Fig. 62 is a plan view corresponding to Fig. 61. Fig. 63 is a plan view of the surface emitting device SLD including the surface emitting element 10-8 according to Modification 8 of Example 1 of one embodiment of the present technology. Fig. 60 is a cross-sectional view taken along a line 60-60 in Fig. 63. Fig. 61 is a cross-sectional view taken along a line 61-61 in Fig. 63.

In the surface emitting element 10-8 according to Modification 8 of Example 1, as illustrated in Figs. 60 to 63, the convex portion P protrudes to the side opposite to the side of the light emitting layer 103 from a portion (for example, the central portion) of the first bump joint surface BJS1. More specifically, the convex portion P provided on the peripheral portion of the second structure 2S of the light emitting element constituent portion LEC is a portion of the anode electrode 106, and protrudes to the side opposite to the side of the light emitting layer 103 more than the other portion of the anode electrode 106. The anode electrode 106 includes a solid first electrode 106e and a second electrode 106f provided on the first electrode 106e and including a first bump joint surface BJS1. Hereinafter, the first electrode 106e is also referred to as a "solid electrode". The second electrode 106f is an electrode (bonding electrode) to be bonded to the other substrate 200 (mounting substrate) via the first bump BP1. The first electrode 106e includes, for example, Au/Pt/Ti, or the like. The second electrode 106f includes, for example, metal plating such as Au plating, Ag plating, or Cu plating. In the surface emitting device SLD including the surface emitting element 10-8, a portion between the light emitting element constituent portions LEC and a portion between the light emitting element constituent portion LEC and the dummy element constituent portion DEC are filled with an underfill 129 (resin), and connection reliability is improved.

In the surface emitting element 10-8, the first bump joint surface BJS1 of the second electrode 106f is a curved surface to be bonded to the other substrate 200 via the first bump BP1. The first bump joint surface BJS1 has a concave surface shape. Thus, hereinafter, the second electrode 106f will be also referred to as a "concave electrode". The central portion of the first bump joint surface BJS1 overlaps at least the light emitting region 103a in plan view. The convex portion P including the peripheral portion of the first bump joint surface BJS1 does not overlap the light emitting region 103a in plan view. More specifically, the convex portion P is provided so as to correspond to at least a portion (for example, all) of the outer periphery of the light emitting region 103a in plan view. More specifically, the convex portion P is a convex portion in a circular shape (circular convex portion) surrounding the light emitting region 103a in plan view. The upper surface of the convex portion P is a contact surface that comes into contact with the other substrate 200 at the time of bump bonding. Here, the center position (lowest position) of the first bump joint surface BJS1 and the second bump joint surface BJS2 are on the same plane.

The protruding amount pb (see Figs. 60 and 61) of the convex portion P is preferably 1/3 or more, more preferably 1/2 or more, still more preferably 2/3 or more, and still more preferably 3/4 or more of the thickness of the portion (here, the central portion) corresponding to the light emitting region 103a of the anode electrode 106. The protruding amount pb of the convex portion P is preferably 0.5 µm to 5.0 µm. The convex portion P includes a plurality of portions facing each other in the in-plane direction.

The wiring 108 is provided across the first and second semiconductor structures SS1, SS2. In other words, the wiring 108 extends along the light emitting mesa from the vicinity of the mesa bottom (mesa bottom portion) to the mesa top (mesa top portion) of the light emitting element constituent portion LEC (light emitting mesa). This is because, in the surface emitting element 10-8, an interval between the mesas of the light emitting element constituent portion LEC is narrow (for example, 10 µm), and it is difficult to perform lift-off at the mesa bottom, and thus, the wiring 108 can be relatively easily formed by performing lift-off by patterning at the mesa top. The wiring 108 includes, for example, Au/Ni/AuGe, and the like. Here, "the wiring 108 is provided across the first and second semiconductor structures SS1, SS2" includes not only a case where the wiring 108 physically and integrally straddles the first and second semiconductor structures SS1, SS2, but also a case where the wiring 108 includes a plurality of physically separated wiring portions, and one wiring portion is provided in the first semiconductor structure SS1 and the other wiring portions are provided in the second semiconductor structure SS2.

In the surface emitting element 10-8, the insulating film 109 (for example, a SiN film) extends along the light emitting mesa from the vicinity of the mesa bottom to above the peripheral portion of the first electrode 106e. The wiring 108 is provided on the insulating film 109. The wiring 108 includes a first wiring portion 108a, a second wiring portion 108b, a third wiring portion 108c, a fourth wiring portion 108d, and a fifth wiring portion 108e. The first wiring portion 108a is provided in contact with the substrate 101 near the mesa bottoms of the light emitting mesa and the dummy mesa. The second wiring portion 108b is provided on the mesa side (mesa side surface) of the dummy mesa. The third wiring portion 108c is provided on the mesa top of the dummy mesa. The fourth wiring portion 108d is provided on the mesa side (mesa side surface) of the light emitting mesa via the insulating film 109. The fifth wiring portion 108e is provided on the mesa top of the light emitting mesa via the insulating film 109. An insulating film 119 (for example, a SiN film) is provided on the wiring 108. The insulating film 119 covers the first wiring portion 108a near the mesa bottoms of the light emitting mesa and the dummy mesa, covers the second wiring portion 108b at the mesa side of the dummy mesa, covers the third wiring portion 108c at the mesa top of the dummy mesa, covers the fourth wiring portion 108d at the mesa side of the light emitting mesa, and covers the fifth wiring portion 108e at the mesa top of the light emitting mesa. Hereinafter, the insulating film 109 is also referred to as a "first insulating film 109", and the insulating film 119 is also referred to as a "second insulating film 119". A thickness of the first insulating film 109 is preferably 50 nm or more and 500 nm or less. A thickness of the wiring 108 is preferably 100 nm or more and 1000 nm or less. A thickness of the second insulating film 119 is preferably 50 nm or more and 500 nm or less.

In other words, the wiring 108 has front and back surfaces covered with an insulating film. A high step portion ST in a circular shape (circular step portion) is formed on the peripheral portion of the second structure 2S (specifically, on the peripheral portion of the first electrode 106e) by the overlapping portion (stacked structure) of the first insulating film 109, the wiring 108, and the second insulating film 119 on the mesa top. The step portion ST in a circular shape implements a concave surface shape of the second electrode 106f. The convex portion P is provided on the step portion ST.

As described above, the configuration in which the three-layer structure (hereinafter, also referred to as a "DMD structure") in which the first insulating film 109, the wiring 108, and the second insulating film 119 are stacked extends from the vicinity of the mesa bottom of the light emitting mesa to the mesa top enables wiring patterning on the mesa top, and contributes to forming the step portion ST having a height by increasing the film thickness, so that a characteristic defect does not occur. Wiring patterning can be performed on the mesa top, which makes it easy to perform lift-off, and productivity is improved. In addition, the fourth wiring portion 108d and the fifth wiring portion 108e are portions that are not used for electrical connection, and thus, there is no problem even if disconnection, or the like, occurs. The DMD structure covers the light emitting mesa and includes the wiring 108 (metal wiring) including a metal in the intermediate layer, and thus, heat dissipation can be improved. Furthermore, the front and back surfaces of the wiring 108 are covered with the insulating film, and thus, the wiring 108 is hardly deformed, and protection of the wiring 108 is excellent. Here, the three-layer structure called the DMD structure has been described as an example, but the height of the step and the heat dissipation can be set to a desired height and desired heat dissipation by adopting a stacked structure of three or more layers in which an insulating film and a metal wiring are alternately stacked. In the stacked structure, a thickness of the metal wiring is preferably greater than a thickness of the insulating film.

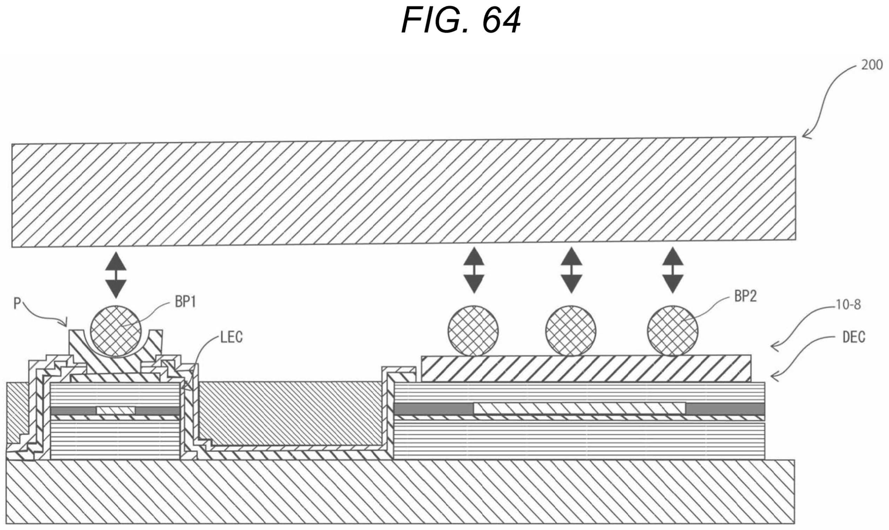

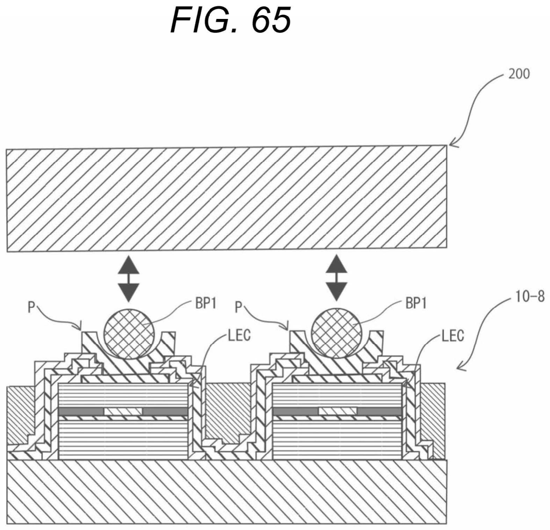

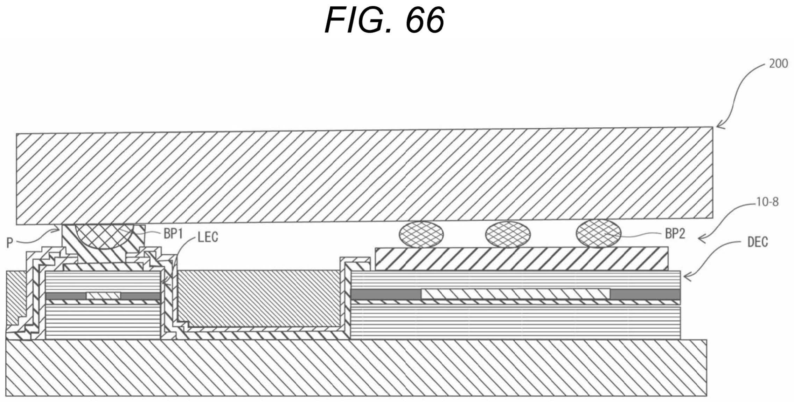

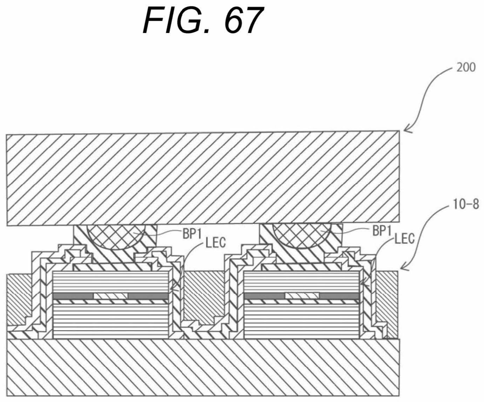

When the surface emitting element 10-8 is bump-bonded to the other substrate 200, the surface emitting element 10-8 and the other substrate 200 are aligned (see Figs. 64 and 65) and pressure-bonded (See Figs. 66 and 67). In this event, a position of the first bump BP1 is controlled so that the concave electrode of the anode electrode 106 suppresses expanding of the first bump BP1 in a lateral direction, and thus, the first bump BP1 is suppressed from protruding from the inside of the concave electrode to the outside (see Figs. 66 and 67). In addition, the first bump BP1 can be positioned at a well-balanced appropriate position with respect to the concave electrode by self-alignment at the time of bump bonding. Note that in Figs. 64 and 65, the first bump BP1 and the second bump BP2 are attached to the side of the surface emitting element 10-8 before the bump bonding, but may be attached to the side of the other substrate 200.

On the other hand, for example, when it is attempted to form the anode electrode itself in a concave surface shape, there is a concern that the metal is deformed due to a temperature (300°C to 400°C) at the time of solder jointing, and a short circuit with adjacent elements or a jointing failure with another substrate (mounting substrate) may occur (because a melting point is lowered by eutectic of Sn and Au). In addition, it is necessary to form a metal film a plurality of times, which results in increase in the number of processes.

For example, when it is attempted to form a step portion having a height only with an insulating film, it is necessary to form the insulating film thick, but when the insulating film is formed thick, there is a concern that heat dissipation may be deteriorated, which may deteriorate characteristics.

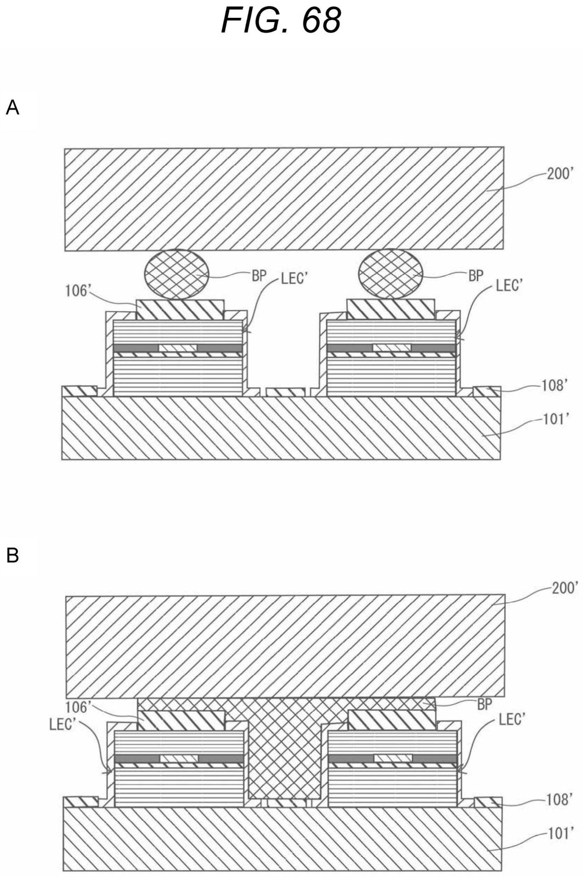

For example, in a surface emitting element of a comparative example illustrated in Fig. 68A, there is a concern that the bump BP protrudes from above the solid anode electrode 106' of the light emitting element constituent portion LEC' at the time of bump bonding with the mounting substrate 200', and a short circuit occurs between the adjacent light emitting element constituent portions LEC' (see Fig. 68B).

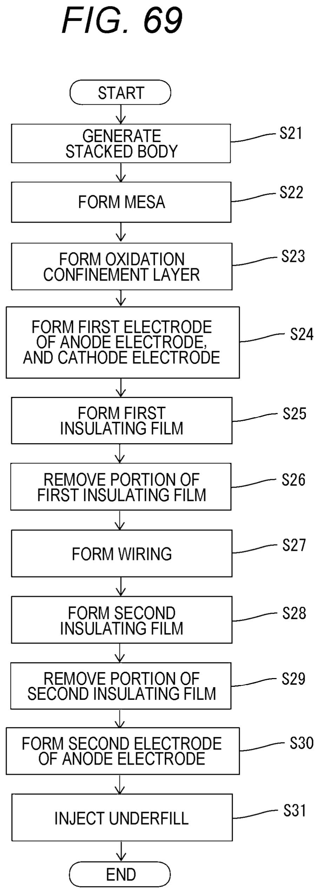

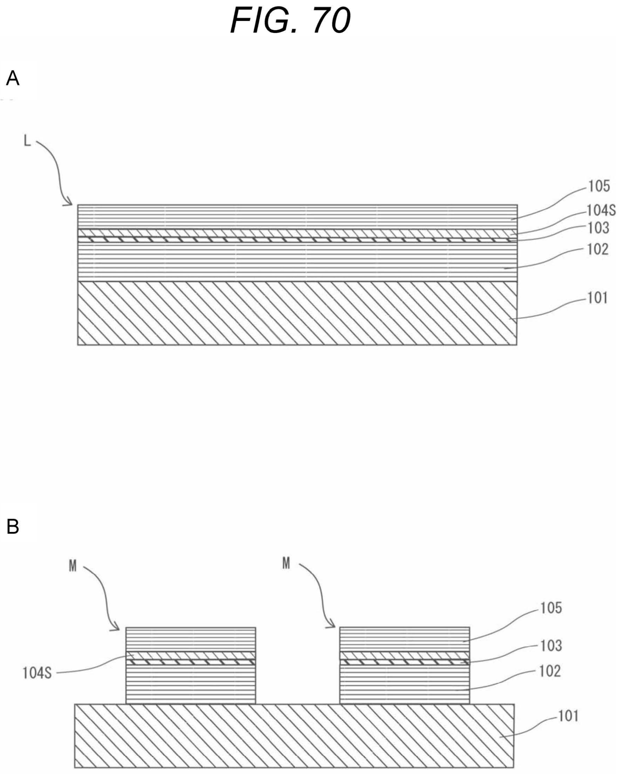

Hereinafter, an example of a method for manufacturing the surface emitting device SLD including the surface emitting element 10-8 will be described with reference to the flowchart of Fig. 69 and cross-sectional views (Figs. 70A to 75) corresponding to Fig. 61 for each manufacturing process of the surface emitting element 10-8. As overall flow, first, a plurality of surface emitting devices SLD each including the surface emitting element 10-8 is simultaneously generated on one wafer (hereinafter, referred to as the "substrate 101" for convenience) which is a base material of the substrate 101 by a semiconductor manufacturing method using a semiconductor manufacturing device. Next, the plurality of continuous integrated surface emitting devices SLD is separated from each other by dicing to obtain a chip-shaped surface emitting device SLD.

In the first step S21, a stacked body L is generated (see Fig. 70A). Specifically, for example, the first semiconductor multilayer film reflector 102, the light emitting layer 103, the oxidized layer 104S (such as, for example, an AlGaAs layer and an AlAs layer), and the second semiconductor multilayer film reflector 105 are stacked in this order on the substrate 101 as a growth substrate by an epitaxial crystal growth method such as a metal organic chemical vapor deposition (MOCVD) method to generate a stacked body L. In this event, as raw materials of the compound semiconductor, for example, a methyl-based organometallic gas such as trimethylaluminum (TMAl), trimethylgallium (TMGa), or trimethylindium (TMIn) and an arsine (AsH₃) gas are used, as raw materials of donor impurities, for example, disilane (Si₂H₆) is used, and as raw materials of acceptor impurities, for example, carbon tetrabromide (CBr₄) is used.

In the next step S22, a mesa M to be the light emitting mesa and a mesa to be the dummy mesa are formed (see Fig. 70B). Specifically, a resist pattern covering a portion where each mesa is to be formed is formed on the stacked body by photolithography, and the stacked body is etched by dry etching or wet etching using the resist pattern as a mask. The etching depth at this time is, for example, until the substrate 101 is exposed. As a result, the mesa M to be the light emitting mesa and the mesa to be the dummy mesa are formed. Thereafter, the resist pattern is removed.

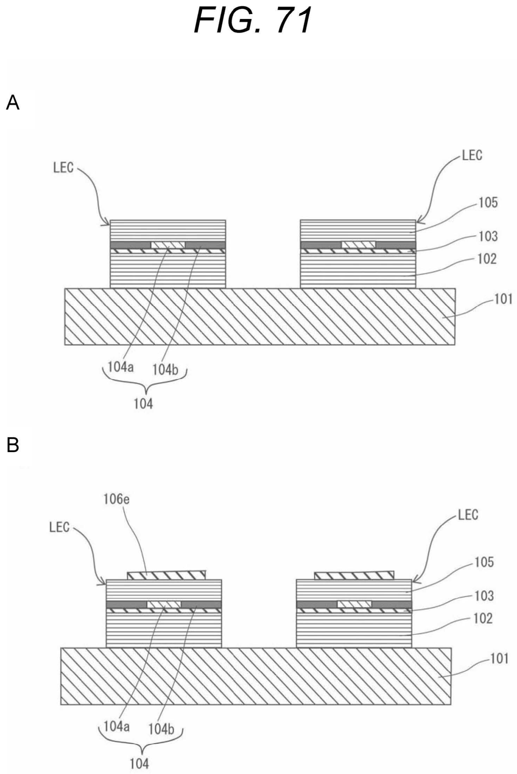

In the next step S23, the oxidation confinement layer 104 is formed (see Fig. 71A). Specifically, each mesa is exposed to a high-temperature water vapor atmosphere, and the oxidized layer 104S is selectively oxidized by a predetermined distance from the side surface. As a result, the oxidation confinement layer 104 in which the non-oxidized region 104a is surrounded by the oxidized region 104b is formed in the mesa M, and the light emitting mesa is generated. A layer in which the non-oxidized region is surrounded by the oxidized region is also formed in the mesa to be the dummy mesa, and the dummy mesa is generated.

In the next step S24, the first electrode 106e (solid electrode) of the anode electrode 106 and the cathode electrode 107 are formed (see Fig. 71B). Specifically, for example, by a lift-off method, the first electrode 106e is formed in a solid shape on the top of the light emitting mesa, and the cathode electrode 107 is formed in a solid shape on the top of the dummy mesa. In this event, for example, vapor deposition, sputtering, or the like, is used for forming an electrode material.

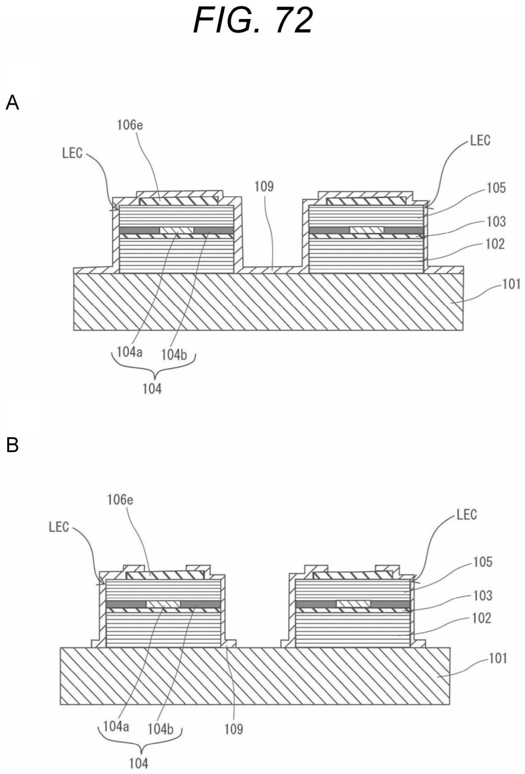

In the next step S25, the first insulating film 109 is formed (see Fig. 72A). Specifically, the first insulating film 109 is formed on the entire surface by, for example, vapor deposition, sputtering, or the like.

In the next step S26, a portion of the first insulating film 109 is removed (see Fig. 72B). Specifically, by photolithography and etching, the first insulating film 109 covering the central portion of the first electrode 106e, the first insulating film 109 covering the cathode electrode 107, the first insulating film 109 covering the dummy mesa side surface, and the first insulating film 109 covering the portion between the light emitting mesa and the dummy mesa on the upper surface 101a of the substrate 101 are removed to expose the central portion of the first electrode 106e, the second bump joint surface BJS2 of the cathode electrode 107, and a portion of the upper surface 101a of the substrate 101.

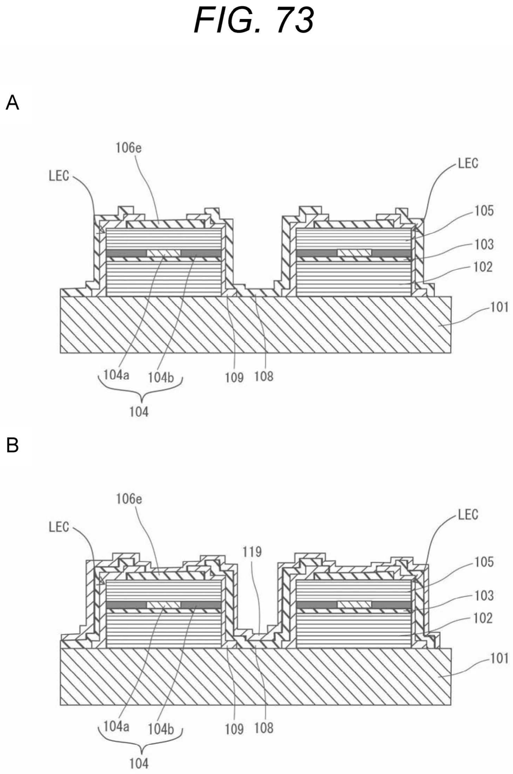

In the next step S27, the wiring 108 is formed (see Fig. 73A). Specifically, for example, by lift-off, the wiring 108 is formed such that the first wiring portion 108a covers a portion of the upper surface 101a of the substrate 101, the second wiring portion 108b covers the side surface of the dummy mesa, the third wiring portion 108c is in contact with the cathode electrode 107 on the dummy mesa, the fourth wiring portion 108d covers the first insulating film 109 on the side surface of the light emitting mesa, and the fifth wiring portion 108e covers the first insulating film 109 on the top of the light emitting mesa. In this event, for example, vapor deposition, sputtering, or the like, is used for forming a wiring material.

In the next step S28, the second insulating film 119 is formed (see Fig. 73B). Specifically, the second insulating film 119 is formed on the entire surface by, for example, vapor deposition, sputtering, or the like.

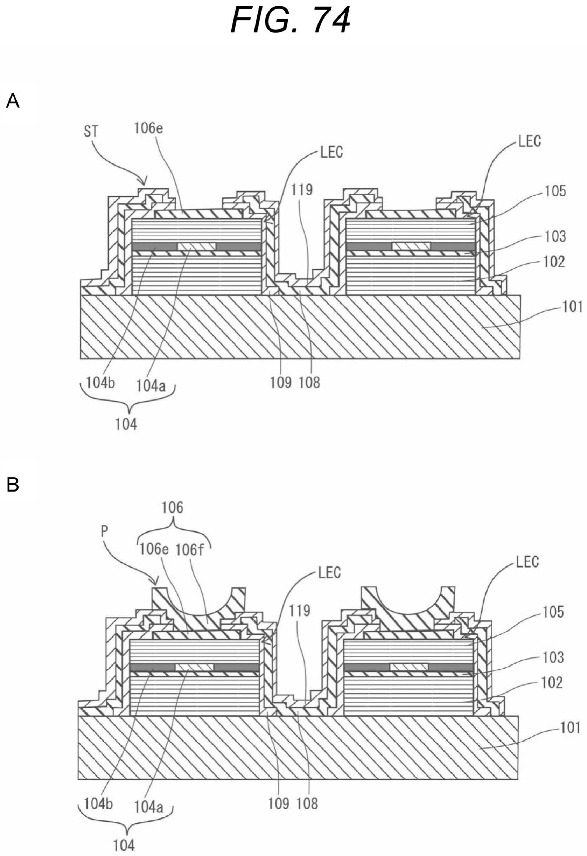

In the next step S29, a portion of the second insulating film 119 is removed (see Fig. 74A). Specifically, the second insulating film 119 covering the central portion of the first electrode 106e and the second insulating film 119 covering the cathode electrode 107 are removed by photolithography and etching to expose the central portion of the first electrode 106e and the second bump joint surface BJS2 of the cathode electrode 107. As a result, a high step portion ST in a circular shape (circular step portion) is formed on the periphery portion of the first electrode 106e.

In the next step S30, the second electrode 106f (concave electrode) of the anode electrode 106 is formed (see Fig. 74B). Specifically, the second electrode 106f is formed so as to straddle over the first electrode 106e and the step portion in a circular shape by, for example, a plating method. Before the plating method is performed, it is preferable to form a seed layer at a portion to be plated. As a result, the second electrode 106f including the convex portion P in a circular shape is formed.

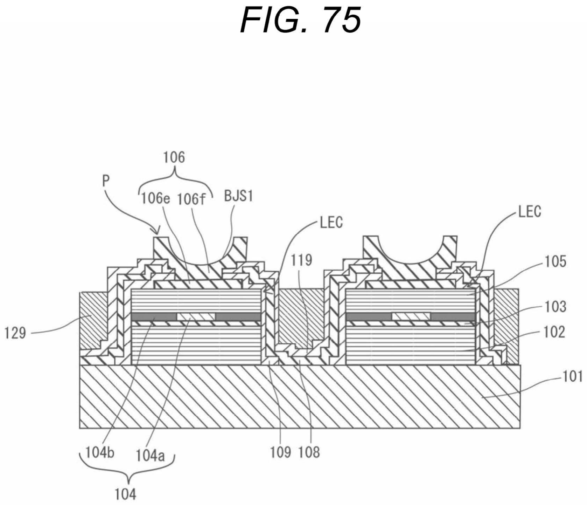

In the last step S31, an underfill is injected (see Fig. 75). Specifically, the underfill is injected between the adjacent light emitting mesas and between the adjacent light emitting mesa and the dummy mesa.

The surface emitting device SLD manufactured as described above is bonded (junction-down mounted) to the other substrate 200 via the first and second bumps BP1, BP2. In this event, when the state shifts from the state before bump bonding illustrated in Figs. 64 and 65 to the state at the time of bump bonding (pressurized state) illustrated in Figs. 66 and 67, the first bump BP1 expands in the lateral direction while being crushed. However, the expansion is restricted from all directions in the circumferential direction by the convex portion P, and thus, the first bump BP1 is self-aligned at an appropriate position without bias with respect to the bump joint portion of the concave electrode (bonding electrode) while the protrusion is suppressed.

### (Modification 9 of Example 1 of One Embodiment of Present Technology)

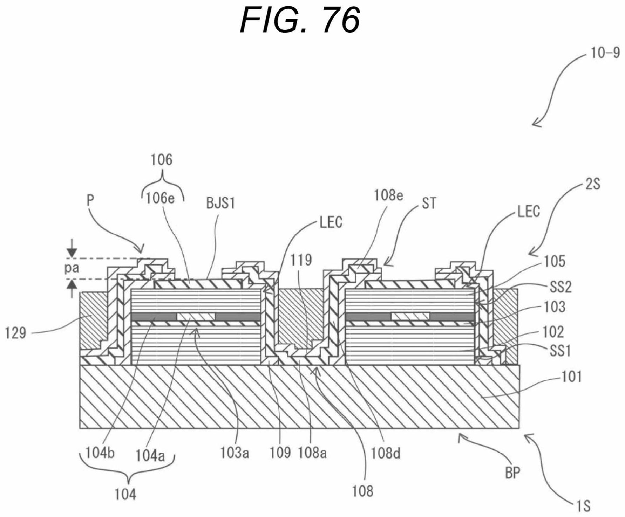

Fig. 76 is a partial cross-sectional view of a light emitting element constituent portion array of a surface emitting device including a surface emitting element 10-9 according to Modification 9 of Example 1 of one embodiment of the present technology.

As illustrated in Fig. 76, the surface emitting element 10-9 has a configuration similar to that of the surface emitting element 10-8 according to Modification 8 except that the anode electrode 106 does not include the second electrode 106f.

In the surface emitting element 10-9, the step portion ST formed on the light emitting element constituent portion LEC (light emitting mesa) by a three-layer structure (DMD structure) in which the first insulating film 109, the wiring 108, and the second insulating film 119 are stacked includes the convex portion P. The convex portion P is a stepped convex portion having a maximum protruding amount pa from the first bump joint surface BJS1.

According to the surface emitting element 10-9, the position controllability of the bump is inferior to the surface emitting element 10-8 according to Modification 8, but the second electrode 106f is not provided, and thus, the number of manufacturing processes and the cost can be reduced.

### (Modification 10 of Example 1 of One Embodiment of Present Technology)

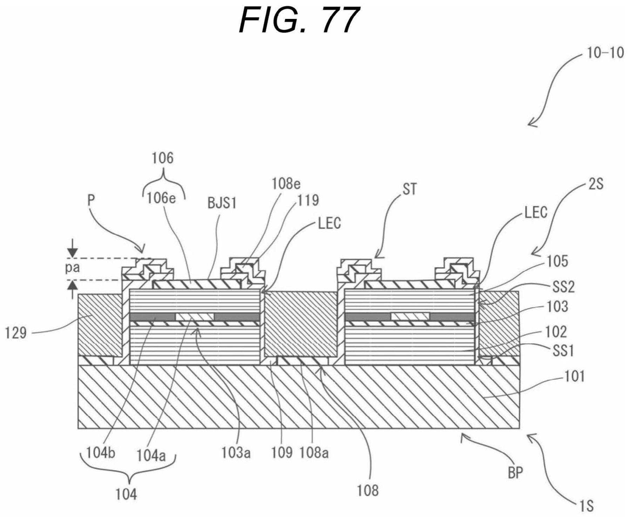

Fig. 77 is a partial cross-sectional view of a light emitting element constituent portion array of a surface emitting device including a surface emitting element 10-10 according to Modification 10 of Example 1 of one embodiment of the present technology.

As illustrated in Fig. 77, the surface emitting element 10-10 has a configuration similar to that of the surface emitting element 10-9 according to Modification 9 except that the fourth wiring portion 108d and the second insulating film 119 are not provided on the first insulating film 109 covering the side surface of the light emitting mesa.

In the surface emitting element 10-10, the fifth wiring portion 108e provided on the first insulating film 109 covering the mesa top of the light emitting mesa and the first wiring portion 108a covering the substrate 101 are physically separated. Such a first wiring portion 108a and a fifth wiring portion 108e separated from each other can be formed, for example, by performing lift-off separately, or can be formed by forming a wiring material only in the vicinity of the mesa bottom and the mesa top (a wiring material is not formed only in the mesa side) due to a narrow interval between the light emitting mesas when lift-off is performed from the vicinity of the mesa bottom to the mesa top. Note that the fourth wiring portion 108d may be formed very thin on the first insulating film 109 covering the side surface of the light emitting mesa, and the second insulating film 119 may be provided on the fourth wiring portion 108d. Further, instead of the fifth wiring portion 108e, a conductor film (such as, for example, a transparent electrode), a semiconductor film, an insulating film, or the like, different from the wiring 108 may be provided.

According to the surface emitting element 10-10, effects similar to those of the surface emitting element 10-9 according to Modification 9 can be obtained.

### (Modification 11 of Example 1 of One Embodiment of Present Technology)

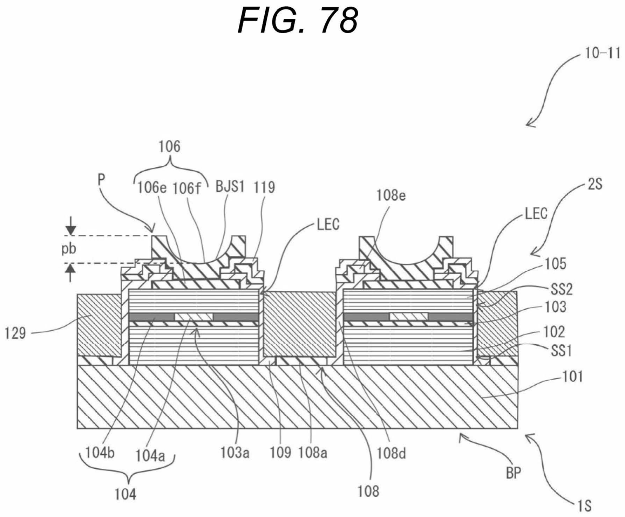

Fig. 78 is a partial cross-sectional view of a light emitting element constituent portion array of a surface emitting device including a surface emitting element 10-11 according to Modification 11 of Example 1 of one embodiment of the present technology.

As illustrated in Fig. 78, the surface emitting element 10-11 has a configuration similar to that of the surface emitting element 10-10 according to Modification 10 except that the anode electrode 106 includes the second electrode 106f (concave electrode).

The surface emitting element 10-11 includes the second electrode 106f, and thus, the position controllability of the bump is excellent although the number of manufacturing processes and the cost are increased as compared with the surface emitting element 10-10 according to Modification 10.

### (Modification 12 of Example 1 of One Embodiment of Present Technology)

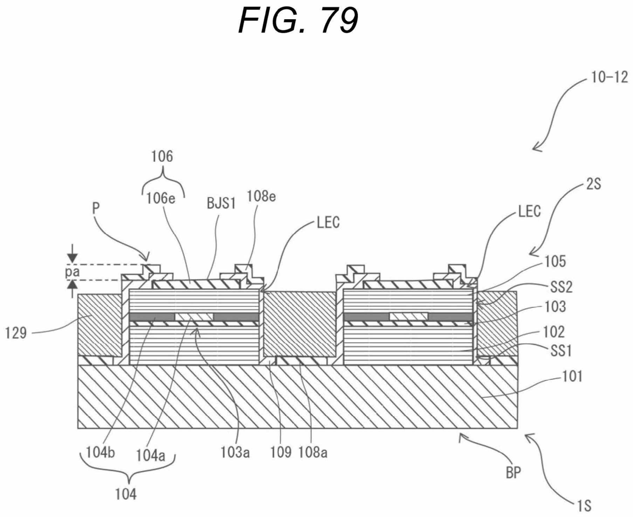

Fig. 79 is a partial cross-sectional view of a light emitting element constituent portion array of a surface emitting device including a surface emitting element 10-12 according to Modification 12 of Example 1 of one embodiment of the present technology.

As illustrated in Fig. 79, the surface emitting element 10-12 has a configuration similar to that of the surface emitting element 10-10 according to Modification 10 except that the second insulating film 119 is not provided.

The surface emitting element 10-12 does not include the second insulating film 119, and thus, the height of the convex portion P and the protection of the wiring 108 are inferior to those of the surface emitting element 10-10 according to Modification 10, but the number of manufacturing processes and the cost can be reduced.

### (Modification 13 of Example 1 of One Embodiment of Present Technology)

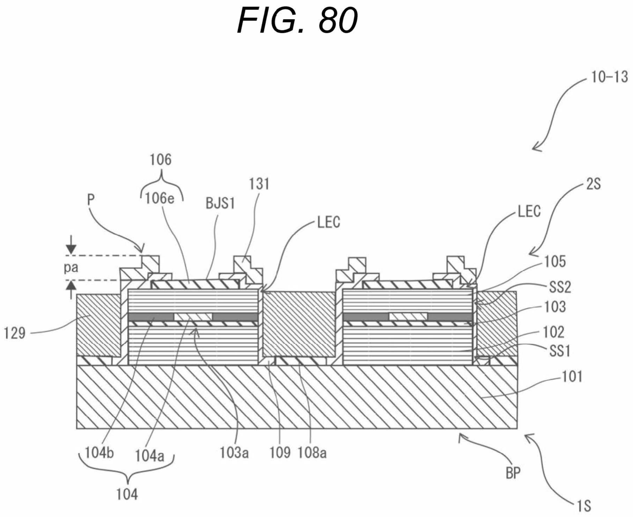

Fig. 80 is a partial cross-sectional view of a light emitting element constituent portion array of a surface emitting device including a surface emitting element 10-13 according to Modification 13 of Example 1 of one embodiment of the present technology.

As illustrated in Fig. 80, the surface emitting element 10-13 has a configuration similar to that of the surface emitting element 10-12 according to Modification 12 except that a thick film 131 including a semiconductor, a conductor, or an insulator is provided instead of the fifth wiring portion 108e.

In the surface emitting element 10-13, the thick film 131 and the first insulating film 109 form the convex portion P in a circular shape having a maximum protruding amount pa from the first bump joint surface BJS1.

According to the surface emitting element 10-13, the convex portion P is constituted with the thick film 131 different from the wiring 108 and the first insulating film 109, so that it is possible to implement the high convex portion P with a small number of layers.

### (Modification 14 of Example 1 of One Embodiment of Present Technology)

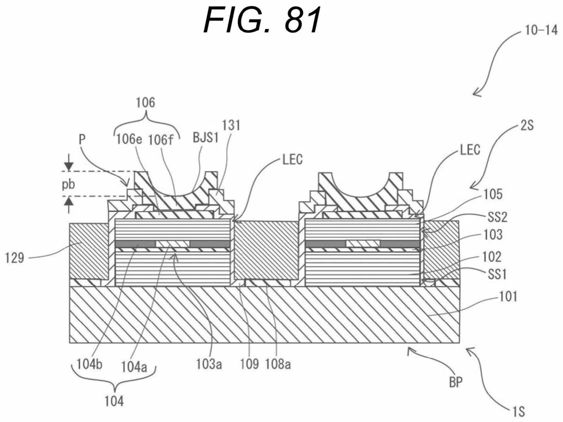

Fig. 81 is a partial cross-sectional view of a light emitting element constituent portion array of a surface emitting device including a surface emitting element 10-14 according to Modification 14 of Example 1 of one embodiment of the present technology.

As illustrated in Fig. 81, the surface emitting element 10-14 has a configuration similar to that of the surface emitting element 10-13 according to Modification 13 except that the anode electrode 106 includes the second electrode 106f (concave electrode).

The surface emitting element 10-14 includes the second electrode 106f, and thus, the position controllability of the bump is excellent although the number of manufacturing processes and the cost are increased as compared with the surface emitting element 10-13 according to Modification 13.

### (Modification 15 of Example 1 of One Embodiment of Present Technology)

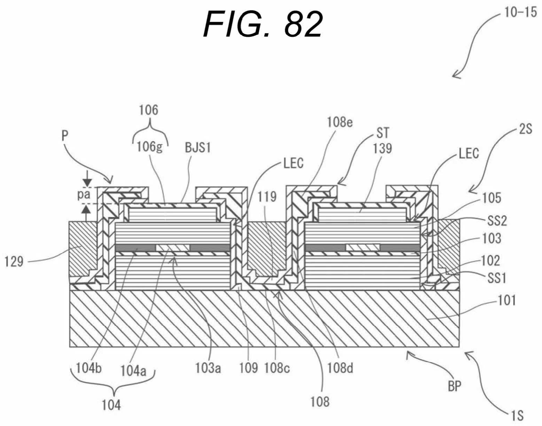

Fig. 82 is a partial cross-sectional view of a light emitting element constituent portion array of a surface emitting device including a surface emitting element 10-15 according to Modification 15 of Example 1 of one embodiment of the present technology.

As illustrated in Fig. 82, the surface emitting element 10-15 has a configuration substantially similar to that of the surface emitting element 10-9 according to Modification 9 except that the second structure 2S includes a dielectric multilayer film reflector 139 on the second semiconductor structure SS2 (specifically, on the second semiconductor multilayer film reflector 105).

In the surface emitting element 10-15, the upper surface and the side surface of the dielectric multilayer film reflector 139 are covered with the first electrode 106g constituting the anode electrode 106. The step portion in a circular shape formed by stacking the first insulating film 109, the wiring 108 (specifically, the fifth wiring portion 108e), and the second insulating film 119 in this order on the peripheral portion of the upper surface of the first electrode 106g includes the convex portion P having the maximum protruding amount pa from the first bump joint surface BJS1.

According to the surface emitting element 10-15, the second structure 2S includes the dielectric multilayer film reflector 139 in addition to the second semiconductor multilayer film reflector 105, so that it is possible to implement a backside emission type VCSEL with higher output and higher efficiency.

### (Modification 16 of Example 1 of One Embodiment of Present Technology)

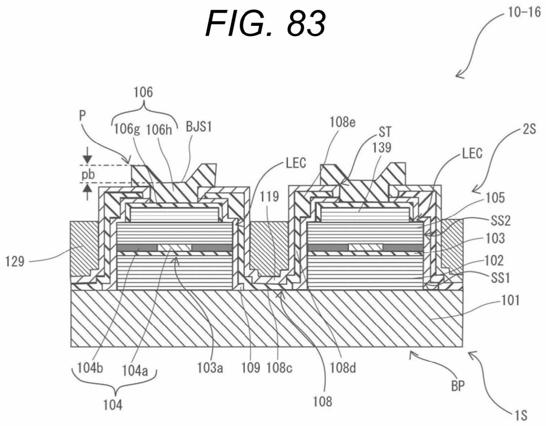

Fig. 83 is a partial cross-sectional view of a light emitting element constituent portion array of a surface emitting device including a surface emitting element 10-16 according to Modification 16 of Example 1 of one embodiment of the present technology.

As illustrated in Fig. 83, the surface emitting element 10-16 has a configuration similar to that of the surface emitting element 10-15 according to Modification 15 except that the anode electrode 106 includes a second electrode 106h (bonding electrode) in addition to the first electrode 106g.

In the surface emitting element 10-16, the first bump joint surface BJS1 of the second electrode 106h includes a stepped concave surface (stepped surface). The stepped concave surface includes a flat surface and an inclined surface in a circular shape continuous with an outer peripheral end of the flat surface and inclined in a direction away from the flat surface as it goes upward.

The surface emitting element 10-16 includes the second electrode 106h, and thus, the position controllability of the bump is excellent although the number of manufacturing processes and the cost are increased as compared with the surface emitting element 10-15 according to Modification 15.

For example, the light emitting element constituent portion may have a mesa-less structure, and the dummy element constituent portion may have a mesa structure.

In each of the above examples and modifications, the surface emitting element may have a contact layer (highly doped semiconductor layer) in ohmic contact with the electrode on the uppermost layer of the light emitting element constituent portion LEC.

In each of the above examples and modifications, the surface emitting element may have a contact layer (highly doped semiconductor layer) in ohmic contact with the wiring 108 between the substrate 101 and the first semiconductor multilayer film reflector 102.

The oxidation confinement layer 104 may be provided, for example, in the first semiconductor multilayer film reflector 102 and/or the second semiconductor multilayer film reflector 105.

In each of the above-described examples and modifications, in the light emitting element constituent portion array LECA of the surface emitting element, the light emitting element constituent portions LEC may be arranged in one dimension or in two dimensions other than in a matrix (such as, for example, houndstooth arrangement and random arrangement).

For example, the current confinement in the surface emitting element is not limited to the current confinement by the oxidation confinement layer 104 or the ion implantation region IIA. For example, the current confinement may be performed by a QWI that provides a bandgap energy difference between the inside and outside of an aperture by Ga vacancy diffusion to confine carriers, a tunnel junction, a buried tunnel junction, or the like. A plurality of current confinement structures may be used in combination. For example, the non-oxidized region 104a of the oxidation confinement layer 104 may be surrounded by the ion implantation region IIA.

For example, the substrate 101 may be a Si substrate, a Ge substrate, a GaN substrate, an InP substrate, or the like. In any case, the semiconductor layer to be stacked on the substrate 101 is preferably appropriately selected so as to be lattice-matched with the material of the substrate 101. For the surface emitting element, a material having any emission wavelength included in the wavelength band of 200 to 2000 nm can be used.

The light emitting unit is not limited to the semiconductor multilayer film reflector, and may include a reflector including one or a combination of two or more selected from a semiconductor, a dielectric, and a metal.

In the surface emitting element of each of the above examples and modifications, the conductivity types (p-type and n-type) of the first and second semiconductor structures may be reversed. In this case, a positional relationship between the anode electrode and the cathode electrode needs to be reversed.

A portion of the configurations of the surface emitting element and the light source device including the surface emitting element of each of the above examples and modifications may be combined within a range not contradictory to each other.

In each of the above examples and modifications, the material, conductivity type, thickness, width, shape, size, and the like, of each layer constituting the surface emitting element and the light source device including the surface emitting element can be appropriately changed within a range functioning as the surface emitting element.

### <17. Application Example to Electronic Equipment>

The technology according to the present disclosure (the present technology) can be applied to various products (electronic equipment). For example, the technology according to the present disclosure may be implemented as any type of moving body such as an automobile, an electric vehicle, a hybrid electric vehicle, a motorcycle, a bicycle, a personal mobility, an airplane, a drone, a ship, or a robot, or as an apparatus mounted on low power consumption equipment (for example, a smartphone, a smartwatch, a tablet, a mouse, or the like).

The surface emitting element according to the present technology can also be applied as, for example, a light source of equipment (for example, a printer, a copier, a projector, a head-mounted display, a head-up display, or the like) that forms or displays an image by light.

### <18. Example in which Surface Emitting Element is Applied to Distance Measurement Device>

Hereinafter, an application example of the surface emitting element 10 according to the first embodiment will be described.

Fig. 60 illustrates an example of a schematic configuration of a distance measurement device 1000 (ranging device) including the surface emitting element 10 as an example of electronic equipment according to the present technology. The distance measurement device 1000 measures a distance to a subject S by a time of flight (TOF) method. The distance measurement device 1000 includes the surface emitting element 10. The distance measurement device 1000 includes, for example, the surface emitting element 10, a light receiving device 125, lenses 128, 138, a signal processing section 145, a control section 155, a display section 165, and a storage section 175.

The light receiving device 125 receives the light emitted from the surface emitting element 10 and reflected by the subject S (object). In other words, the light receiving device 125 detects the light reflected by the subject S. The lens 128 is a lens for collimating the light emitted from the surface emitting element 10, and is, for example, a collimating lens. The lens 138 is a lens for collecting light reflected by the subject S and guiding the light to the light receiving device 125, and is, for example, a condenser lens.

The signal processing section 145 is a circuit for generating a signal corresponding to a difference between a signal input from the light receiving device 125 and a reference signal input from the control section 155. The control section 155 includes, for example, a time to digital converter (TDC). The reference signal may be a signal input from the control section 155, or may be an output signal of a detection section that directly detects the output of the surface emitting element 10. The control section 155 is, for example, a processor that controls the surface emitting element 10, the light receiving device 125, the signal processing section 145, the display section 165, and the storage section 175. The control section 155 is a circuit that measures the distance to the subject S on the basis of the signal generated by the signal processing section 145. The control section 155 generates a video signal for displaying information on the distance to the subject S, and outputs the video signal to the display section 165. The display section 165 displays information on the distance to the subject S on the basis of the video signal input from the control section 155. The control section 155 stores information on the distance to the subject S in the storage section 175.

In the present application example, instead of the surface emitting element 10, any one of the above-described surface emitting elements 10-1, 10-2, 10-3, 10-4, 10-5, 10-6, 10-7, 20, 30, 40, 50, 60, 70, 80, 90, 100, 110, 110-1, 110-2, 110-3, 110-4, 120, 130, 140, 150 can be applied to the distance measurement device 1000.

### <19. Example in which Distance Measurement Device is Mounted on Moving Body>

Fig. 61 is a block diagram illustrating an example of a schematic configuration of a vehicle control system as an example of a mobile body control system to which the technology in the present disclosure can be applied.

The vehicle control system 12000 includes a plurality of electronic control units connected to each other via a communication network 12001. In the example illustrated in Fig. 61, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and an in-vehicle network interface (I/F) 12053 are illustrated as functional configurations of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine or a driving motor, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various lamps such as a headlamp, a back-up lamp, a brake lamp, a turn indicator, or a fog lamp. In this case, a radio wave transmitted from a mobile device that substitutes for a key or signals of various switches may be input to the body system control unit 12020. The body system control unit 12020 receives these input radio waves or signals, and controls a door lock device, the power window device, the lamps, or the like, of the vehicle.

The outside-vehicle information detecting unit 12030 detects information about the outside of the vehicle including the vehicle control system 12000. For example, a distance measurement device 12031 is connected to the outside-vehicle information detecting unit 12030. The distance measurement device 12031 includes the distance measurement device 1000 described above. The outside-vehicle information detecting unit 12030 causes the distance measurement device 12031 to measure a distance to an object (subject S) outside the vehicle, and acquires distance data acquired by the measurement. The outside-vehicle information detecting unit 12030 may perform processing of detecting a person, a car, an obstacle, a sign, or the like, on the basis of the acquired distance data.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether or not the driver is dozing.

The microcomputer 12051 can calculate a control target value for the driving force generating device, the steering mechanism, or the braking device on the basis of the information about the inside or outside of the vehicle, the information being obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS), the functions including vehicle collision avoidance or shock mitigation, following driving based on the following distance, vehicle speed maintaining driving, vehicle collision warning, vehicle lane departure warning, and the like.

Furthermore, the microcomputer 12051 can perform cooperative control intended for automated driving, which makes the vehicle travel automatedly without depending on the operation of the driver, or the like, by controlling the driving force generating device, the steering mechanism, the braking device, or the like on the basis of the information about the surroundings of the vehicle, the information being obtained by the outside-vehicle information detecting unit 12030 or the in-vehicle information detecting unit 12040.

In addition, the microcomputer 12051 can output a control command to the body system control unit 12020 on the basis of the information about the outside of the vehicle obtained by the outside-vehicle information detecting unit 12030. For example, the microcomputer 12051 can perform cooperative control intended to prevent glare by controlling the headlamp to switch from high beam to low beam, for example, in accordance with the position of a preceding vehicle or an oncoming vehicle detected by the outside-vehicle information detecting unit 12030.

The sound/image output section 12052 transmits an output signal of at least one of a sound or an image to an output device capable of visually or auditorily notifying an occupant of the vehicle or the outside of the vehicle of information. In the example of Fig. 61, an audio speaker 12061, a display section 12062, and an instrument panel 12063 are illustrated as the output device. The display section 12062 may, for example, include at least one of an on-board display or a head-up display.

Fig. 62 is a view illustrating an example of installation positions of the distance measurement device 12031.

In Fig. 62, a vehicle 12100 includes distance measurement devices 12101, 12102, 12103, 12104, 12105 as the distance measurement device 12031.

For example, the distance measurement devices 12101, 12102, 12103, 12104, 12105 are provided at positions such as a front nose, sideview mirrors, a rear bumper, a back door, an upper portion of a windshield in a vehicle interior, and the like, of the vehicle 12100. The distance measurement device 12101 provided at the front nose and the distance measurement device 12105 provided at the upper portion of the windshield in the vehicle interior mainly acquire data of the front side of the vehicle 12100. The distance measurement devices 12102 and 12103 provided at the sideview mirrors mainly acquire data of the sides of the vehicle 12100. The distance measurement device 12104 provided at the rear bumper or the back door mainly acquires data of the rear side of the vehicle 12100. The data of the front side acquired by the distance measurement devices 12101 and 12105 is mainly used to detect a preceding vehicle, a pedestrian, an obstacle, a traffic light, a traffic sign, or the like.

Note that Fig. 62 illustrates an example of detection ranges of the distance measurement devices 12101 to 12104. A detection range 12111 indicates a detection range of the distance measurement device 12101 provided at the front nose, detection ranges 12112 and 12113 indicate detection ranges of the distance measurement devices 12102 and 12103 provided at the sideview mirrors, respectively, and a detection range 12114 indicates a detection range of the distance measurement device 12104 provided at the rear bumper or the back door.

For example, the microcomputer 12051 may obtain a distance to each three-dimensional object within the detection ranges 12111 to 12114 and a temporal change in the distance (relative speed with respect to the vehicle 12100) on the basis of the distance data obtained from the distance measurement devices 12101 to 12104, whereby particularly the nearest three-dimensional object present on a traveling path of the vehicle 12100, which travels in substantially the same direction as the vehicle 12100 at a predetermined speed (for example, equal to or more than 0 km/h), may be extracted as a preceding vehicle. Moreover, the microcomputer 12051 can set a following distance to be maintained relative to a preceding vehicle in advance, and perform automatic brake control (including following stop control), automatic acceleration control (including following start control), or the like. It is therefore possible to perform cooperative control intended for automated driving in which the vehicle travels autonomously without depending on the driver's operation, or the like.

For example, on the basis of the distance data obtained from the distance measurement devices 12101 to 12104, the microcomputer 12051 can extract three-dimensional object data regarding three-dimensional objects while classifying into two-wheeled vehicles, standard-sized vehicles, large-sized vehicles, pedestrians, and other three-dimensional objects such as utility poles, and use the three-dimensional object data for automatic avoidance of obstacles. For example, the microcomputer 12051 identifies obstacles around the vehicle 12100 as obstacles that the driver of the vehicle 12100 can recognize visually and obstacles that are difficult for the driver of the vehicle to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

An example of the moving body control system to which the technology according to the present disclosure can be applied has been described above. The technology according to the present disclosure may be applied to the distance measurement device 12031 in the configuration described above.

Furthermore, the present technology may also adopt the following configurations.
(1) A surface emitting element including:
   a first structure including a first semiconductor structure;
   a second structure stacked with the first structure and including a second semiconductor structure; and
   a light emitting layer arranged between the first structure and the second structure and including a light emitting region,
   in which the second structure further includes an electrode including an external joint surface on a side opposite to a side of the light emitting layer of the second semiconductor structure, and
   a convex portion protruding to the side opposite to the side of the light emitting layer more than at least a portion of the external joint surface is provided in the second structure.
(2) The surface emitting element according to (1), in which the convex portion protrudes to the side opposite to the side of the light emitting layer more than the external joint surface.
(3) The surface emitting element according to (1), in which the convex portion protrudes to the side opposite to the side of the light emitting layer more than a portion of the external joint surface.
(4) The surface emitting element according to (1) to (3), in which the convex portion is a portion of the electrode and protrudes to the side opposite to the side of the light emitting layer more than the other portion of the electrode.
(5) The surface emitting element according to any one of (1) to (4), in which the external joint surface has a concave surface shape.
(6) The surface emitting element according to any one of (1) to (5),
   in which a stacked structure in which an insulating film and a wiring are stacked is provided across the first and second semiconductor structures, and
   the stacked structure forms a step portion on a peripheral portion of the second structure.
(7) The surface emitting element according to (6), in which the step portion includes the convex portion.
(8) The surface emitting element according to (6), in which the convex portion is provided on the step portion.
(9) The surface emitting element according to any one of (6) to (8),
   in which the stacked structure includes a plurality of the insulating films and at least one of the wirings, and
   the insulating films and the wirings are alternately stacked.
(10) The surface emitting element according to claim 1, in which the convex portion has a stacked structure in which a plurality of layers is stacked.
(11) The surface emitting element according to any one of (1) to (10), in which the convex portion does not overlap the light emitting region in plan view.
(12) The surface emitting element according to any one of (1) to (11), in which the external joint surface overlaps at least the light emitting region in plan view.
(13) The surface emitting element according to any one of (1) to (12), in which the external joint surface is a flat surface, a curved surface, or a stepped surface to be bonded to a substrate via a bump.
(14) The surface emitting element according to any one of (1) to (13), in which a protruding amount of the convex portion is 1/3 or more of a thickness of a portion corresponding to the light emitting region of the electrode.
(15) The surface emitting element according to any one of (1) to (14), in which the convex portion includes a plurality of portions facing each other in an in-plane direction.
(16) The surface emitting element according to any one of (1) to (15), in which the convex portion includes a portion of the electrode.
(17) The surface emitting element according to any one of (1) to (16), in which the convex portion includes at least a portion of an insulating film.
(18) The surface emitting element according to any one of (1) to (17), in which the convex portion is provided so as to correspond to at least a portion of an outer periphery of the light emitting region in plan view.
(19) The surface emitting element according to any one of (1) to (18), in which the convex portion surrounds the light emitting region in plan view.
(20) The surface emitting element according to any one of (1) to (19), in which the convex portion includes a plurality of portions arranged so as to surround the light emitting region in plan view.
(21) The surface emitting element according to any one of (1) to (20), in which the convex portion is a stepped convex portion.
(22) The surface emitting element according to any one of (1) to (21), in which the convex portion includes:
   a base portion; and
   at least one protrusion protruding from the base portion to the side opposite to the side of the light emitting layer.
(23) The surface emitting element according to (22), in which the at least one protrusion is a plurality of protrusions having different protruding amounts.
(24) The surface emitting element according to (23), in which the plurality of protrusions farther from the light emitting region in plan view has a larger protruding amount.
(25) The surface emitting element according to any one of (1) to (24), in which in the second semiconductor structure, the electrode is provided in a first region including a region corresponding to the light emitting region on the side opposite to the side of the light emitting layer, a second region around the first region includes a protruding portion protruding to the side opposite to the side of the light emitting layer more than the first region, and
   the convex portion includes a portion of the protruding portion.
(26) The surface emitting element according to (25), in which the second semiconductor structure includes a semiconductor multilayer film reflector including the first region and the second region.
(27) The surface emitting element according to (25), in which the second semiconductor structure includes a contact layer including the first region and the second region.
(28) The surface emitting element according to any one of (1) to (27), in which the second structure further includes a dielectric layer arranged between the second semiconductor structure and a portion including the external joint surface of the electrode.
(29) The surface emitting element according to any one of (1) to (28), in which a current confinement region that sets the light emitting region is provided between a surface of the first structure on the side opposite to the side of the light emitting layer and the light emitting layer and/or between a surface of the second structure on the side opposite to the side of the light emitting layer and the light emitting layer.
(30) The surface emitting element according to any one of (1) to (29), in which the convex portion is provided so as to correspond to a portion of an outer periphery of the light emitting region in plan view.
(31) The surface emitting element according to any one of (1) to (30), in which at least the second semiconductor structure out of the first semiconductor structure and the second semiconductor structure includes a semiconductor multilayer film reflector.
(32) The surface emitting element according to any one of (1) to (31), in which a mesa is constituted with at least a portion of the first semiconductor structure, the light emitting layer, and the second semiconductor structure.
(33) A light source device including:
   the surface emitting element according to any one of (1) to (32); and a substrate to be bonded to an electrode of the surface emitting element via a bump.
(34) The surface emitting element according to any one of (1) to (33), in which light is emitted to the side opposite to the side of the light emitting layer of the first structure.
(35) The surface emitting element according to any one of (1) to (34), in which the convex portion is provided so as to correspond to 50% or more of an outer periphery of the light emitting region in plan view.
(36) The surface emitting element according to any one of claims (1) to (35), in which the electrode includes:
   a first electrode; and
   a second electrode including the external joint surface.
(37) The surface emitting element according to (36), in which the second electrode is provided so as to straddle over the first electrode and a surface of the second semiconductor structure on the side opposite to the side of the light emitting layer.
(38) The surface emitting element according to (36) or (37), in which the convex portion includes at least a portion of the first electrode.
(39) The surface emitting element according to any one of (36) to (38), in which the convex portion includes a portion of the second electrode.
(40) A light source device including the surface emitting element according to any one of (1) to (39).
(41) Electronic equipment including the surface emitting element according to any one of (1) to (39).
(42) Electronic equipment including the light source device according to (40).

### REFERENCE SIGNS LIST

10, 10-1, 10-2, 10-3, 10-4, 10-5, 10-6, 10-7, 20, 30, 40, 50, 60, 70, 80, 90, 100, 110, 110-1, 110-2, 110-3, 110-4, 120, 130, 140, 150 Surface emitting element
102 First semiconductor multilayer film reflector (first semiconductor structure)
103 Light emitting layer
103a Light emitting region
104b Oxidation confinement region (current confinement region)
105 Second semiconductor multilayer film reflector (second semiconductor structure, semiconductor multilayer film reflector)
106 Anode electrode (electrode)
106a, 106e, 106g First electrode
106b, 106f, 106h Second electrode
108 Wiring
109 First insulating film (insulating film)
111 Contact layer
112 Dielectric layer
113 Cladding layer (first semiconductor structure)
114 Cladding layer (second semiconductor structure)
119 Second insulating film (insulating film)
139 Dielectric multilayer film reflector (dielectric layer)
200 Another substrate
1S First structure
2S Second structure
SS1 First semiconductor structure
SS2 Second semiconductor structure
BSJ1 First bump joint surface (external joint surface)
P Convex portion
pa, pb Protruding amount
P0 Base portion
P1, P2 Protrusion
IIA Ion implantation region (current confinement region)
R1 First region
R2 Second region

## Claims

1. A surface emitting element comprising:
a first structure including a first semiconductor structure;
a second structure stacked with the first structure and including a second semiconductor structure; and
a light emitting layer arranged between the first structure and the second structure and including a light emitting region,
wherein the second structure further includes an electrode including an external joint surface on a side opposite to a side of the light emitting layer of the second semiconductor structure, and
a convex portion protruding to the side opposite to the side of the light emitting layer more than at least a portion of the external joint surface is provided in the second structure.

2. The surface emitting element according to claim 1, wherein the convex portion protrudes to the side opposite to the side of the light emitting layer more than the external joint surface.

3. The surface emitting element according to claim 1, wherein the convex portion protrudes to the side opposite to the side of the light emitting layer more than a portion of the external joint surface.

4. The surface emitting element according to claim 1, wherein the convex portion is a portion of the electrode and protrudes to the side opposite to the side of the light emitting layer more than the other portion of the electrode.

5. The surface emitting element according to claim 1, wherein the external joint surface has a concave surface shape.

6. The surface emitting element according to claim 1,
wherein a stacked structure in which an insulating film and a wiring are stacked is provided across the first semiconductor structure and the second semiconductor structure, and
the stacked structure forms a step portion on a peripheral portion of the second structure.

7. The surface emitting element according to claim 6, wherein the step portion includes the convex portion.

8. The surface emitting element according to claim 6, wherein the convex portion is provided on the step portion.

9. The surface emitting element according to claim 6,
wherein the stacked structure includes a plurality of the insulating films and at least one of the wirings, and
the insulating films and the wirings are alternately stacked.

10. The surface emitting element according to claim 1, wherein the convex portion has a stacked structure in which a plurality of layers is stacked.

11. The surface emitting element according to claim 1, wherein the convex portion does not overlap the light emitting region in plan view.

12. The surface emitting element according to claim 10, wherein the external joint surface overlaps at least the light emitting region in plan view.

13. The surface emitting element according to claim 1, wherein the external joint surface is a flat surface, a curved surface, or a stepped surface to be bonded to a substrate via a bump.

14. The surface emitting element according to claim 12, wherein a protruding amount of the convex portion is 1/3 or more of a thickness of a portion corresponding to the light emitting region of the electrode.

15. The surface emitting element according to claim 1, wherein the convex portion includes a plurality of portions facing each other in an in-plane direction.

16. The surface emitting element according to claim 1, wherein the convex portion includes a portion of the electrode.

17. The surface emitting element according to claim 1, wherein the convex portion includes at least a portion of an insulating film.

18. The surface emitting element according to claim 1, wherein the convex portion is provided so as to correspond to at least a portion of an outer periphery of the light emitting region in plan view.

19. The surface emitting element according to claim 1, wherein the convex portion surrounds the light emitting region in plan view.

20. The surface emitting element according to claim 1, wherein the convex portion includes a plurality of portions arranged so as to surround the light emitting region in plan view.

21. The surface emitting element according to claim 1, wherein the convex portion is a stepped convex portion.

22. The surface emitting element according to claim 1, wherein the convex portion includes:
a base portion; and
at least one protrusion protruding from the base portion to the side opposite to the side of the light emitting layer.

23. The surface emitting element according to claim 22, wherein the at least one protrusion is a plurality of protrusions having different protruding amounts.

24. The surface emitting element according to claim 23, wherein the plurality of protrusions farther from the light emitting region in plan view has a larger protruding amount.

25. The surface emitting element according to claim 1,
wherein in the second semiconductor structure, the electrode is provided in a first region including a region corresponding to the light emitting region on the side opposite to the side of the light emitting layer, a second region around the first region includes a protruding portion protruding to the side opposite to the side of the light emitting layer more than the first region, and
the convex portion includes a portion of the protruding portion.

26. The surface emitting element according to claim 25, wherein the second semiconductor structure includes a semiconductor multilayer film reflector including the first region and the second region.

27. The surface emitting element according to claim 25, wherein the second semiconductor structure includes a contact layer including the first region and the second region.

28. The surface emitting element according to claim 1, wherein the second structure further includes a dielectric layer arranged between the second semiconductor structure and the electrode.

29. The surface emitting element according to claim 1, wherein a current confinement region that sets the light emitting region is provided between a surface of the first structure on the side opposite to the side of the light emitting layer and the light emitting layer and/or between a surface of the second structure on the side opposite to the side of the light emitting layer and the light emitting layer.
